# EUROPEAN PATENT APPLICATION

(11) **EP 4 468 080 A1**
(43) Date of publication of application: **27.11.2024**
(21) Application number: 24173164.5
(22) Date of filing: 29.04.2024
(51) Int. Cl.: G03F 7/004, G03F 7/038

(54) **CHEMICALLY AMPLIFIED NEGATIVE RESIST COMPOSITION AND RESIST PATTERN FORMING PROCESS**

(30) Priority: 11.05.2023 JP 2023078335
(71) Applicant: SHIN-ETSU CHEMICAL CO., LTD., Tokyo 1000005 (JP)
(72) Inventor: MASUNAGA, Keiichi, NIIGATA-KEN (JP); WATANABE, Satoshi, NIIGATA-KEN (JP); FUKUSHIMA, Masahiro, NIIGATA-KEN (JP); KOTAKE, Masaaki, NIIGATA-KEN (JP); MATSUZAWA, Yuta, NIIGATA-KEN (JP)
(74) Representative: Ter Meer Steinmeister & Partner

(57) **Abstract**

A chemically amplified negative resist composition comprising (A) a quencher in the form of an onium salt containing an anion having a nitrogen-containing aliphatic heterocycle and a fluorocarboxylic acid structure and (B) a base polymer is provided. The resist composition forms a pattern of rectangular profile with improved LER, resolution, fidelity, and dose margin.

## Description

### TECHNICAL FIELD

This invention relates to a chemically amplified negative resist composition and a resist pattern forming process using the same.

### BACKGROUND ART

To meet the demand for higher integration density and operating speed of LSIs, the effort to reduce the pattern rule is in rapid progress. Acid-catalyzed chemically amplified resist compositions are most often used in forming resist patterns with a feature size of 0.2 µm or less. High-energy radiation such as UV, deep-UV or EB is used as the light source for exposure of these resist compositions. In particular, the EB lithography, which is utilized as the ultra-fine microfabrication technique, is also indispensable in processing photomask blanks to form photomasks for use in semiconductor device fabrication.

Polymers comprising a major proportion of aromatic structure having an acidic side chain, for example, polyhydroxystyrene are useful in resist materials for the KrF excimer laser lithography. These polymers are not used in resist materials for the ArF excimer laser lithography because they exhibit strong absorption at a wavelength of around 200 nm. These polymers, however, are expected to form useful resist materials for the EB and EUV lithography for forming patterns of smaller size than the processing limit of ArF excimer laser because they offer high etching resistance.

Resist compositions for photolithography include positive ones in which exposed areas are dissolved away and negative ones in which exposed areas are left as a pattern. A viable composition is selected among them depending on the desired resist pattern. In general, the chemically amplified negative resist composition comprises a polymer which is normally soluble in an aqueous alkaline developer, an acid generator which is decomposed to generate an acid upon exposure to light, and a crosslinker which causes the polymer to crosslink in the presence of the acid serving as a catalyst, thus rendering the polymer insoluble in the developer (sometimes, the crosslinker is incorporated in the polymer). Most often a quencher is added for controlling the diffusion of the acid generated upon light exposure.

Typical of the alkali-soluble units to constitute polymers which dissolve in aqueous alkaline developer are units derived from phenols. A number of negative resist compositions of such type were developed, especially as adapted for exposure to KrF excimer laser light. These compositions have not been used in the ArF excimer laser lithography because the phenolic units are not transmissive to exposure light having a wavelength of 150 to 220 nm. Recently, these compositions are recognized attractive again as the negative resist composition for the short wavelength (e.g., EB or EUV) lithography capable of forming smaller size patterns. Exemplary compositions are described in Patent Documents 1 to 3.

Attempts were made in the photolithography to ameliorate resist sensitivity and pattern profile in a controlled way by properly selecting and combining components used in resist compositions and adjusting processing conditions. One outstanding problem is the diffusion of acid because acid diffusion has a significant impact on the resolution of a chemically amplified resist composition.

The quencher is, in fact, essential for controlling acid diffusion and improving resist performance, especially resolution. Studies have been made on the quencher while amines and weak acid onium salts have been generally used. The weak acid onium salts are exemplified in several patent documents. For example, Patent Document 4 describes that the addition of triphenylsulfonium acetate ensures to form a satisfactory resist pattern without T-top profile, a difference in line width between isolated and grouped patterns, and standing waves. Patent Document 5 describes the addition of ammonium salts of sulfonic acids or carboxylic acids for achieving improvements in sensitivity, resolution and exposure margin. Also, Patent Document 6 describes that a resist composition for KrF or EB lithography comprising a PAG capable of generating a fluorinated carboxylic acid is improved in resolution and process latitudes such as exposure margin and depth of focus. Patent Document 7 describes that a resist composition for F₂ lithography using F₂ laser comprising a PAG capable of generating a fluorinated carboxylic acid is improved in LER and overcomes the footing problem. These compositions are used in the KrF, EB and F₂ lithography processes.

Patent Document 8 describes a positive photosensitive composition for ArF lithography comprising a carboxylic acid onium salt. This system is based on the mechanism that a salt exchange occurs between a weak acid onium salt and a strong acid (sulfonic acid) generated by a PAG upon exposure, to form a weak acid and a strong acid onium salt. That is, the strong acid (sulfonic acid) having high acidity is replaced by a weak acid (carboxylic acid), thereby suppressing acid-catalyzed decomposition reaction of acid labile group and reducing or controlling the distance of acid diffusion. The onium salt apparently functions as a quencher.

Patent Documents 9 to 11 describe carboxylic acid onium salts having an indole, indoline or piperidine carboxylic acid structure which is a nitrogen-containing heterocyclic compound. Patent Document 12 describes a carboxylic acid onium salt having an aminobenzoic acid structure. Patent Document 13 describes a carboxylic acid onium salt having an amide bond. Although these compounds act as the quencher, some problems remain. Since the aromatic amine and amide bond are not highly basic, the acid diffusion controlling ability is not sufficient. Since the piperidine carboxylic acid is highly water soluble, its industrial manufacture is difficult. As to their role, they are mainly handled as a quencher relative to a fluorinated alkane sulfonic acid of addition type. Particularly in the processing of mask blanks, few studies have been made on their use as a quencher in a negative resist composition comprising a polyhydroxystyrene as a base polymer for use in the EB imaging process.

When resist compositions comprising the carboxylic acid onium salts or fluorocarboxylic acid onium salts are used in patterning, however, LER and resolution are insufficient for the current lithography which must comply with advanced miniaturization. It is desired to have a quencher which has a reduced LER and is improved in resolution, rectangularity, pattern fidelity and dose margin.

### Citation List

| | |
|---|---|
| Patent Document 1: | JP-A 2006-201532 |
| Patent Document 2: | JP-A 2006-215180 |
| Patent Document 3: | JP-A 2008-249762 |
| Patent Document 4: | JP 3955384 (USP 6479210) |
| Patent Document 5: | JP-A H11-327143 |
| Patent Document 6: | JP 4231622 (USP 6485883) |
| Patent Document 7: | JP 4116340 (USP 7214467) |
| Patent Document 8: | JP 4226803 (USP 6492091) |
| Patent Document 9: | JP 6217561 |
| Patent Document 10: | JP 6874738 |
| Patent Document 11: | JP 6512049 |
| Patent Document 12: | JP 6323302 |
| Patent Document 13: | WO 2019/087626 |

### DISCLOSURE OF INVENTION

An object of the invention is to provide a chemically amplified negative resist composition which is processed by lithography to form a resist pattern of rectangular profile with improved LER, resolution, fidelity, and dose margin, and a pattern forming process using the resist composition.

The inventors have found that a resist composition comprising as the quencher an onium salt containing an anion having a nitrogen-containing aliphatic heterocycle and a fluorocarboxylic acid structure can be processed by lithography to form a resist pattern of rectangular profile with improved LER, resolution, fidelity, and dose margin.

Accordingly, the invention provides a chemically amplified negative resist composition and resist pattern forming process, as defined below.
1. A chemically amplified negative resist composition comprising
   (A) a quencher containing an onium salt having the formula (A): 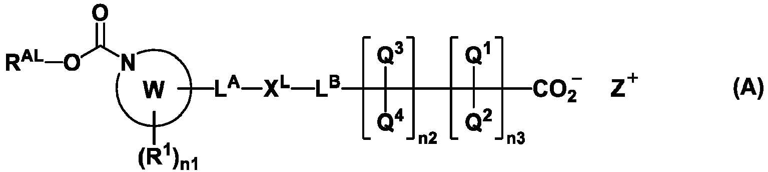 wherein n1 is an integer of 0 to 6, n2 is an integer of 0 to 3, n3 is an integer of 1 to 4,
      W is a C₂-C₂₀ nitrogen-containing aliphatic heterocycle which may contain a heteroatom,
      L^{A} and L^{B} are each independently a single bond, ether bond, ester bond, amide bond, sulfonate ester bond, carbonate bond or carbamate bond,
      X^{L} is a single bond or a C₁-C₄₀ hydrocarbylene group which may contain a heteroatom,
      R¹ is a C₁-C₂₀ hydrocarbyl group which may contain a heteroatom, and when n1 is 2 or more, a plurality of R¹ may bond together to form a ring with the carbon atoms on W to which they are attached,
      Q¹ to Q⁴ are each independently hydrogen, fluorine, a C₁-C₆ hydrocarbyl group or C₁-C₆ fluorinated hydrocarbyl group, at least one of Q¹ to Q⁴ being fluorine or a C₁-C₆ fluorinated hydrocarbyl group, Q³ and Q⁴ may bond together to form a ring with the carbon atom to which they are attached,
      R^{AL} is an acid labile group, and
      Z⁺ is an onium cation, and
   (B) a base polymer containing a polymer comprising repeat units having the formula (B1): 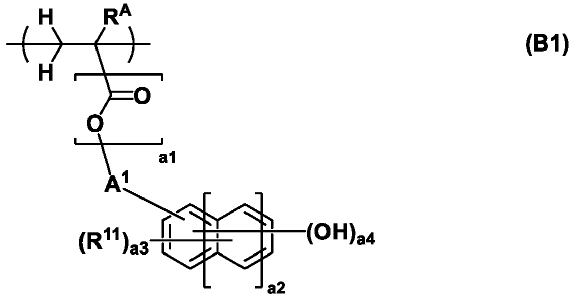 wherein a1 is 0 or 1, a2 is an integer of 0 to 2, a3 is an integer meeting 0 ≤ a3 ≤ 5+2(a2)-a4, a4 is an integer of 1 to 3,
      R^{A} is hydrogen, fluorine, methyl or trifluoromethyl,
      R¹¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group, and
      A¹ is a single bond or a C₁-C₁₀ saturated hydrocarbylene group in which -CH₂- may be replaced by -O-.
2. The negative resist composition of claim 1 wherein R^{AL} is a group having the formula (AL-1) or (AL-2): 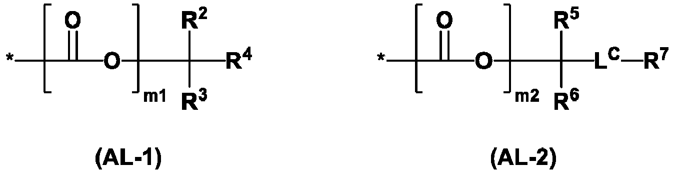 wherein L^{C} is -O- or -S-,
   R², R³ and R⁴ are each independently a C₁-C₁₀ hydrocarbyl group, any two of R², R³ and R⁴ may bond together to form a ring with the carbon atom to which they are attached,
   R⁵ and R⁶ are each independently hydrogen or a C₁-C₁₀ hydrocarbyl group, R⁷ is a C₁-C₂₀ hydrocarbyl group in which -CH₂- may be replaced by -O- or -S-, R⁶ and R⁷ may bond together to form a C₃-C₂₀ heterocyclic group with the carbon atom and L^{C} to which they are attached, -CH₂- in the heterocyclic group may be replaced by -O- or -S-,
   m1 and m2 are each independently 0 or 1, and
   * designates a point of attachment to the adjacent -O-.
3. The negative resist composition of claim 1 or 2 wherein Z⁺ is a sulfonium cation having the formula (cation-1), iodonium cation having the formula (cation-2), or ammonium cation having the formula (cation-3): 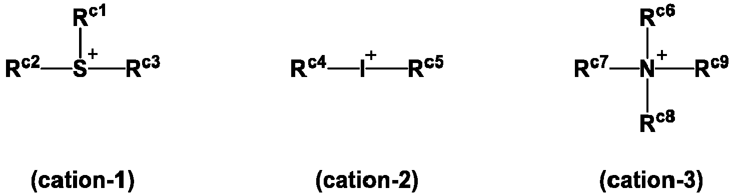 wherein R^{c1} to R^{c9} are each independently halogen or a C₁-C₃₀ hydrocarbyl group which may contain a heteroatom, R^{c1} and R^{c2} may bond together to form a ring with the sulfur atom to which they are attached.
4. The negative resist composition of any one of claims 1 to 3 wherein the onium salt has the formula (A1): 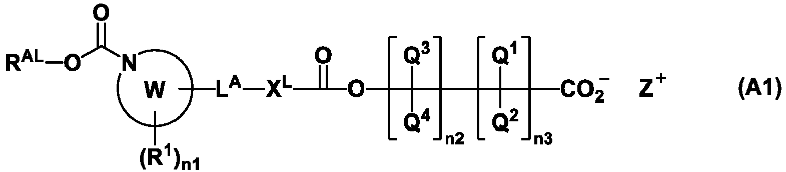 wherein n1 to n3, W, L^{A}, X^{L}, R¹, Q¹ to Q⁴, R^{AL} and Z⁺ are as defined above.
5. The negative resist composition of claim 4 wherein the onium salt has the formula (A2): 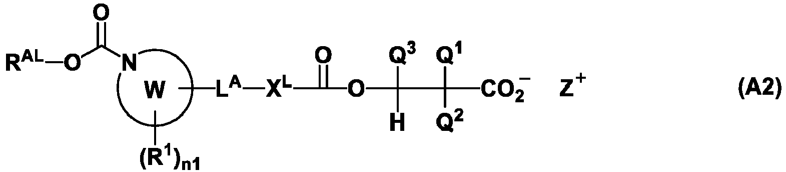 wherein n1, W, L^{A}, X^{L}, R¹, Q¹ to Q³, R^{AL} and Z⁺ are as defined above.
6. The negative resist composition of any one of claims 1 to 5 wherein the polymer further comprises repeat units having the formula (B2): 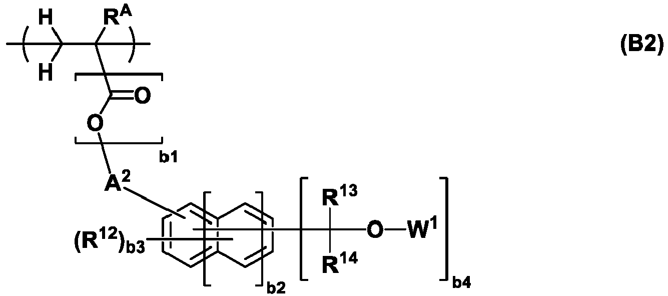 wherein b1 is 0 or 1, b2 is an integer of 0 to 2, b3 is an integer meeting 0 ≤ b3 ≤ 5+2(b2)-b4, b4 is an integer of 1 to 3,
   R^{A} is hydrogen, fluorine, methyl or trifluoromethyl,
   R¹² is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group,
   R¹³ and R¹⁴ are each independently hydrogen, a C₁-C₁₅ saturated hydrocarbyl group which may be substituted with hydroxy or saturated hydrocarbyloxy moiety, or optionally substituted aryl group, excluding that both R¹³ and R¹⁴ are hydrogen at the same time, R¹³ and R¹⁴ may bond together to form a ring with the carbon atom to which they are attached,
   A² is a single bond or a C₁-C₁₀ saturated hydrocarbylene group in which -CH₂- may be replaced by -O-, and
   W¹ is hydrogen, a C₁-C₁₀ aliphatic hydrocarbyl group or optionally substituted aryl group.
7. The negative resist composition of any one of claims 1 to 6 wherein the polymer further comprises repeat units of at least one type selected from repeat units having the formula (B3), repeat units having the formula (B4), and repeat units having the formula (B5): 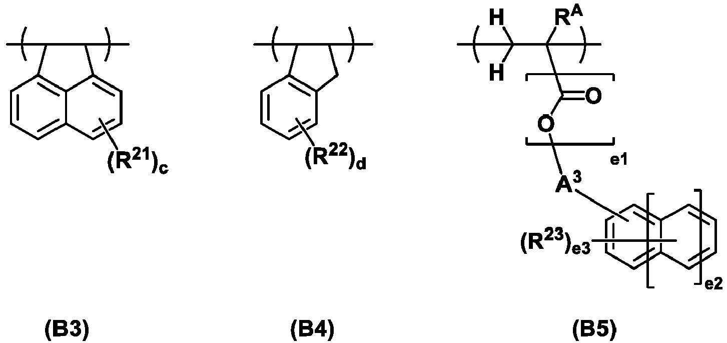 wherein c and d are each independently an integer of 0 to 4, e1 is 0 or 1, e2 is an integer of 0 to 2, e3 is an integer of 0 to 5,
   R^{A} is hydrogen, fluorine, methyl or trifluoromethyl,
   R²¹ and R²² are each independently hydroxy, halogen, optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group,
   R²³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro, cyano, C₁-C₂₀ saturated hydrocarbylsulfinyl group, or C₁-C₂₀ saturated hydrocarbylsulfonyl group,
   A³ is a single bond or C₁-C₁₀ saturated hydrocarbylene group in which -CH₂- may be replaced by -O-.
8. The negative resist composition of claim 6 wherein the polymer further comprises repeat units of at least one type selected from repeat units having the formulae (B6) to (B13): 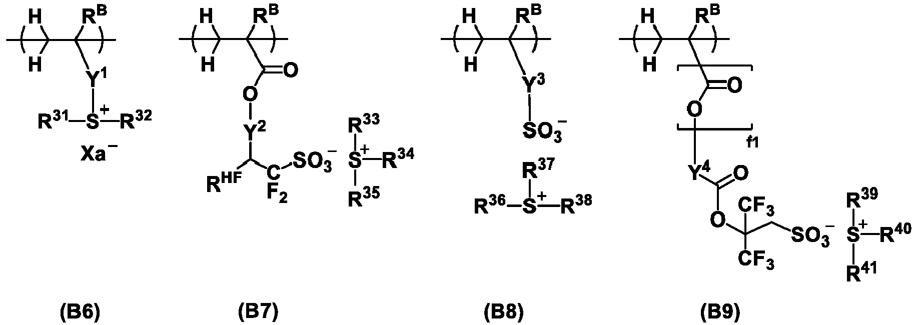 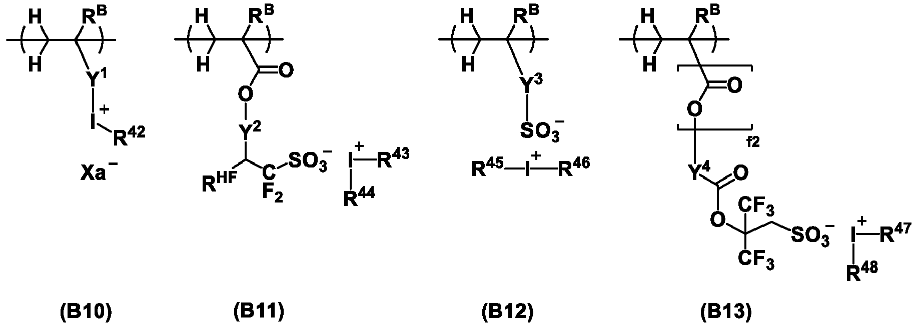 wherein R^{B} is each independently hydrogen or methyl,
   Y¹ is a single bond, a C₁-C₆ aliphatic hydrocarbylene group, phenylene group, naphthylene group or C₇-C₁₈ group obtained by combining the foregoing, *-O-Y¹¹-, *-C(=O)-O-Y¹¹-, or *-C(=O)-NH-Y¹¹-, Y¹¹ is a C₁-C₆ aliphatic hydrocarbylene group, phenylene group, naphthylene group or C₇-C₁₈ group obtained by combining the foregoing, which may contain a carbonyl moiety, ester bond, ether bond or hydroxy moiety,
   Y² is a single bond or **-Y²¹-C(=O)-O-, Y²¹ is a C₁-C₂₀ hydrocarbylene group which may contain a heteroatom,
   Y³ is a single bond, methylene, ethylene, phenylene, fluorinated phenylene, trifluoromethyl-substituted phenylene, *-O-Y³¹-, *-C(=O)-O-Y³¹-, or *-C(=O)-NH-Y³¹-, Y³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety,
   * designates a point of attachment to the carbon atom in the backbone, ** designates a point of attachment to the oxygen atom in the formula,
   Y⁴ is a single bond or C₁-C₃₀ hydrocarbylene group which may contain a heteroatom,
   f1 and f2 are each independently 0 or 1, f1 and f2 are 0 when Y⁴ is a single bond,
   R³¹ to R⁴⁸ are each independently halogen or a C₁-C₂₀ hydrocarbyl group which may contain a heteroatom, R³¹ and R³² may bond together to form a ring with the sulfur atom to which they are attached, R³³ and R³⁴, R³⁶ and R³⁷, or R³⁹ and R⁴⁰ may bond together to form a ring with the sulfur atom to which they are attached,
   R^{HF} is hydrogen or trifluoromethyl, and
   Xa⁻ is a non-nucleophilic counter ion.
9. The negative resist composition of claim 8 wherein the polymer further comprises repeat units having the formula (B 1-1), repeat units having the formula (B2-1) or repeat units having the formula (B2-2), and repeat units having the formula (B7): 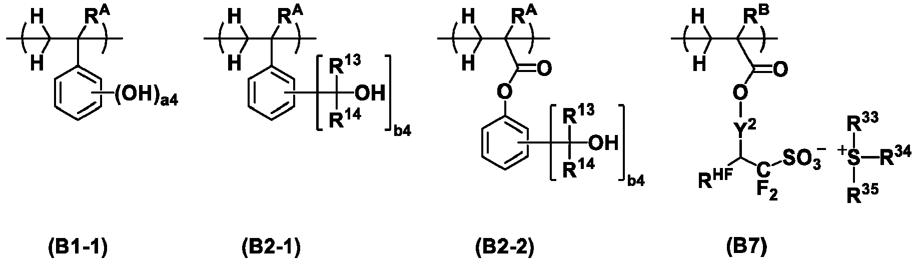 wherein a4, b4, R^{A}, R^{B}, Y², R¹³, R¹⁴, R³³, R³⁴, R³⁵, and R^{HF} are as defined above.
10. The negative resist composition of claim 8 or 9 wherein the base polymer (B) further contains a polymer comprising repeat units having formula (B1) and repeat units having formula (B2), but not repeat units having formulae (B6) to (B13).
11. The negative resist composition of any one of claims 1 to 10 wherein repeat units having an aromatic ring structure account for at least 60 mol% of the overall repeat units of the polymer in the base polymer.
12. The negative resist composition of any one of claims 1 to 11, further comprising (C) a crosslinker.
13. The negative resist composition of claim 6 which is free of a crosslinker.
14. The negative resist composition of any one of claims 1 to 13, further comprising (D) a fluorinated polymer comprising repeat units of at least one type selected from repeat units having the formula (D1), repeat units having the formula (D2), repeat units having the formula (D3) and repeat units having the formula (D4) and optionally repeat units of at least one type selected from repeat units having the formula (D5) and repeat units having the formula (D6): 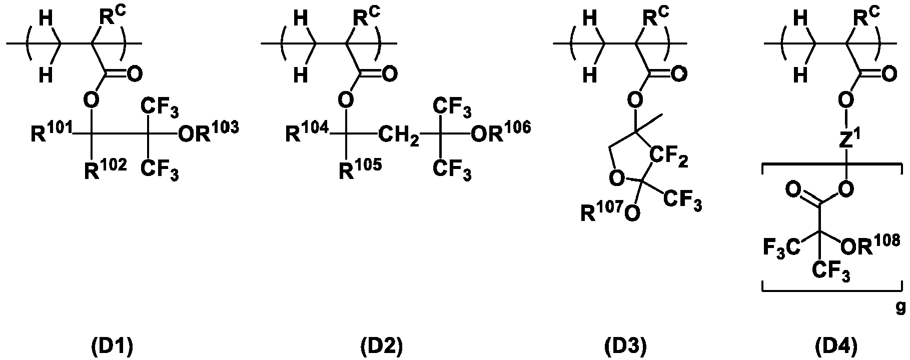 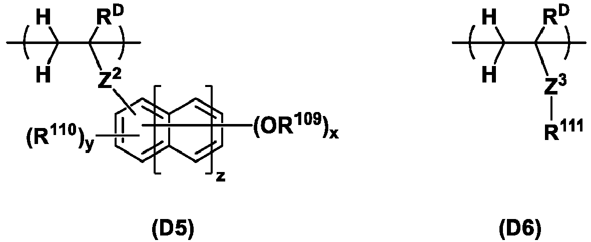 wherein x is an integer of 1 to 3, y is an integer satisfying 0 ≤ y ≤ 5+2z-x, z is 0 or 1, g is an integer of 1 to 3,
   R^{C} is each independently hydrogen, fluorine, methyl or trifluoromethyl,
   R^{D} is each independently hydrogen or methyl,
   R¹⁰¹, R¹⁰², R¹⁰⁴ and R¹⁰⁵ are each independently hydrogen or a C₁-C₁₀ saturated hydrocarbyl group,
   R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, and when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
   R¹⁰⁹ is hydrogen or a C₁-C₅ straight or branched hydrocarbyl group in which a heteroatom-containing moiety may intervene in a carbon-carbon bond,
   R¹¹⁰ is a C₁-C₅ straight or branched hydrocarbyl group in which a heteroatom-containing moiety may intervene in a carbon-carbon bond,
   R¹¹¹ is a C₁-C₂₀ saturated hydrocarbyl group in which at least one hydrogen is substituted by fluorine, and in which some constituent -CH₂- may be replaced by an ester bond or ether bond,
   Z¹ is a C₁-C₂₀ (g+1)-valent hydrocarbon group or C₁-C₂₀ (g+1)-valent fluorinated hydrocarbon group,
   Z² is a single bond, *-C(=O)-O- or *-C(=O)-NH-, * designates a point of attachment to the carbon atom in the backbone,
   Z³ is a single bond, -O-, *-C(=O)-O-Z³¹-Z³²- or *-C(=O)-NH-Z³¹-Z³²-, Z³¹ is a single bond or C₁-C₁₀ saturated hydrocarbylene group, Z³² is a single bond, ester bond, ether bond, or sulfonamide bond, and * designates a point of attachment to the carbon atom in the backbone.
15. The negative resist composition of any one of claims 1 to 14, further comprising (E) an acid generator.
16. The negative resist composition of claim 15 wherein the acid generator contains an anion having an acid strength (pKa) of -3.0 or larger.
17. The negative resist composition of claim 15 or 16 wherein the acid generator (E) and the quencher (A) are present in a weight ratio of less than 6/1.
18. The negative resist composition of any one of claims 1 to 17, further comprising (F) an organic solvent.
19. A resist pattern forming process comprising the steps of:
   applying the chemically amplified negative resist composition of any one of claims 1 to 18 onto a substrate to form a resist film thereon,
   exposing the resist film patternwise to high-energy radiation, and
   developing the exposed resist film in an alkaline developer.
20. The process of claim 19 wherein the high-energy radiation is EUV or EB.
21. The process of claim 19 or 20 wherein the substrate has the outermost surface of a material containing at least one element selected from chromium, silicon, tantalum, molybdenum, cobalt, nickel, tungsten, and tin.
22. The process of any one of claims 19 to 21 wherein the substrate is a mask blank of transmission or reflection type.
23. A mask blank of transmission or reflection type which is coated with the chemically amplified negative resist composition of any one of claims 1 to 18.

### ADVANTAGEOUS EFFECTS OF INVENTION

Owing to the quencher function of the onium salt having formula (A), a resist composition comprising the onium salt is effective for controlling acid diffusion upon light exposure for pattern formation. When the composition is coated onto a substrate to form a resist film, which is processed by EUV or EB lithography, a pattern having a very high resolution, high fidelity, improved LER and dose margin can be formed. Owing to the repeat units having formula (B 1), the adhesion of the resist film to the substrate is enhanced and the dissolution of the resist film in alkaline developer is facilitated.

Since the resist pattern forming process using the chemically amplified negative resist composition can form a pattern having a very high resolution, high fidelity, improved LER and dose margin, the resist composition and the pattern forming process are advantageously applicable to the micropatterning technology, especially EUV and EB lithography processes.

### DESCRIPTION OF EMBODIMENTS

As used herein, the singular forms "a," "an" and "the" include plural referents unless the context clearly dictates otherwise. "Optional" or "optionally" means that the subsequently described event or circumstances may or may not occur, and that description includes instances where the event or circumstance occurs and instances where it does not. The notation (Cn-Cm) means a group containing from n to m carbon atoms per group. In chemical formulae, Me stands for methyl, and Ac for acetyl. Both the broken line (---) and the asterisk (*) designate a point of attachment or valence bond. As used herein, the term "fluorinated" refers to a fluorine-substituted or fluorine-containing compound or group. The terms "group" and "moiety" are interchangeable.

The abbreviations and acronyms have the following meaning.
EB: electron beam
EUV: extreme ultraviolet
Mw: weight average molecular weight
Mn: number average molecular weight
Mw/Mn: molecular weight distribution or dispersity
GPC: gel permeation chromatography
PEB: post-exposure bake
PAG: photoacid generator
LER: line edge roughness
EL: exposure latitude
DOF: depth of focus
CDU: critical dimension uniformity

It is understood that for some structures represented by chemical formulae, there can exist enantiomers and diastereomers because of the presence of asymmetric carbon atoms. In such a case, a single formula collectively represents all such isomers. The isomers may be used alone or in admixture.

### Chemically amplified negative resist composition

One embodiment of the invention is a chemically amplified negative resist composition comprising (A) a quencher containing an onium salt having a specific nitrogen-containing heterocycle and a fluorocarboxylic acid structure and (B) a base polymer containing a specific polymer.

### (A) Quencher

The quencher as component (A) contains an onium salt having the formula (A).

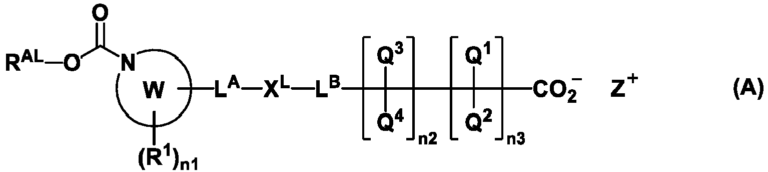

In formula (A), n1 is an integer of 0 to 6; n2 is an integer of 0 to 3, preferably 0 or 1; n3 is an integer of 1 to 4, preferably 1 or 2, most preferably 1.

In formula (A), W is a C₂-C₂₀ nitrogen-containing aliphatic heterocycle which may contain a heteroatom. Exemplary structures of W are shown below, but not limited thereto. It is noted that in each structure, * designates a point of attachment to L^{A}, and ** designates a point of attachment to R^{AL}-O-C(=O)-.

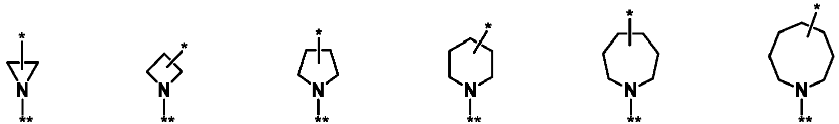

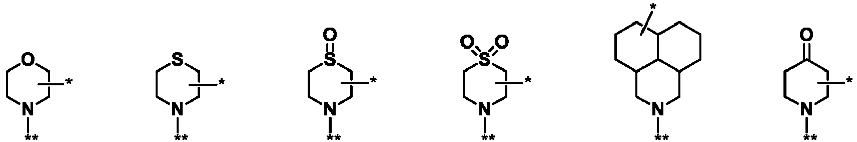

In formula (A), L^{A} and L^{B} are each independently a single bond, ether bond, ester bond, amide bond, sulfonate ester bond, carbonate bond or carbamate bond. Of these, a single bond, ether bond, ester bond and amide bond are preferred, with a single bond, ester bond and amide bond being more preferred.

In formula (A), X^{L} is a single bond or a C₁-C₄₀ hydrocarbylene group which may contain a heteroatom. The hydrocarbylene group may be straight, branched or cyclic and examples thereof include alkanediyl groups and cyclic saturated hydrocarbylene groups. Suitable heteroatoms include oxygen, nitrogen, and sulfur.

Examples of the optionally heteroatom-containing C₁-C₄₀ hydrocarbylene group X^{L} are shown below, but not limited thereto. Herein * each designates a point of attachment to L^{A} or L^{B}.

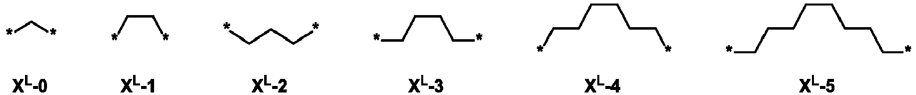

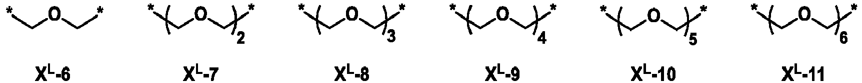

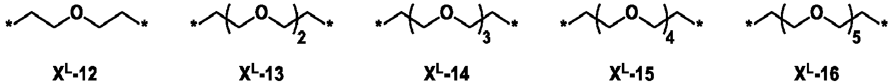

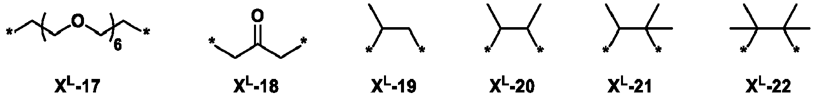

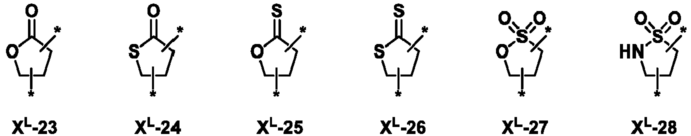

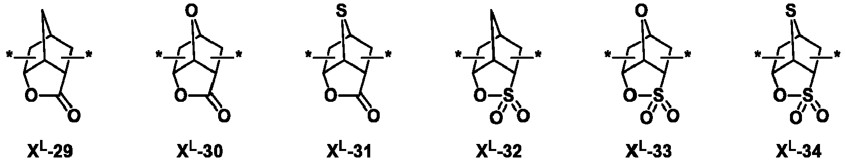

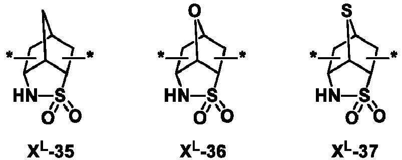

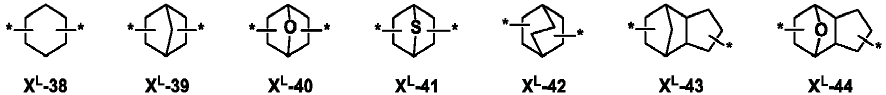

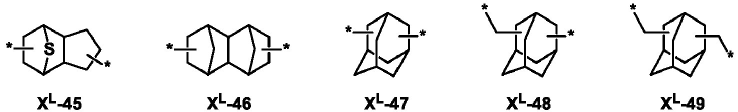

Of these, X^{L}-0 to X^{L}-22 and X^{L}-47 to X^{L}-49 are preferred, with X^{L}-0 to X^{L}-17 being more preferred.

In formula (A), R¹ is a C₁-C₂₀ hydrocarbyl group which may contain a heteroatom. The hydrocarbyl group may be saturated or unsaturated and straight, branched or cyclic. Examples thereof include C₁-C₂₀ alkyl groups such as methyl, ethyl, propyl, isopropyl, n-butyl, isobutyl, sec-butyl, tert-butyl, n-pentyl, tert-pentyl, n-hexyl, n-octyl, 2-ethylhexyl, n-nonyl, and n-decyl; C₃-C₂₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decyl, adamantyl, and adamantylmethyl; C₆-C₂₀ aryl groups such as phenyl, naphthyl and anthryl, and combinations thereof. In the hydrocarbyl group, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy moiety, fluorine, chlorine, bromine, iodine, cyano moiety, carbonyl moiety, ether bond, ester bond, sulfonate ester bond, carbonate bond, carbamate bond, amide bond, imide bond, lactone ring, sultone ring, thiolactone ring, lactam ring, sultam ring, carboxylic anhydride (-C(=O)-O-C(=O)-) or haloalkyl moiety.

When n1 is 2 or more (i.e., n1 ≥ 2), a plurality of R¹ may bond together to form a ring with the carbon atoms on W to which they are attached. Examples of the ring include cyclopropane, cyclobutane, cyclopentane, cyclohexane, norbornane, and adamantane rings. In the ring, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the ring may contain a hydroxy moiety, fluorine, chlorine, bromine, iodine, cyano moiety, carbonyl moiety, ether bond, ester bond, sulfonate ester bond, carbonate bond, lactone ring, sultone ring, carboxylic anhydride (-C(=O)-O-C(=O)-) or haloalkyl moiety. Also, two R¹ may bond with a common atom on W and bond together to form a ring, i.e., spiro ring.

In formula (A), Q¹ to Q⁴ are each independently hydrogen, fluorine, a C₁-C₆ hydrocarbyl group or C₁-C₆ fluorinated hydrocarbyl group. At least one of Q¹ to Q⁴ is fluorine or a C₁-C₆ fluorinated hydrocarbyl group. The hydrocarbyl group may be saturated or unsaturated and straight, branched or cyclic. Examples of the hydrocarbyl group are as exemplified for the C₁-C₂₀ hydrocarbyl group R¹, but of 1 to 6 carbon atoms. Typical of the C₁-C₆ fluorinated hydrocarbyl group is trifluoromethyl. Q³ and Q⁴ may bond together to form a ring with the carbon atom to which they are attached. Examples of the ring include cyclopropane, cyclobutane, cyclopentane, cyclohexane, norbornane, and adamantane rings.

In formula (A), R^{AL} is an acid labile group. Preferably, R^{AL} is a group having the formula (AL-1) or (AL-2).

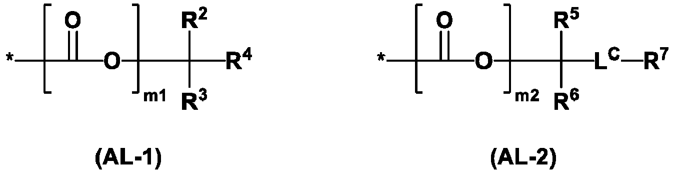

Herein * designates a point of attachment to the adjacent -O-.

In formula (AL-1), R², R³ and R⁴ are each independently a C₁-C₁₀ hydrocarbyl group. Any two of R², R³ and R⁴ may bond together to form a ring with the carbon atom to which they are attached. The subscript m1 is 0 or 1.

In formula (AL-2), L^{C} is -O- or -S-. R⁵ and R⁶ are each independently hydrogen or a C₁-C₁₀ hydrocarbyl group. R⁷ is a C₁-C₂₀ hydrocarbyl group in which -CH₂- may be replaced by -O- or -S-. R⁶ and R⁷ may bond together to form a C₃-C₂₀ heterocyclic group with the carbon atom and L^{C} to which they are attached. Some constituent -CH₂- in the heterocyclic group may be replaced by -O- or -S-. The subscript m2 is 0 or 1.

Examples of the acid labile group having formula (AL-1) are shown below, but not limited thereto. Herein * designates a point of attachment to the adjacent -O-.

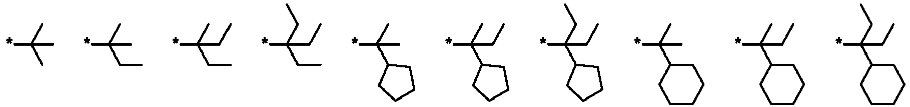

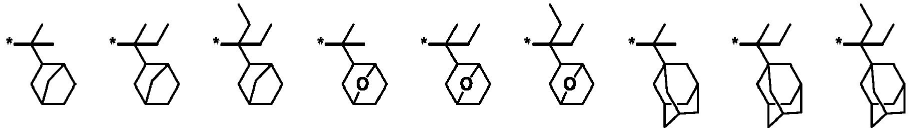

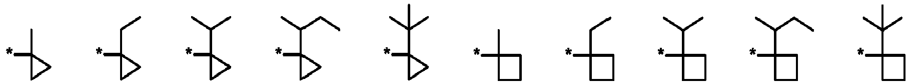

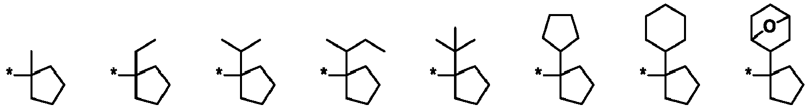

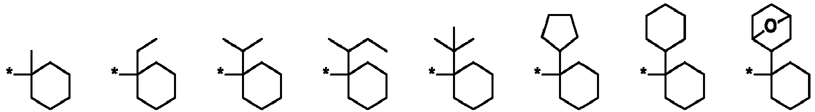

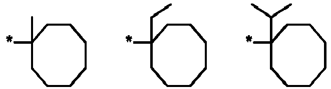

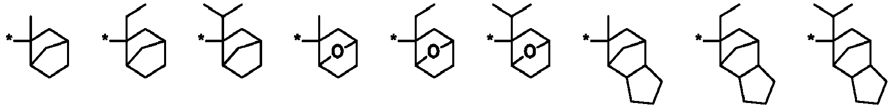

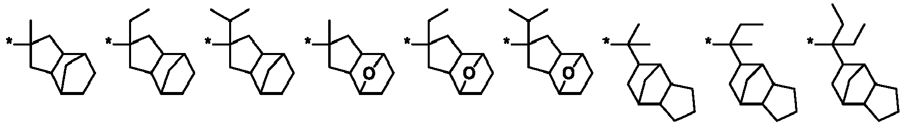

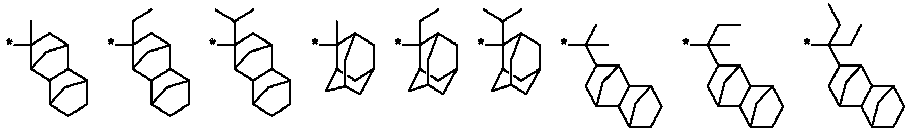

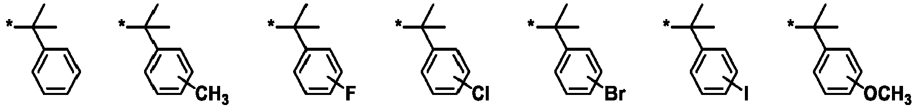

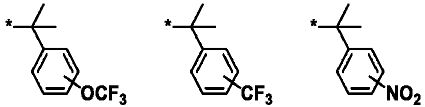

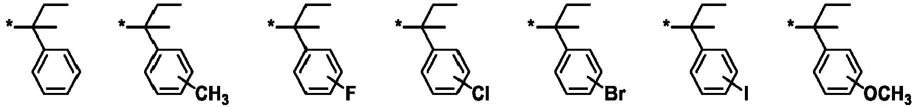

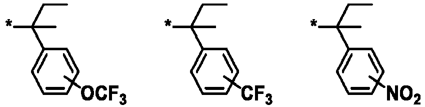

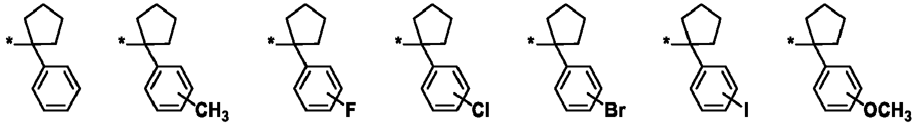

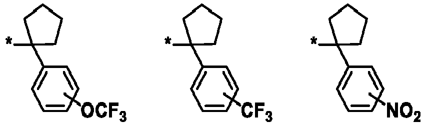

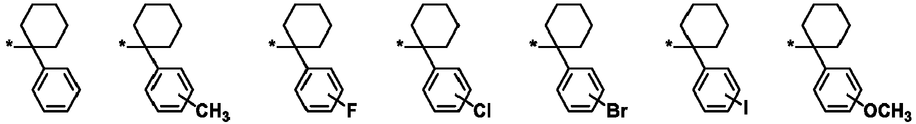

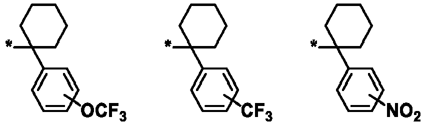

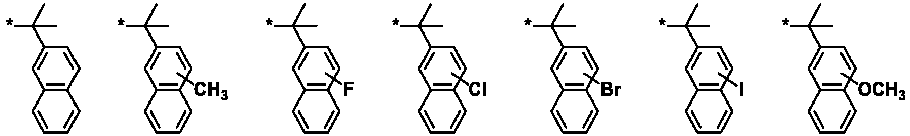

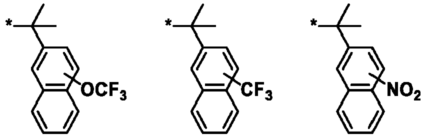

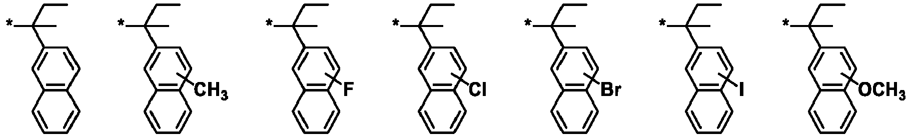

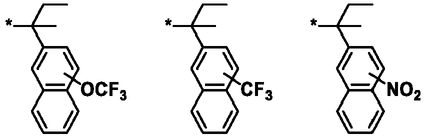

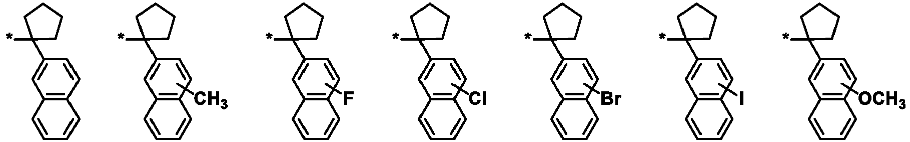

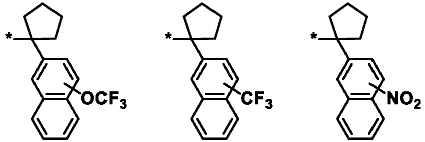

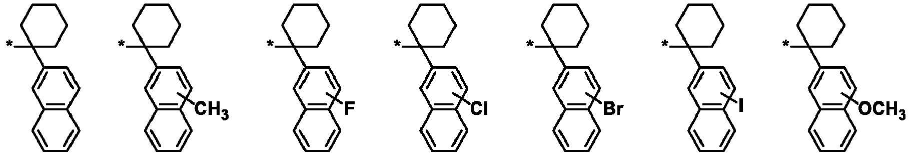

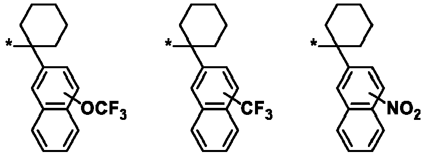

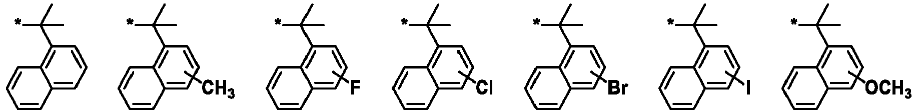

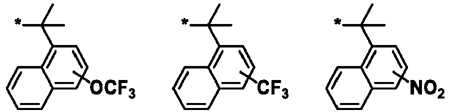

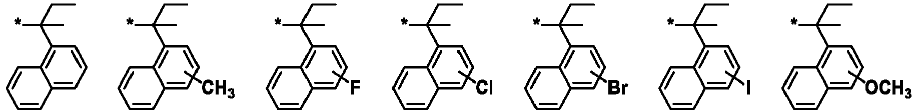

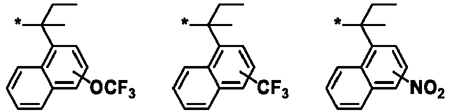

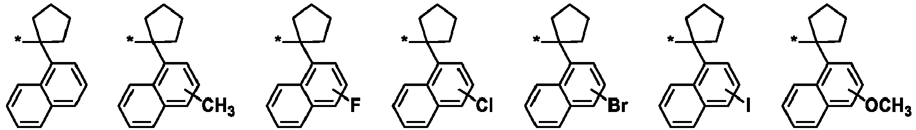

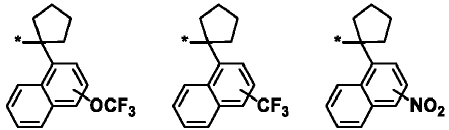

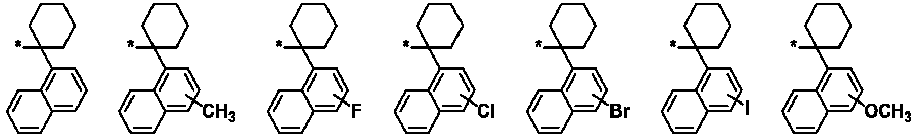

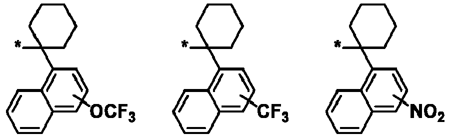

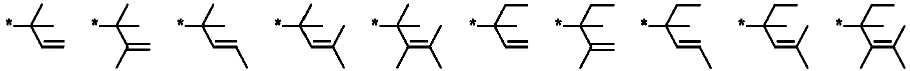

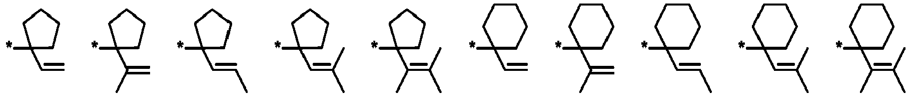

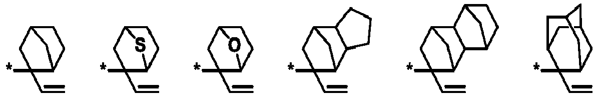

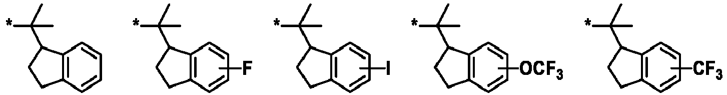

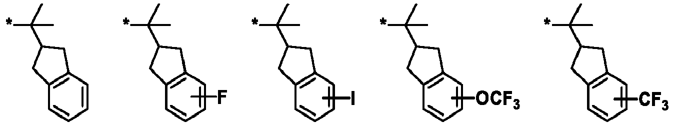

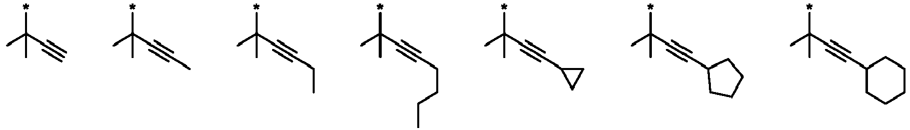

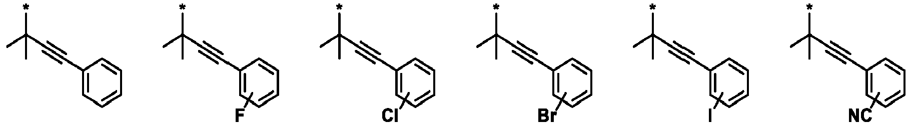

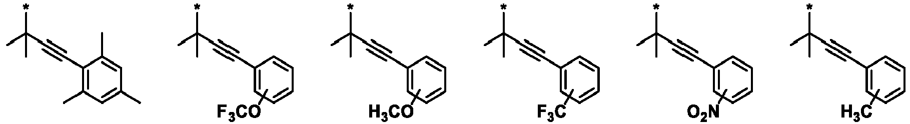

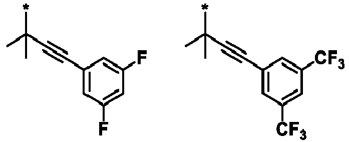

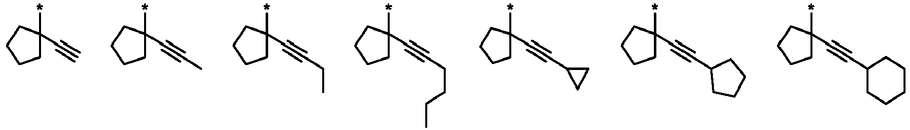

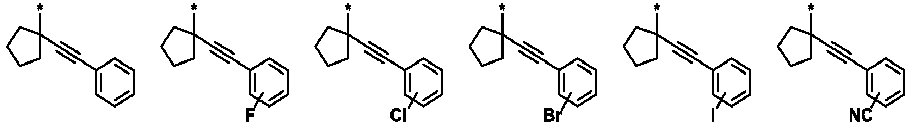

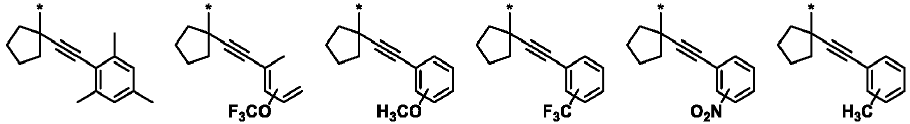

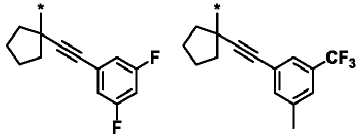

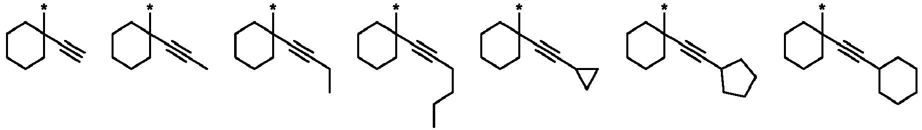

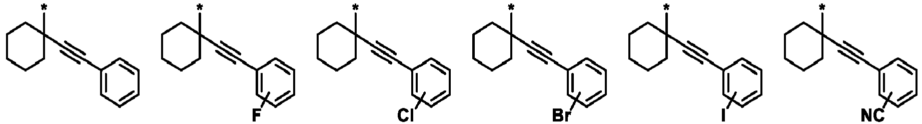

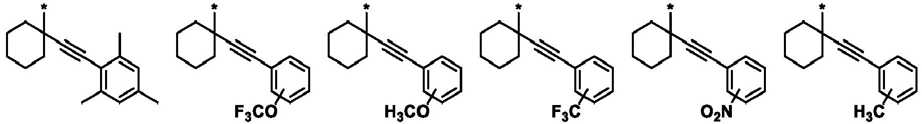

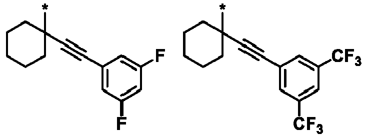

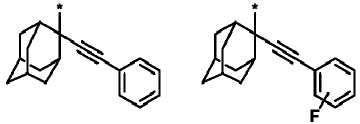

Examples of the acid labile group having formula (AL-2) are shown below, but not limited thereto. Herein * designates a point of attachment to the adjacent -O-.

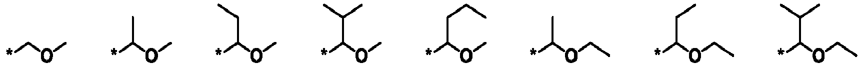

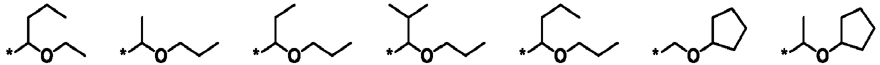

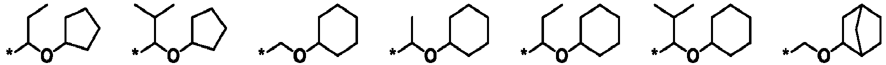

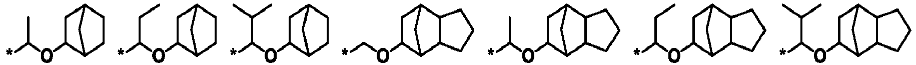

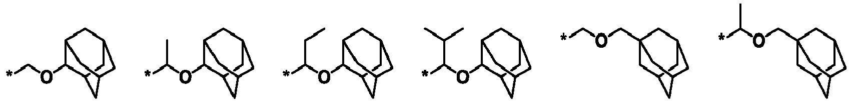

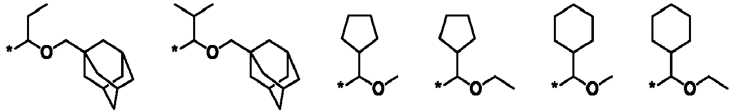

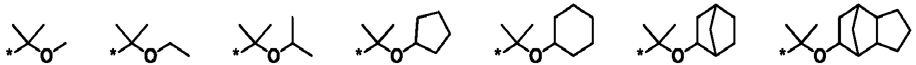

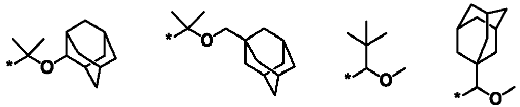

Of the onium salts having formula (A), those having the formula (A1) are preferred. 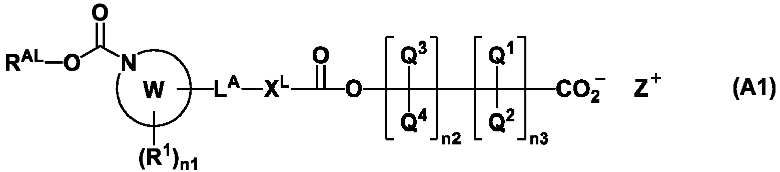 Herein n1 to n3, W, L^{A}, X^{L}, R¹, Q¹ to Q⁴, R^{AL} and Z⁺ are as defined above.

Of the onium salts having formula (A1), those having the formula (A2) are more preferred. 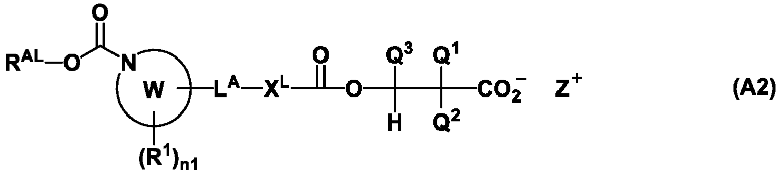 Herein n1, W, L^{A}, X^{L}, R¹, Q¹ to Q³, R^{AL} and Z⁺ are as defined above.

Examples of the anion in the onium salt having formula (A) are shown below, but not limited thereto.

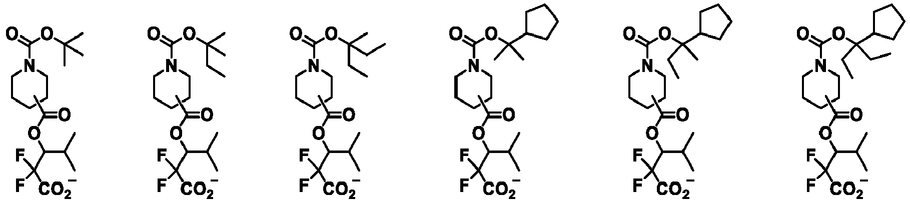

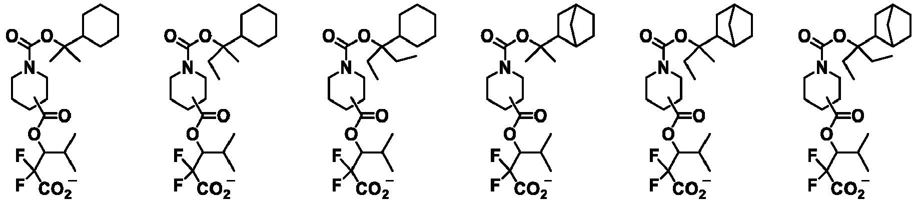

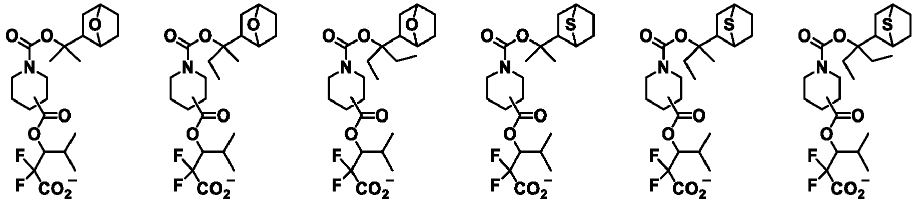

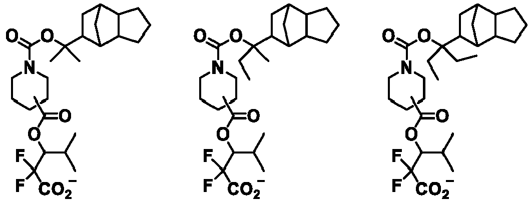

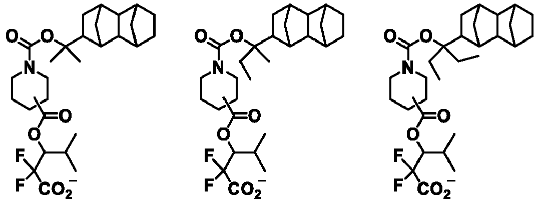

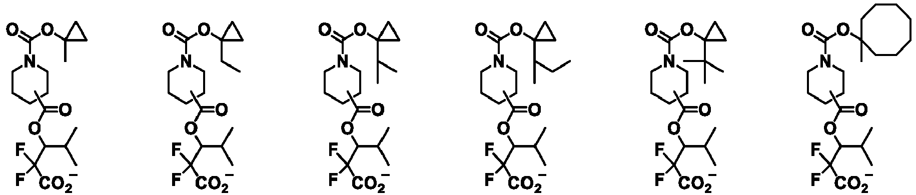

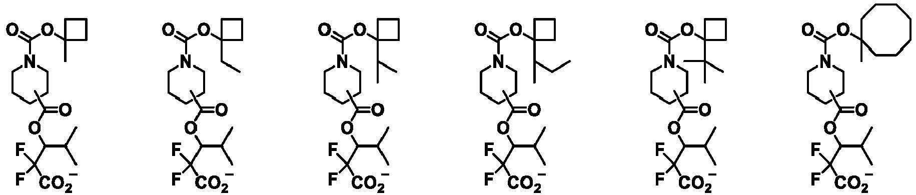

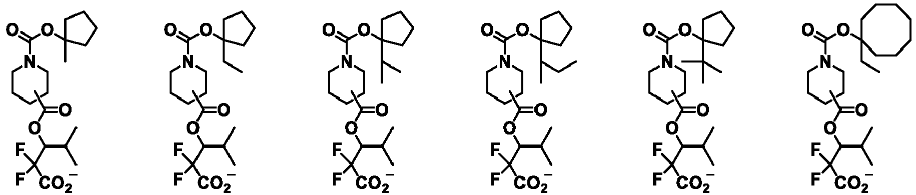

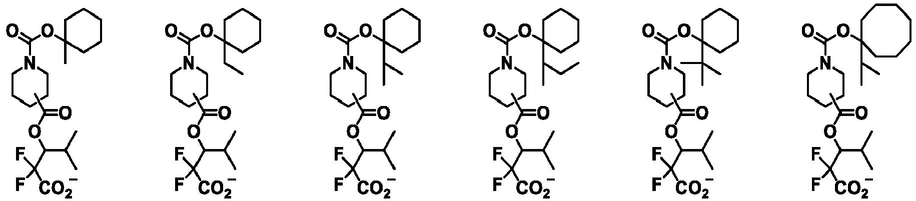

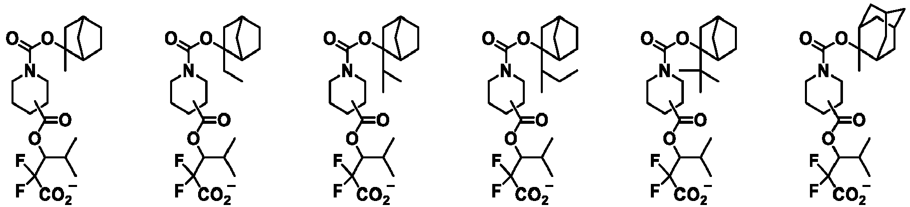

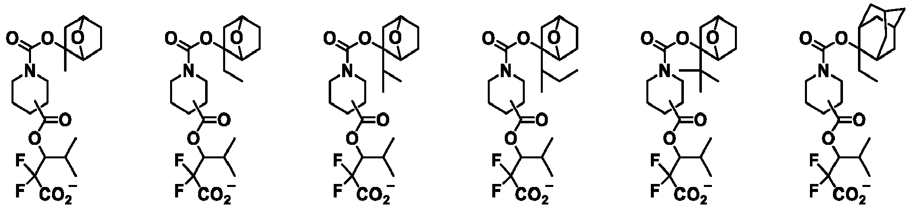

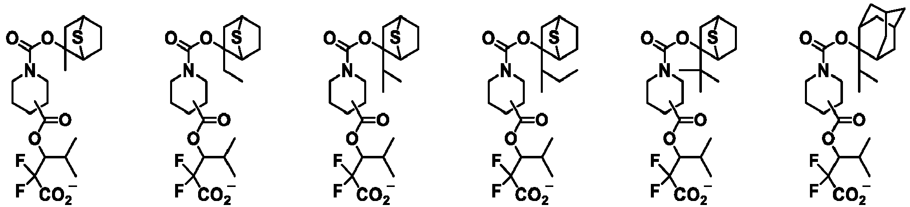

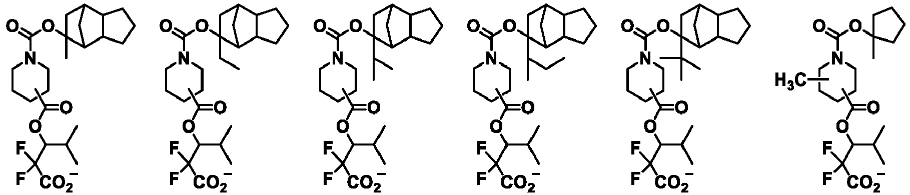

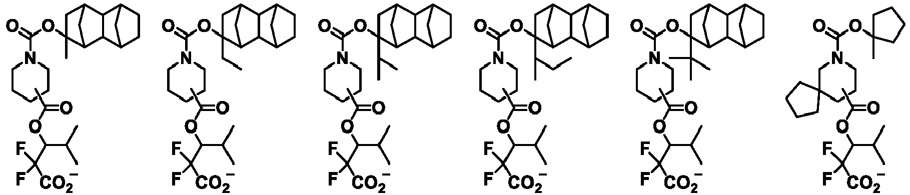

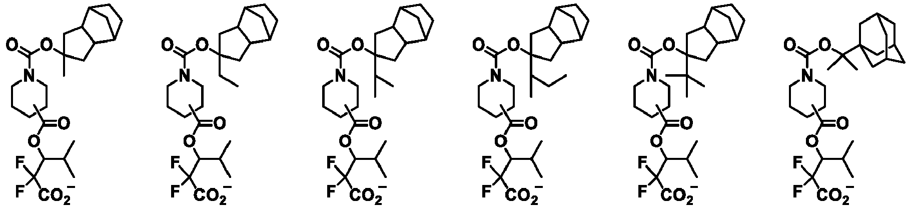

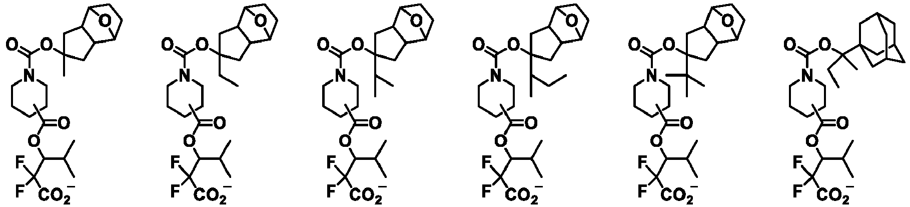

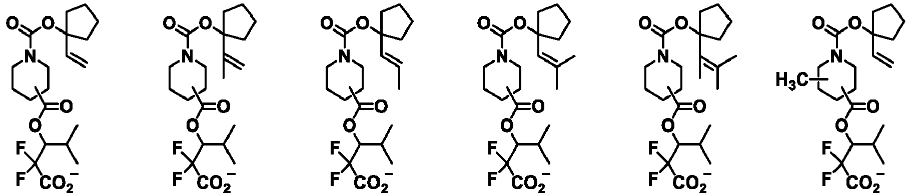

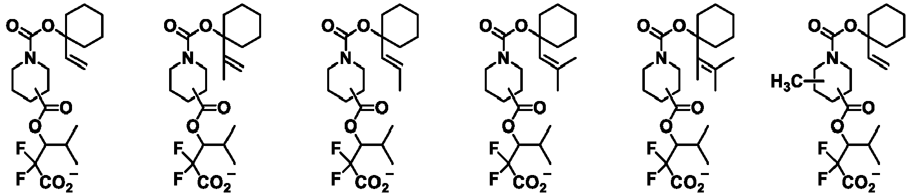

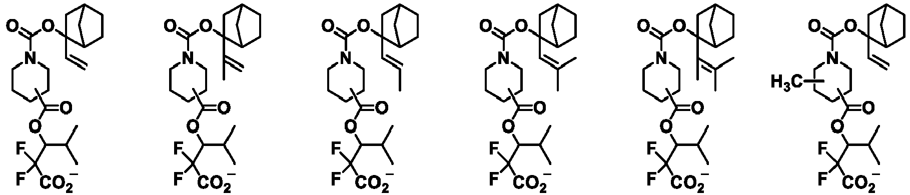

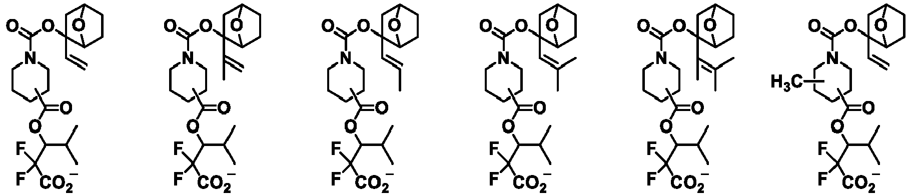

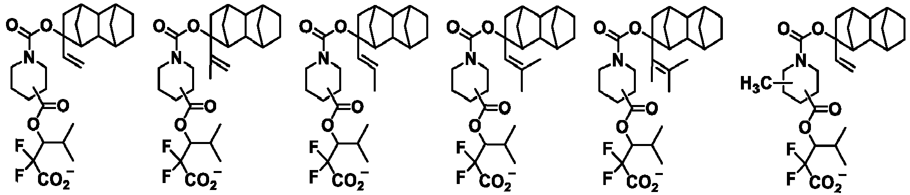

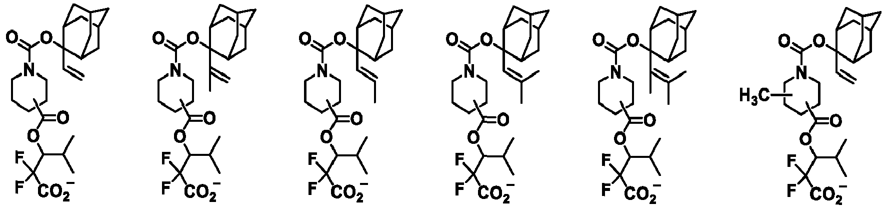

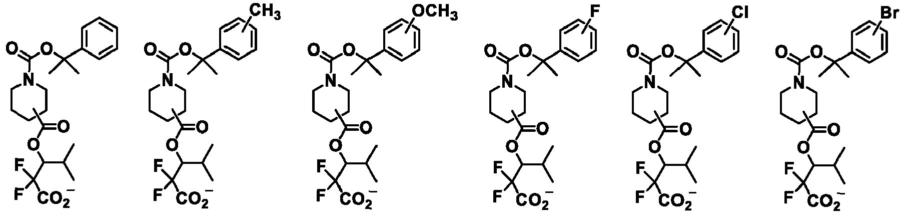

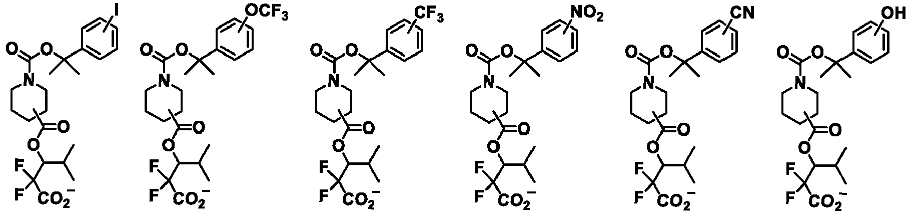

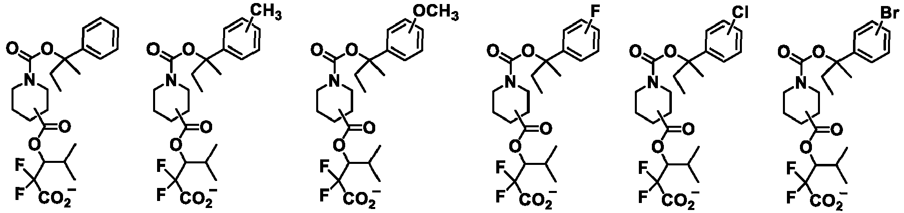

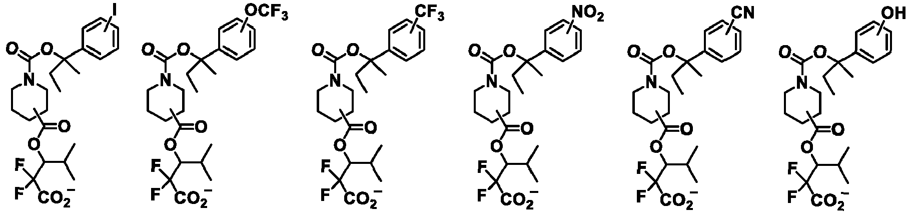

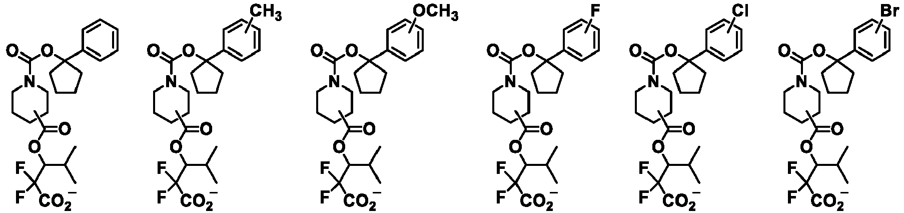

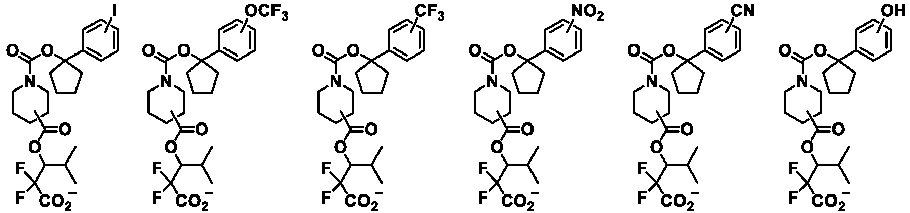

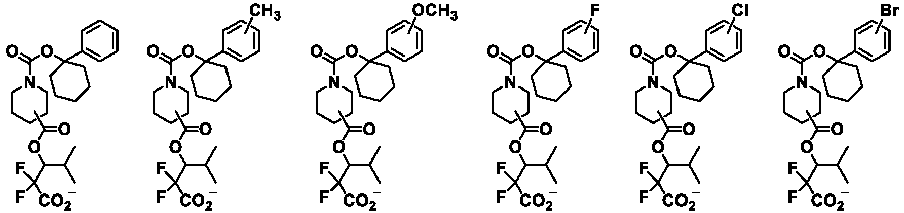

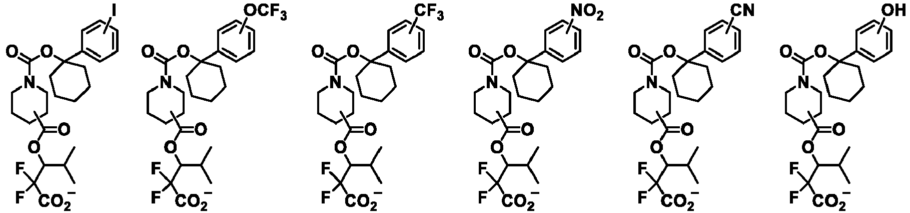

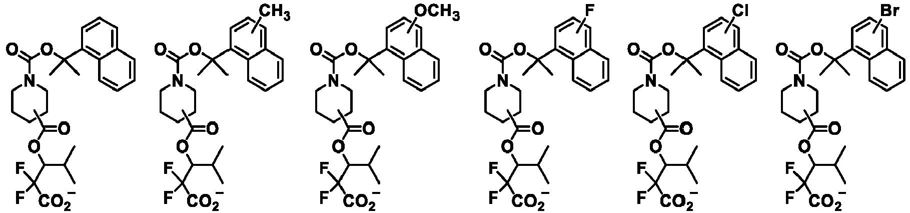

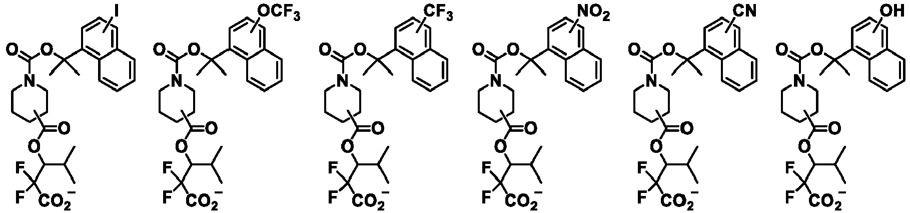

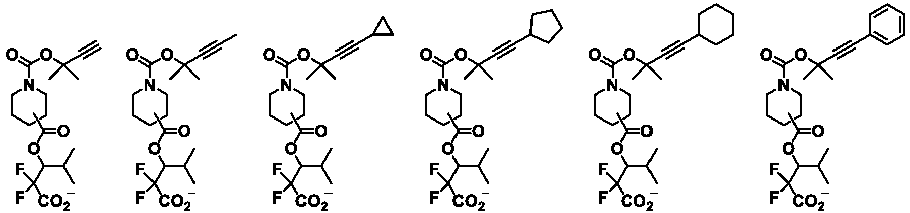

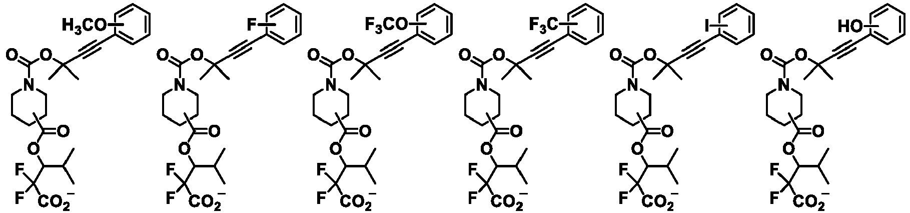

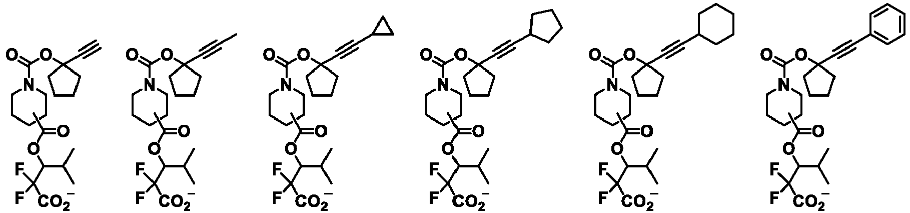

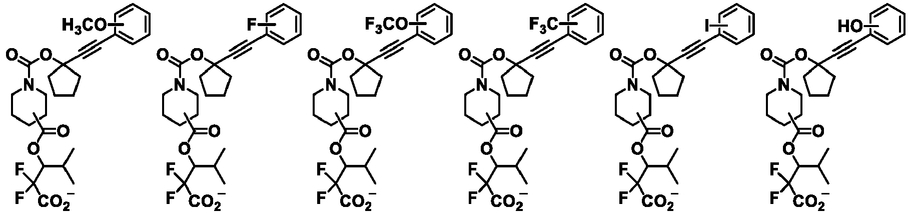

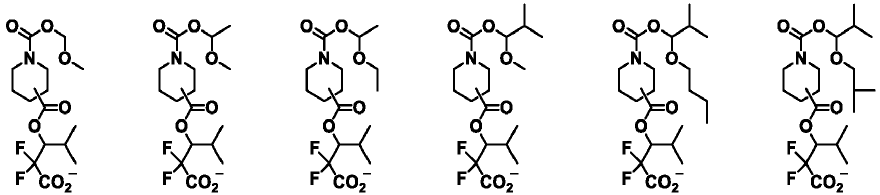

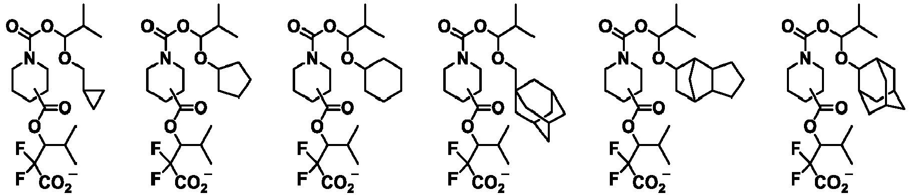

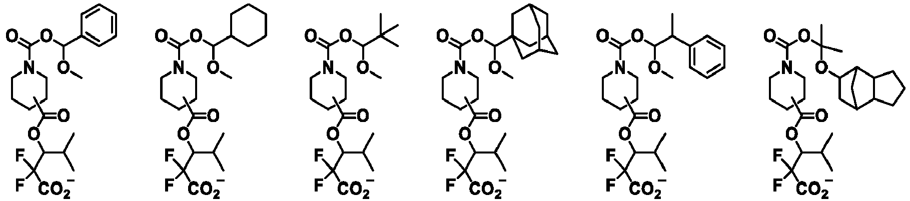

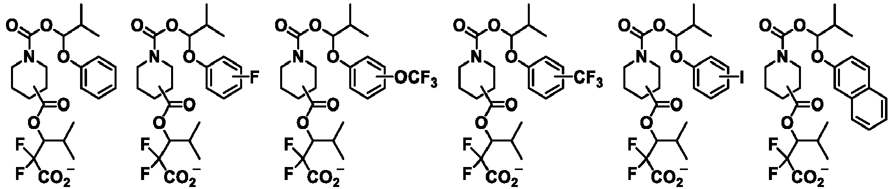

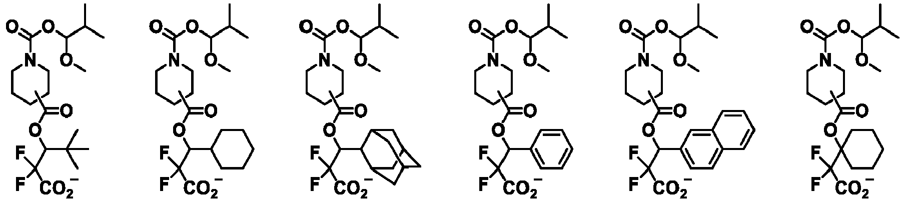

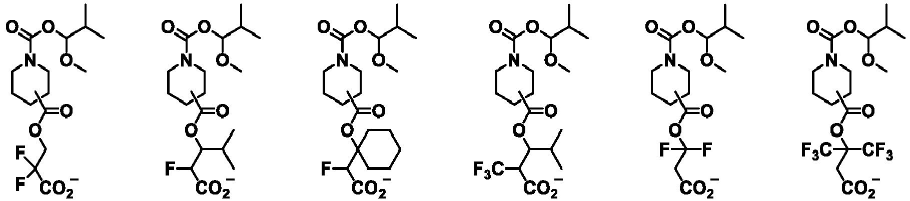

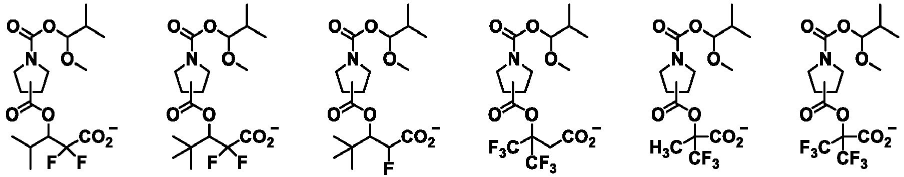

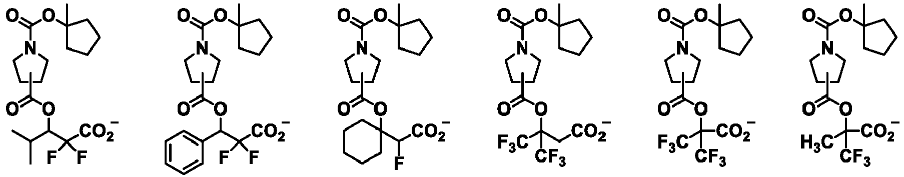

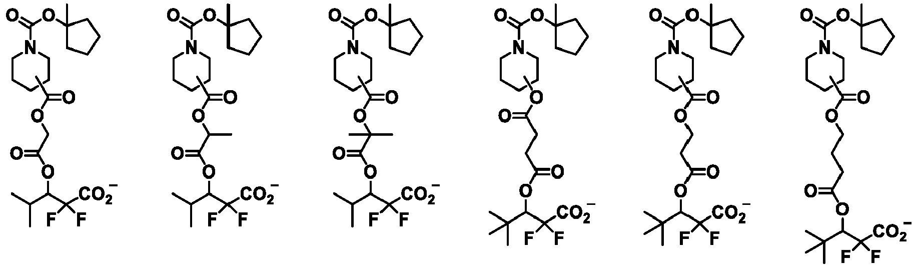

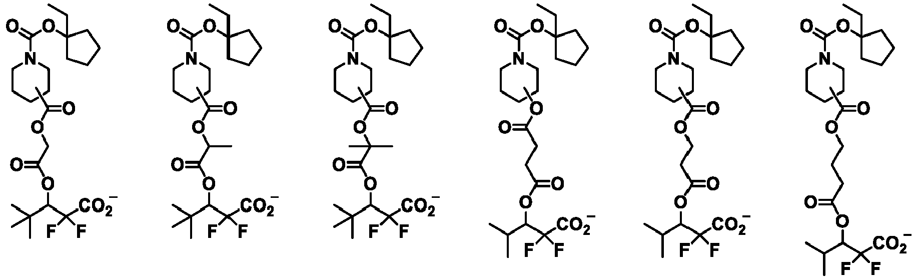

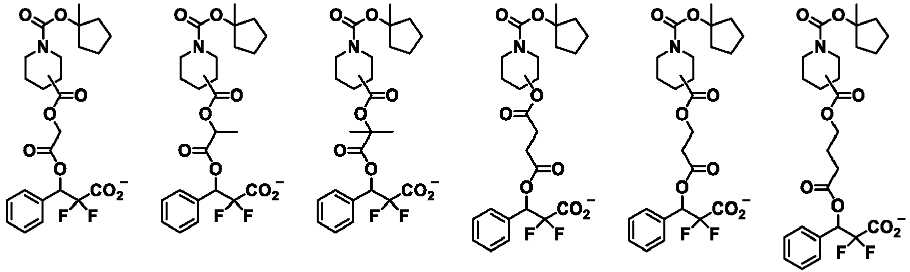

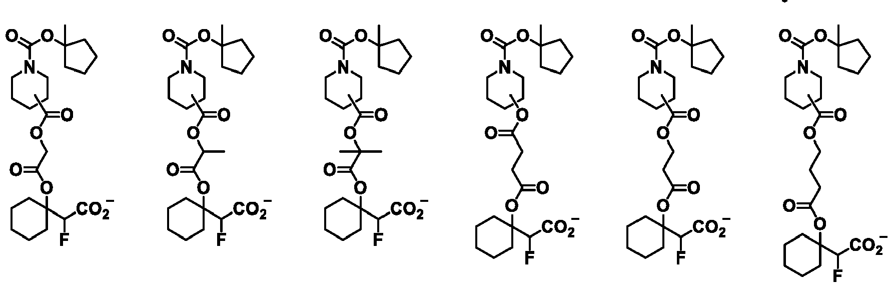

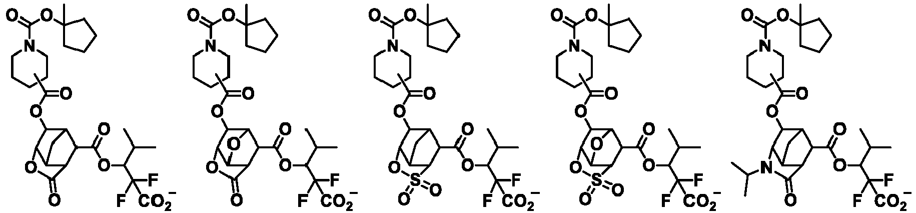

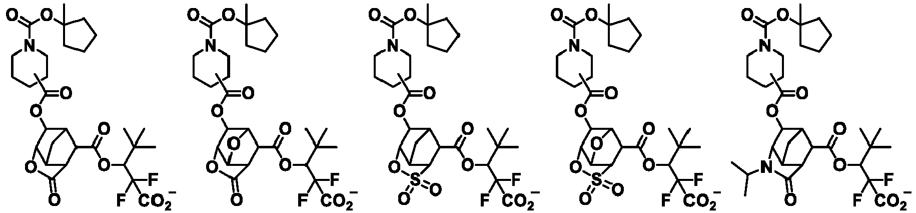

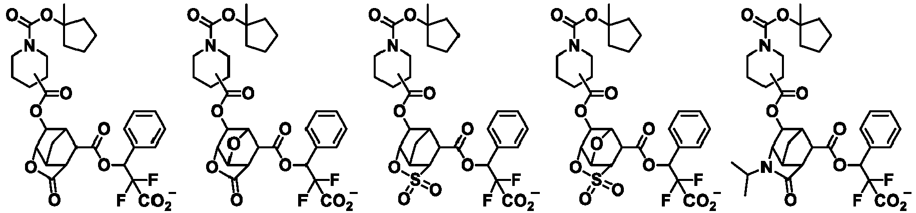

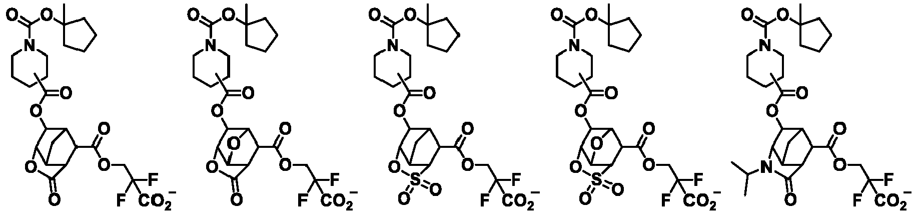

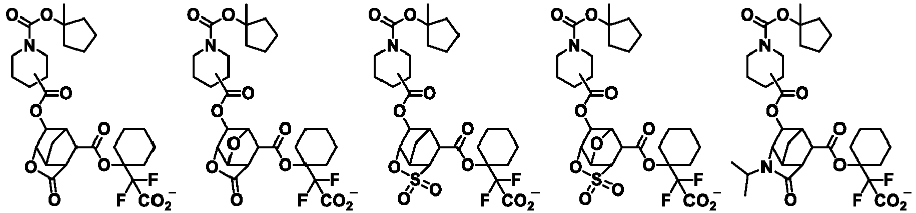

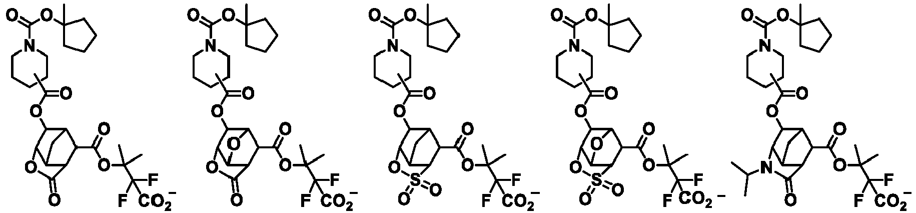

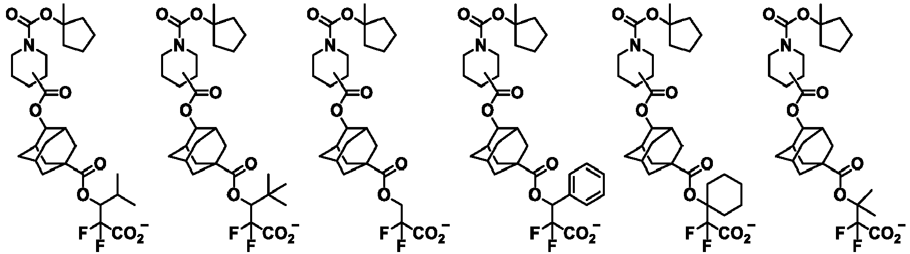

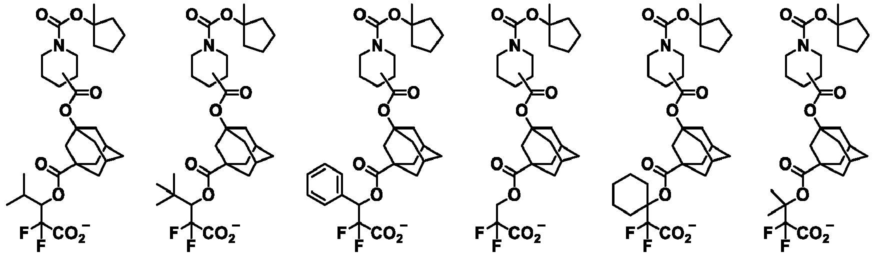

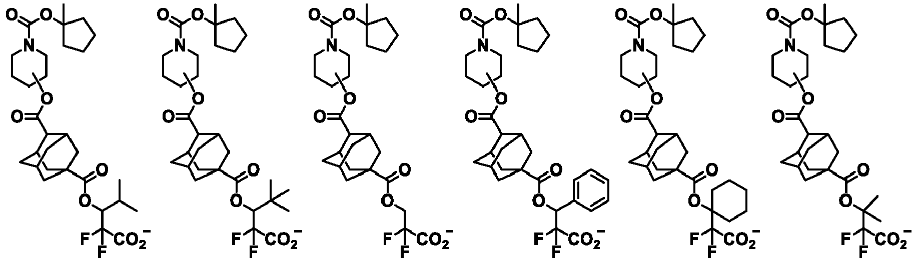

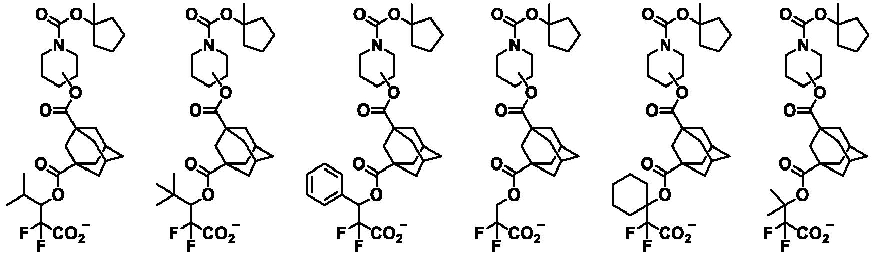

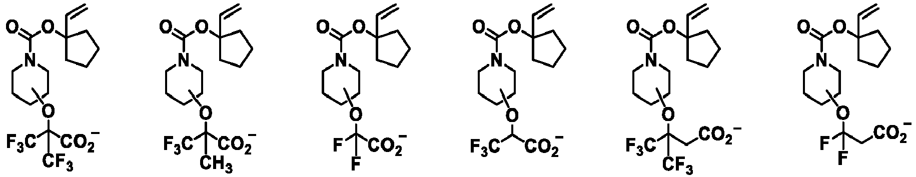

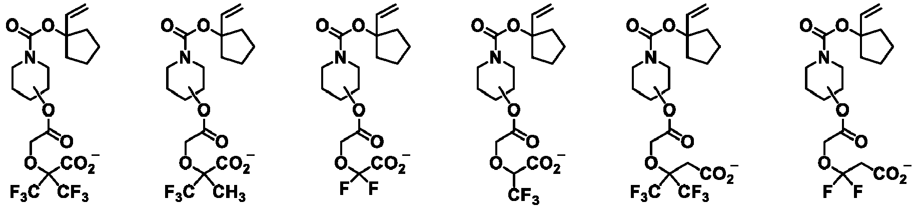

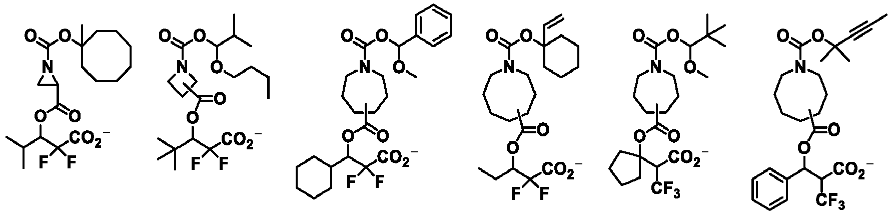

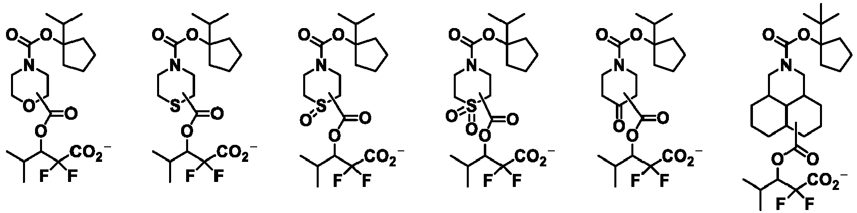

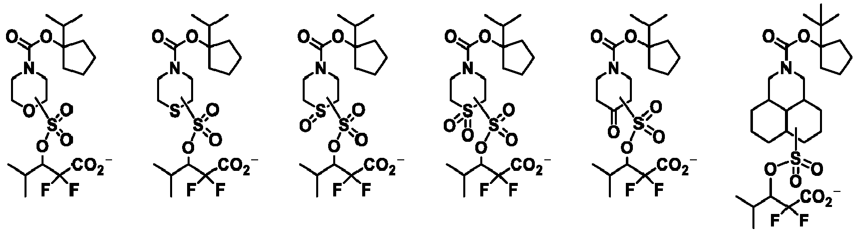

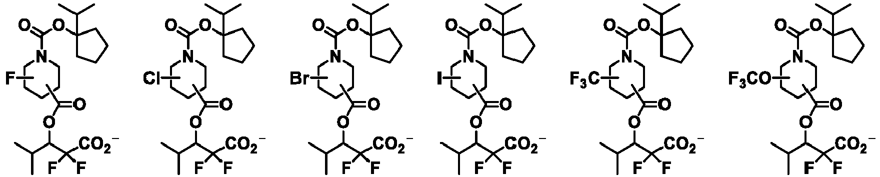

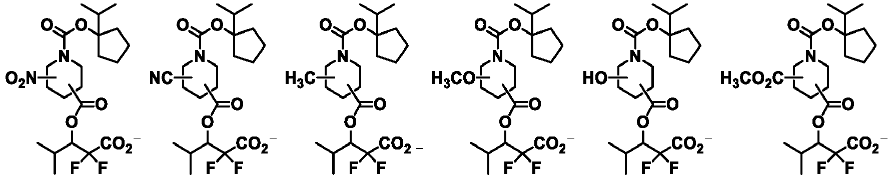

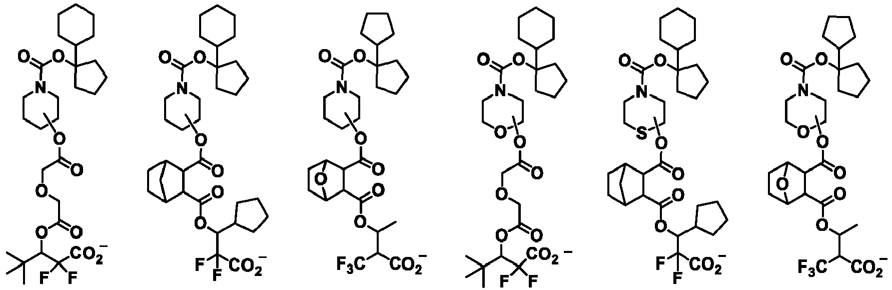

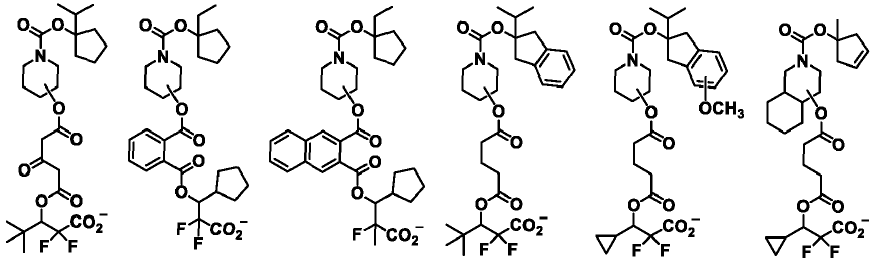

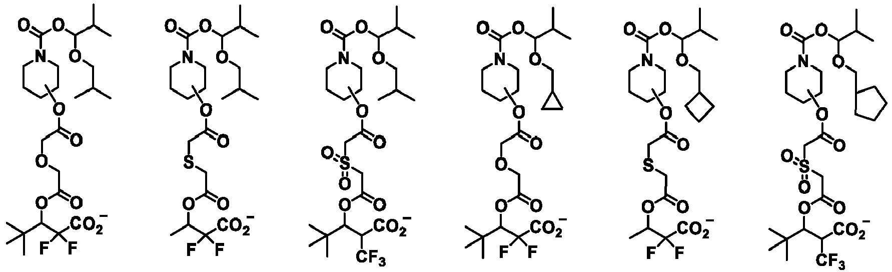

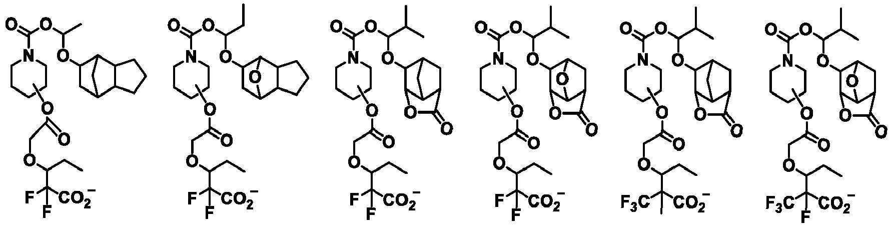

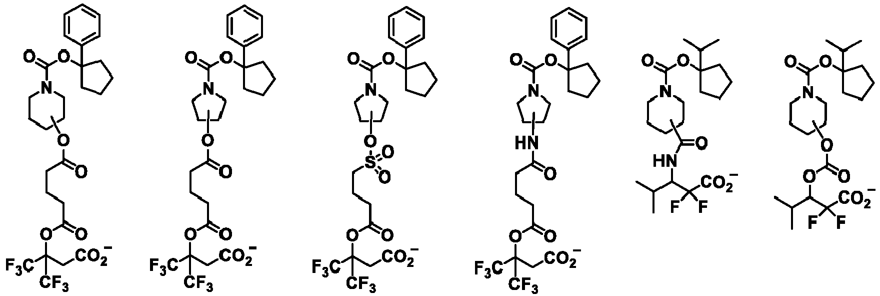

In formula (A), Z⁺ is an onium cation. Preferred are sulfonium cations having the formula (cation-1), iodonium cations having the formula (cation-2), and ammonium cations having the formula (cation-3).

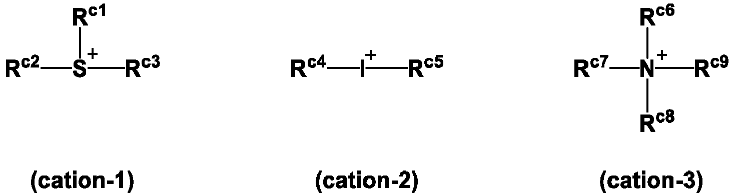

In formulae (cation-1) to (cation-3), R^{c1} to R^{c9} are each independently halogen or a C₁-C₃₀ hydrocarbyl group which may contain a heteroatom.

Suitable halogen atoms include fluorine, chlorine, bromine and iodine.

The hydrocarbyl group represented by R^{c1} to R^{c9} may be saturated or unsaturated and straight, branched or cyclic. Examples thereof include C₁-C₃₀ alkyl groups such as methyl, ethyl, n-propyl, isopropyl, n-butyl, isobutyl, sec-butyl, and tert-butyl; C₃-C₃₀ cyclic saturated hydrocarbyl groups such as cyclopropyl, cyclopentyl, cyclohexyl, cyclopropylmethyl, 4-methylcyclohexyl, cyclohexylmethyl, norbornyl, and adamantyl; C₂-C₃₀ alkenyl groups such as vinyl, allyl, propenyl, butenyl, and hexenyl; C₃-C₃₀ cyclic unsaturated hydrocarbyl groups such as cyclohexenyl; C₆-C₃₀ aryl groups such as phenyl, naphthyl and thienyl; C₇-C₃₀ aralkyl groups such as benzyl, 1-phenylethyl and 2-phenylethyl, and combinations thereof. Inter alia, aryl groups are preferred. In the hydrocarbyl group, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy moiety, fluorine, chlorine, bromine, iodine, cyano moiety, nitro moiety, carbonyl moiety, ether bond, ester bond, sulfonate ester bond, carbonate bond, lactone ring, sultone ring, carboxylic anhydride (-C(=O)-O-C(=O)-) or haloalkyl moiety.

Also, R^{c1} and R^{c2} may bond together to form a ring with the sulfur atom to which they are attached. Examples of the sulfonium cation having formula (cation-1) wherein R^{c1} and R^{c2} form a ring are shown below.

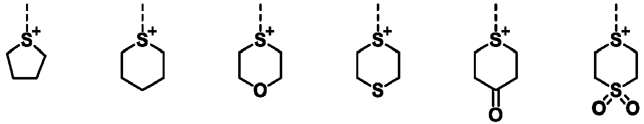

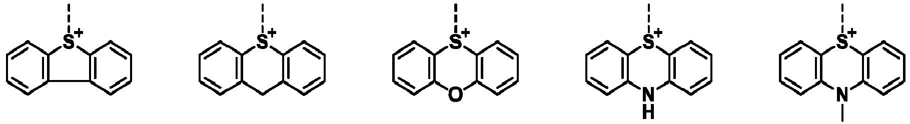

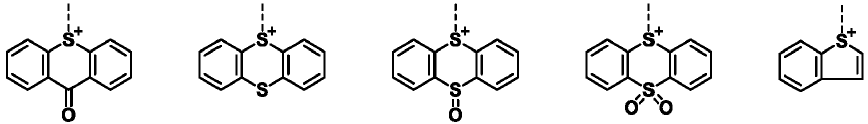

Herein the broken line designates a point of attachment to R^{c3}.

Examples of the sulfonium cation having formula (cation-1) are shown below, but not limited thereto.

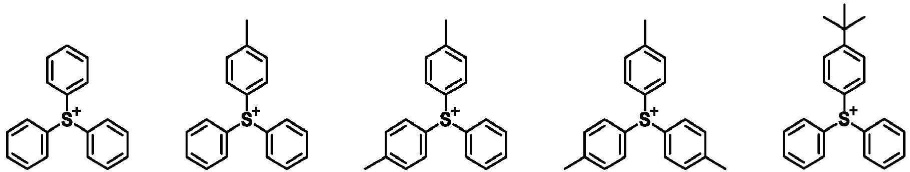

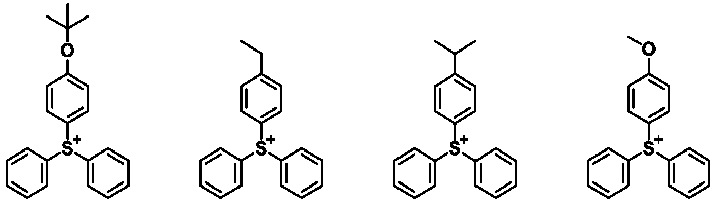

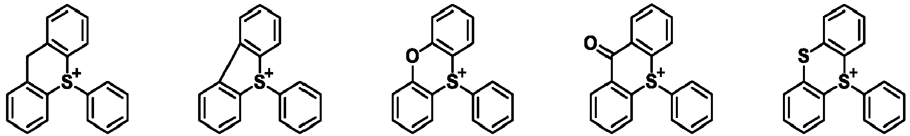

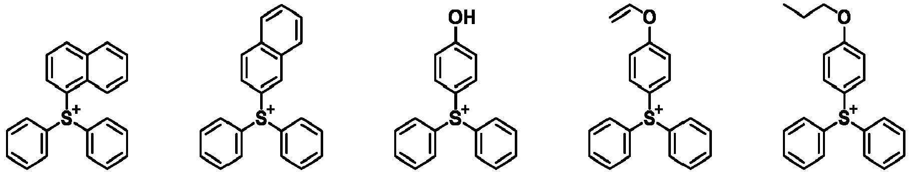

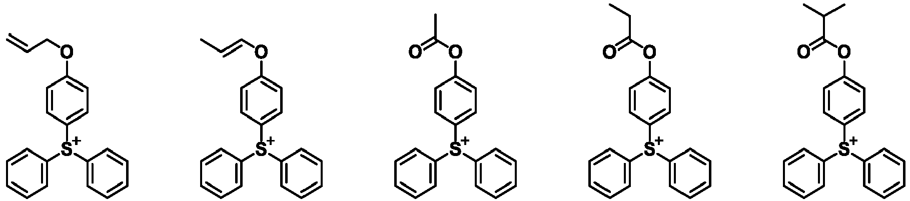

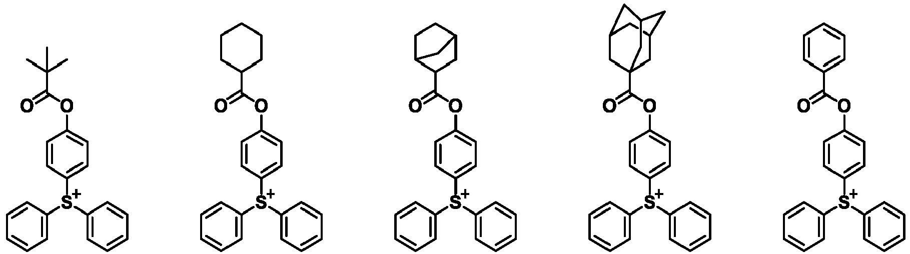

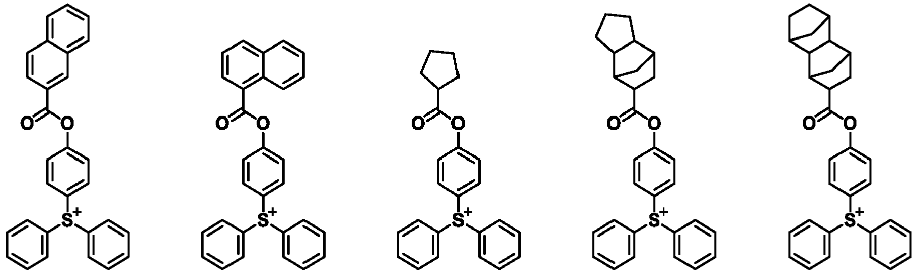

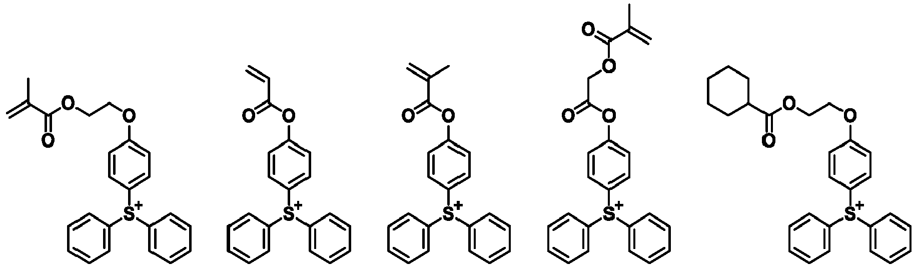

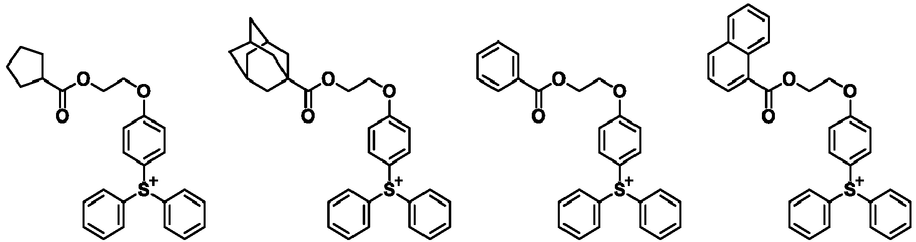

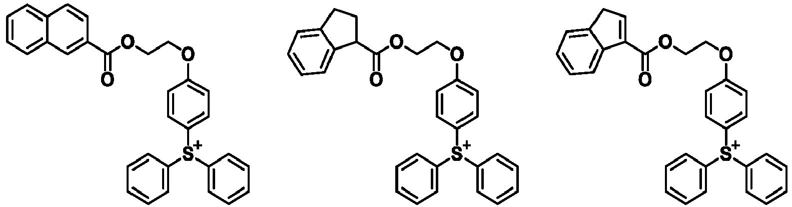

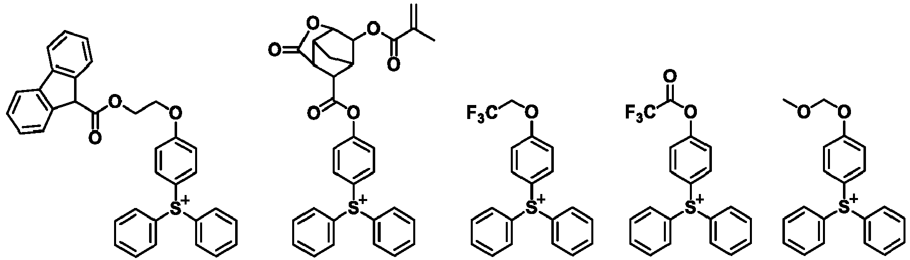

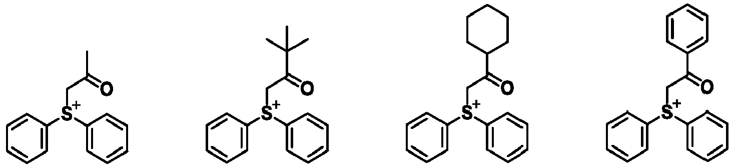

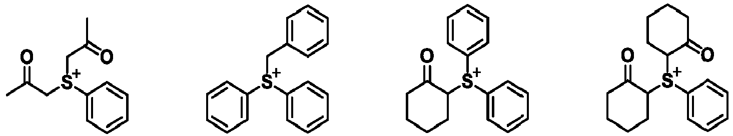

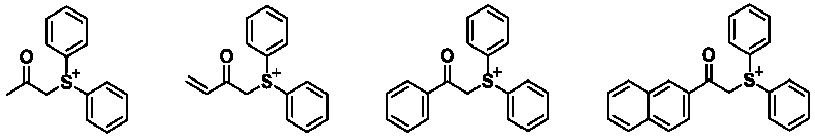

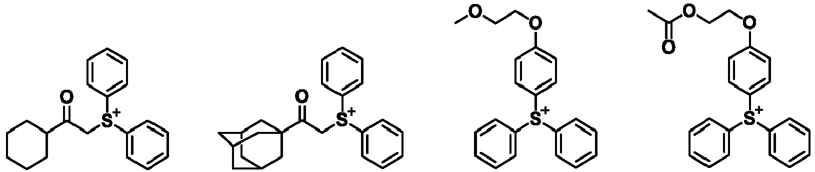

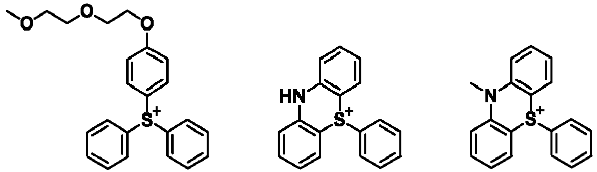

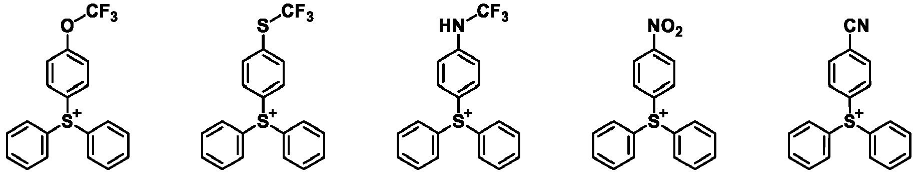

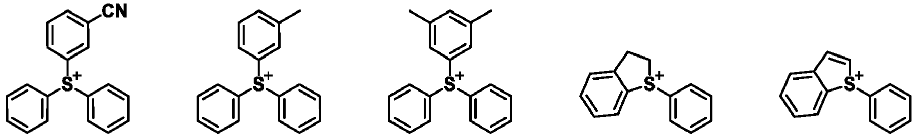

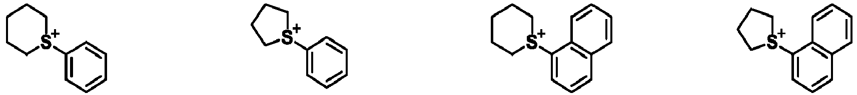

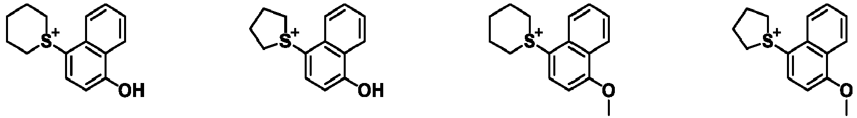

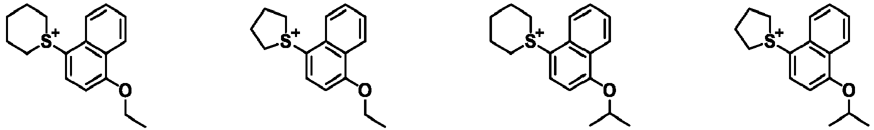

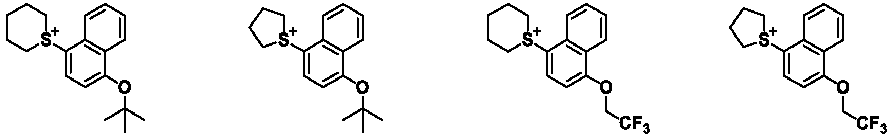

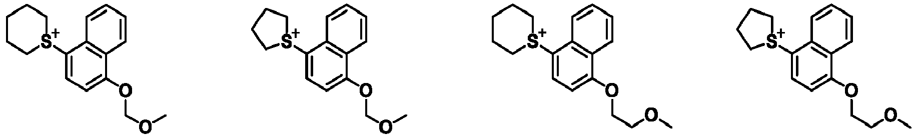

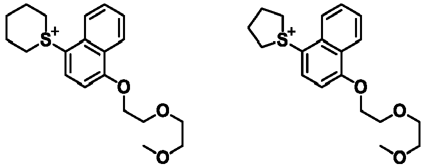

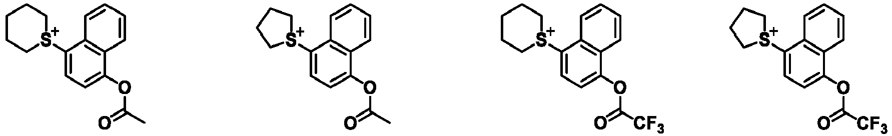

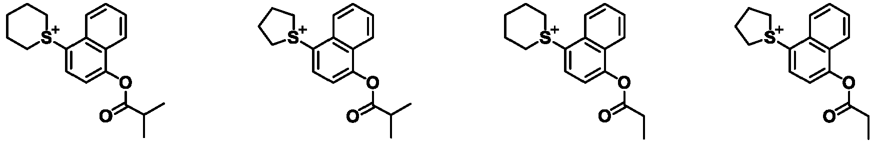

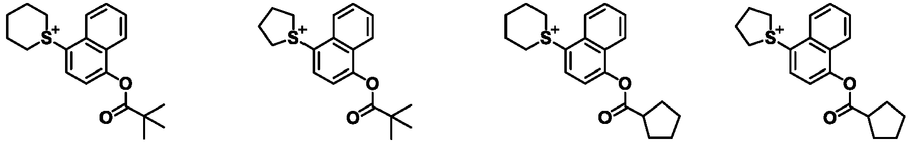

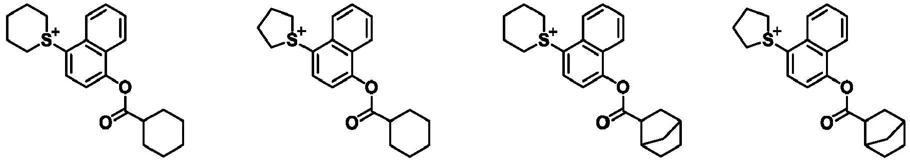

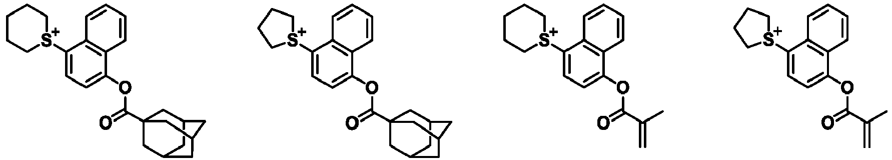

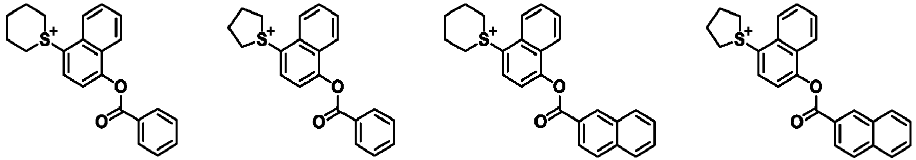

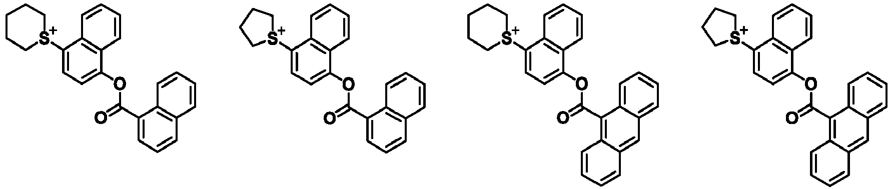

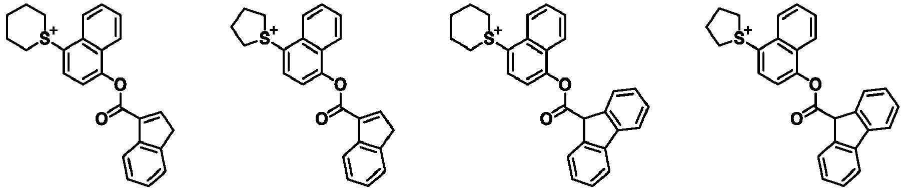

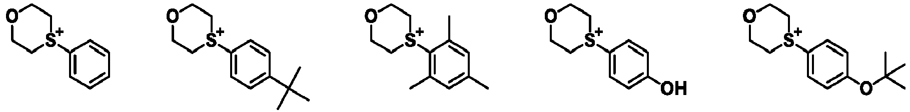

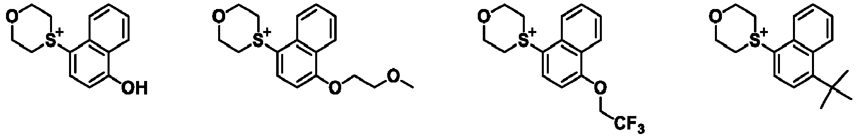

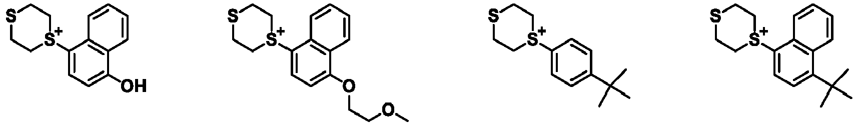

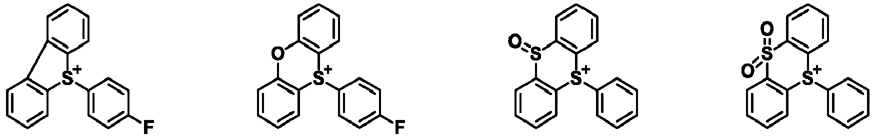

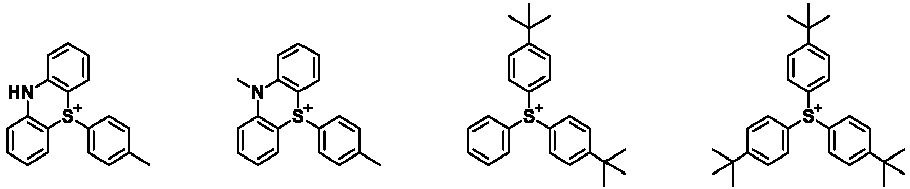

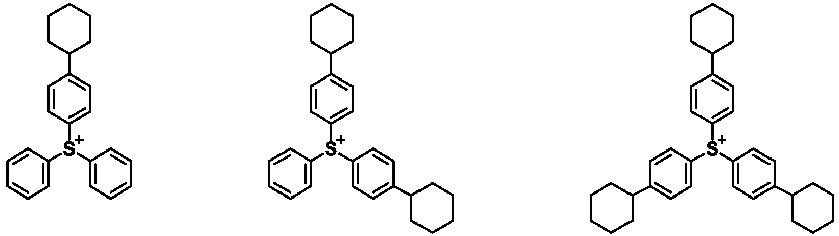

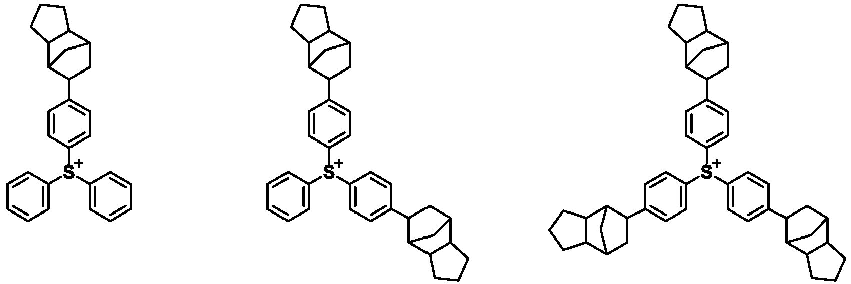

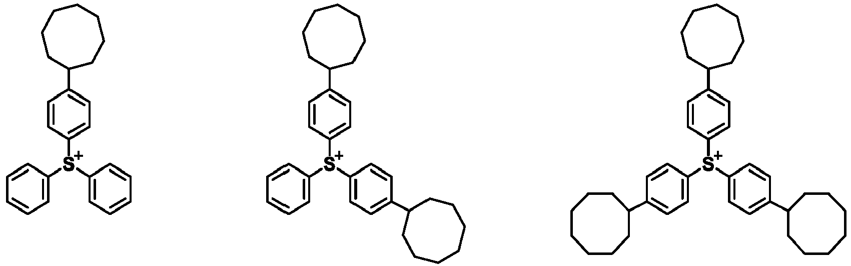

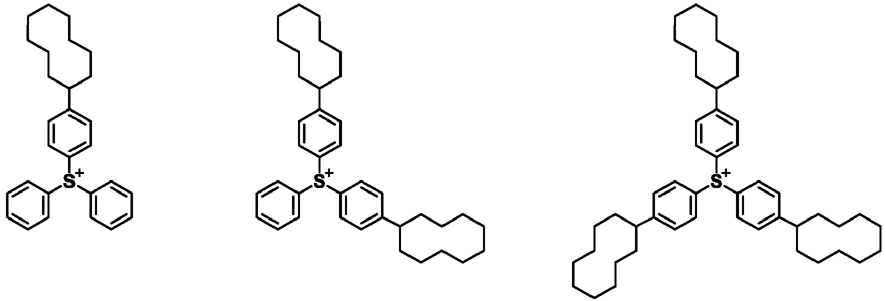

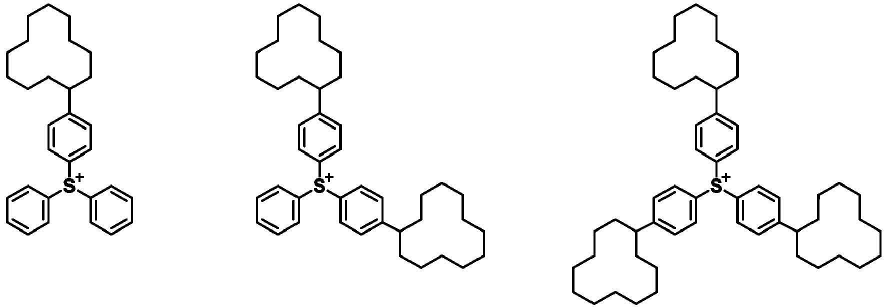

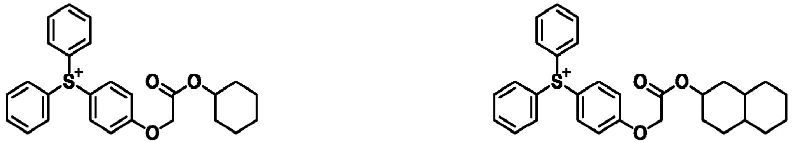

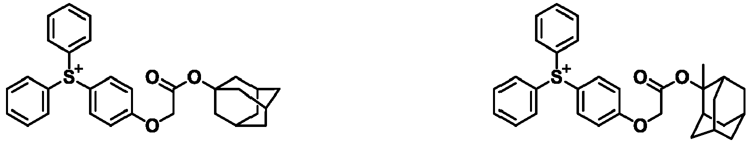

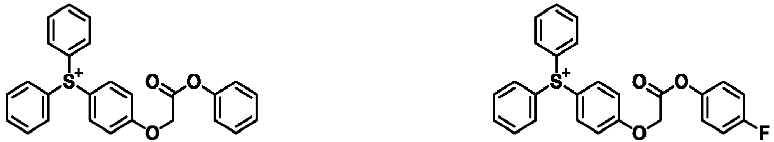

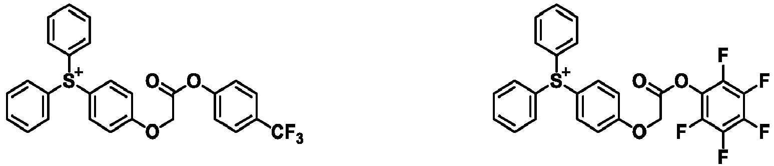

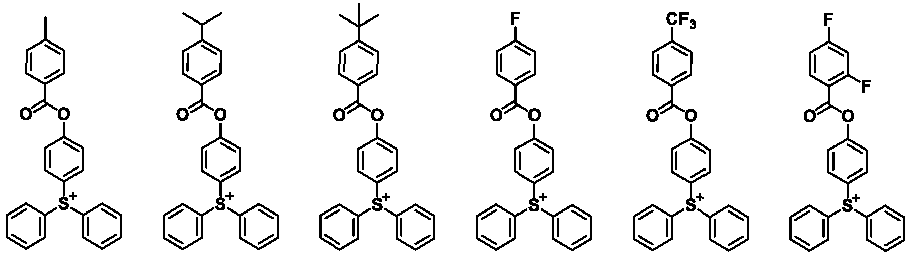

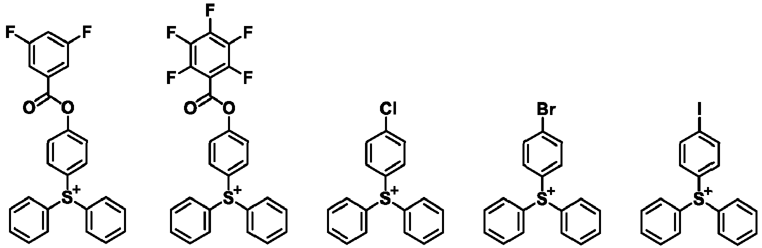

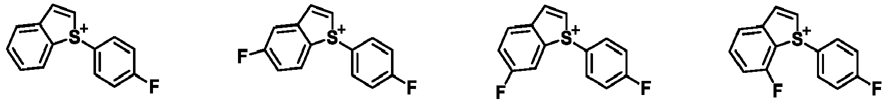

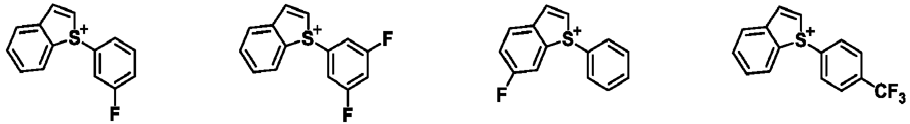

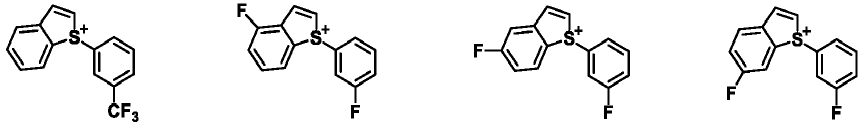

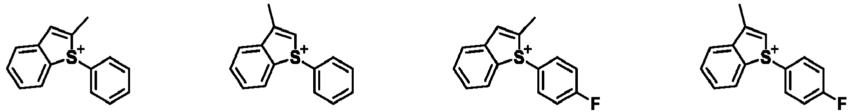

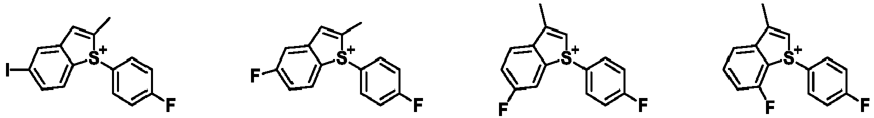

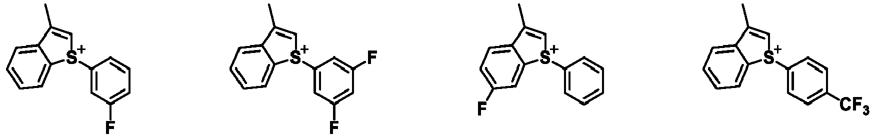

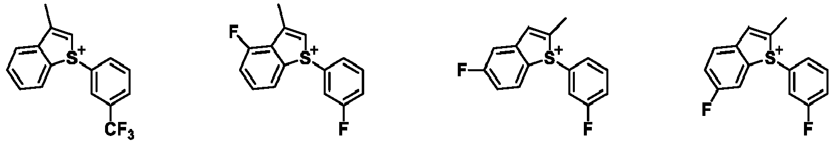

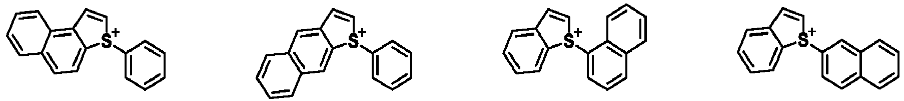

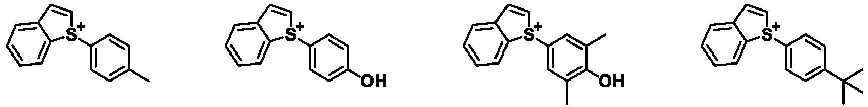

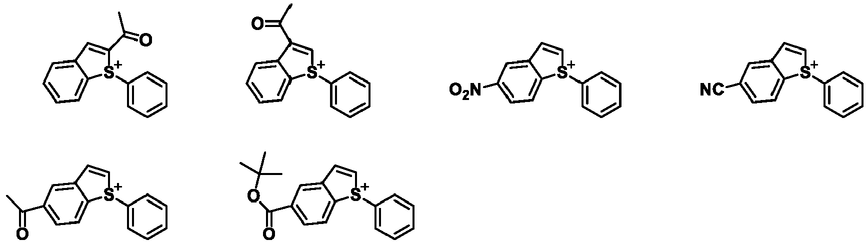

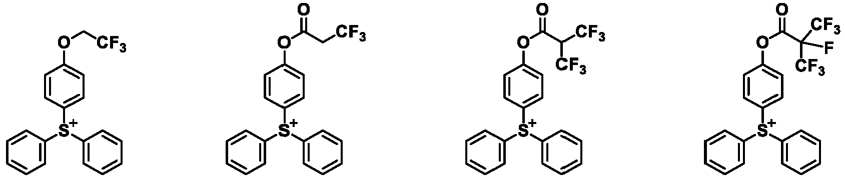

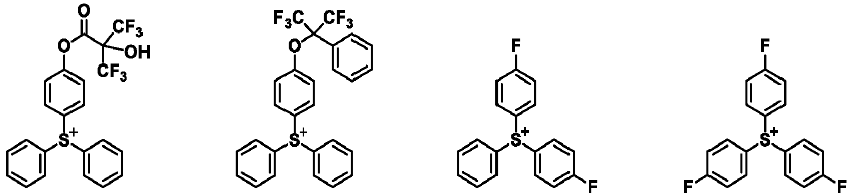

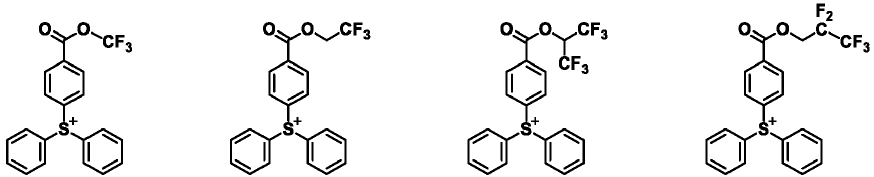

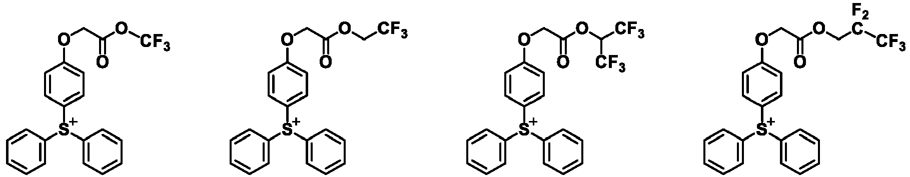

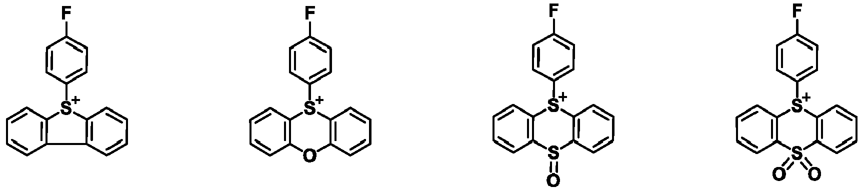

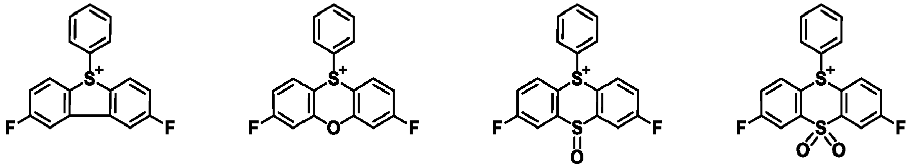

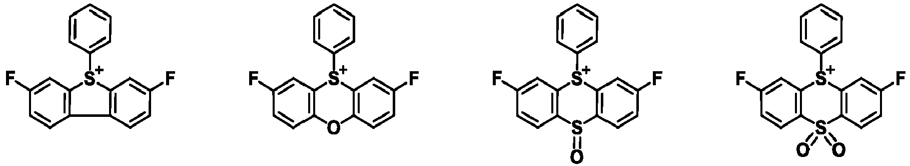

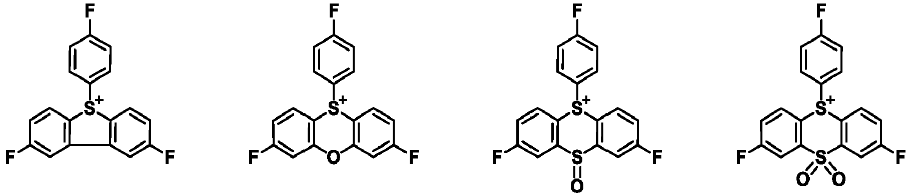

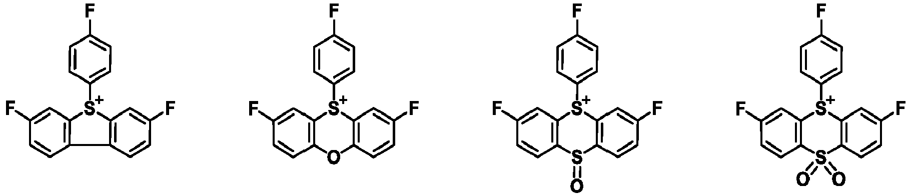

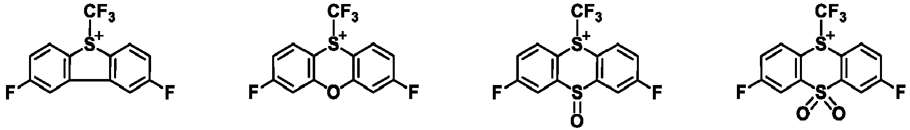

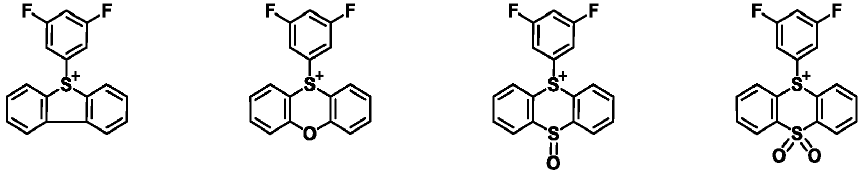

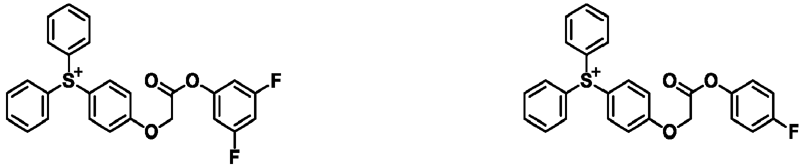

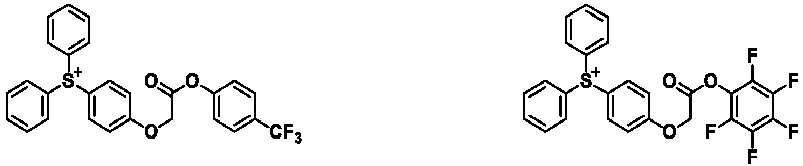

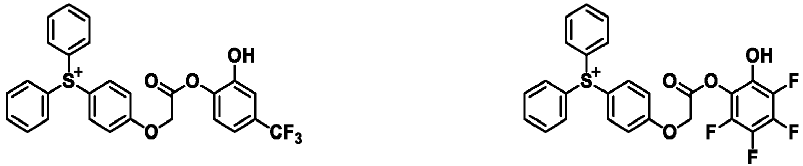

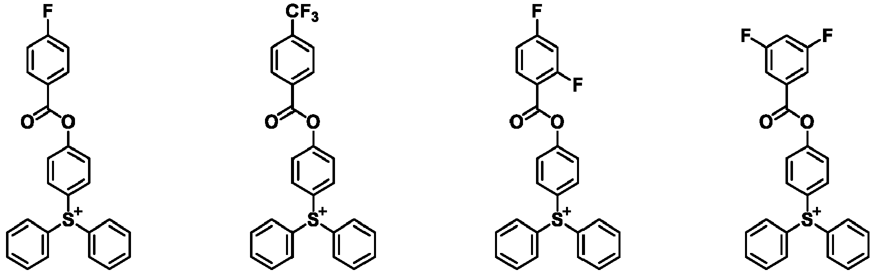

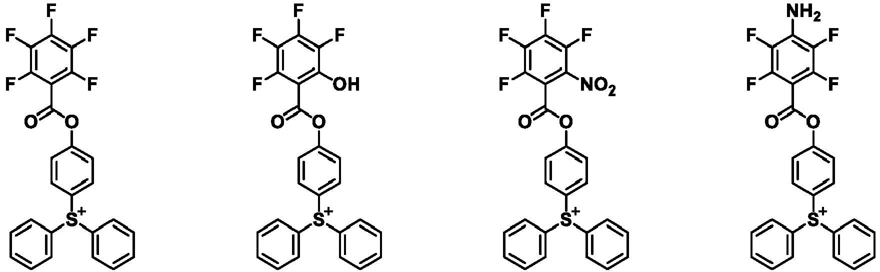

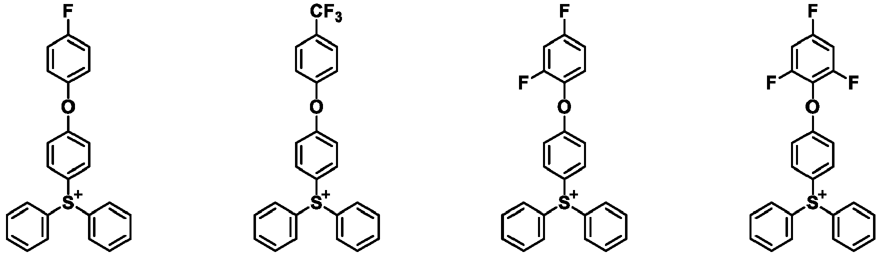

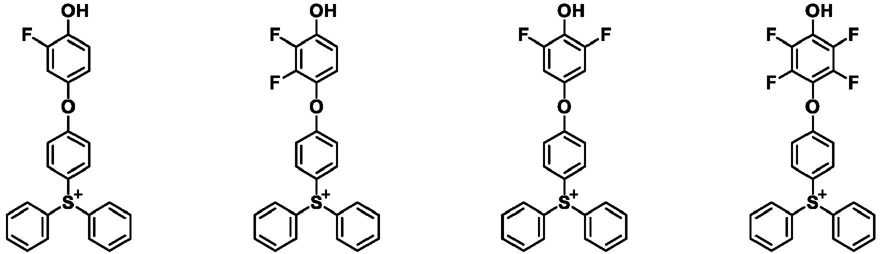

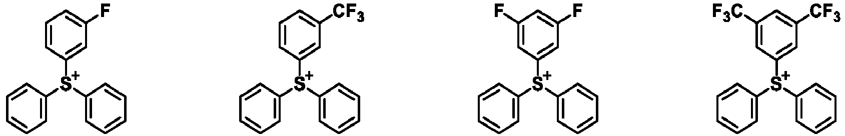

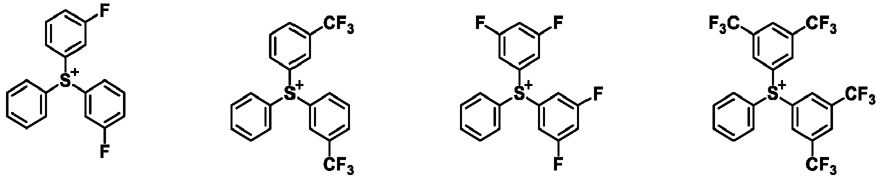

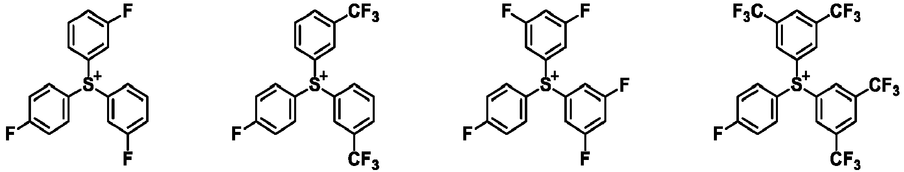

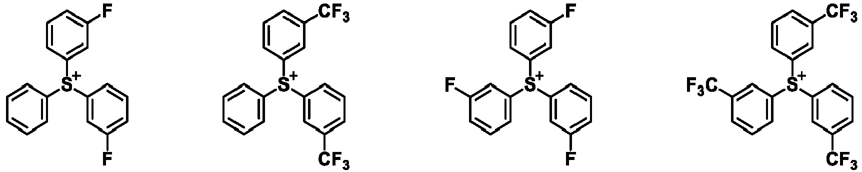

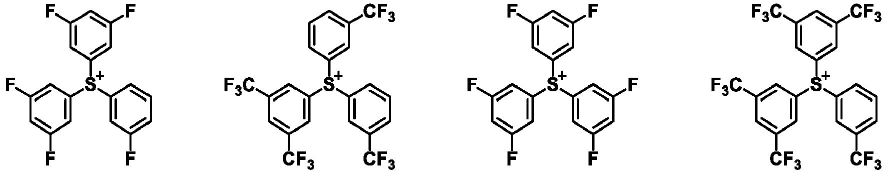

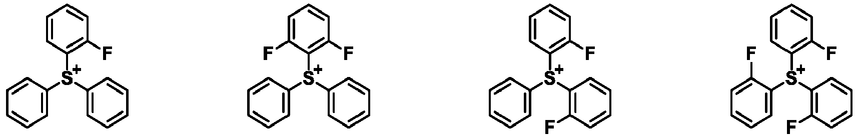

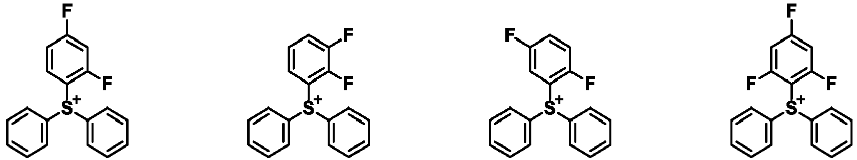

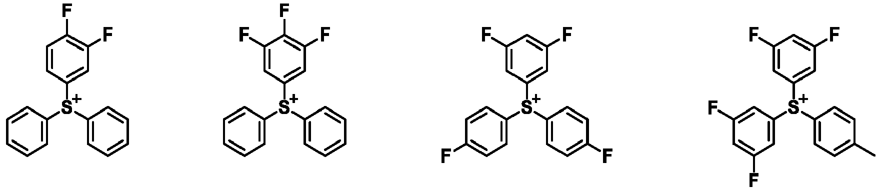

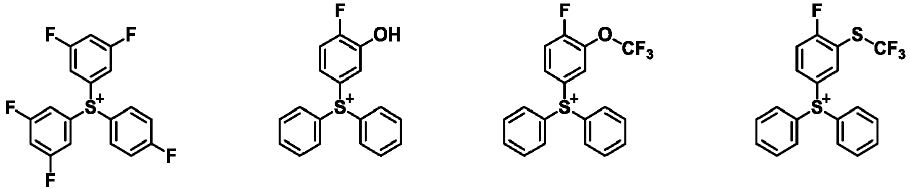

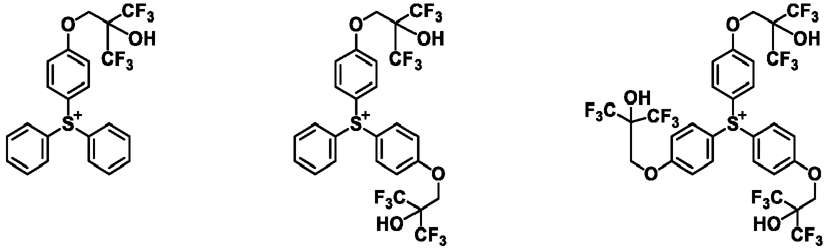

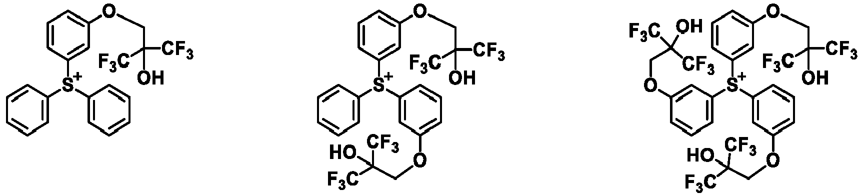

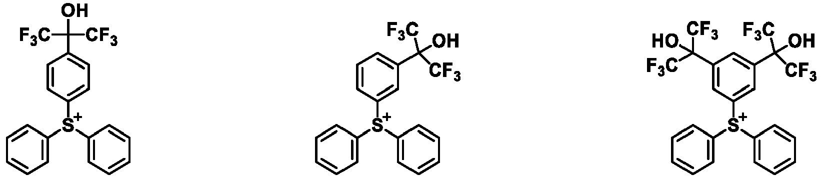

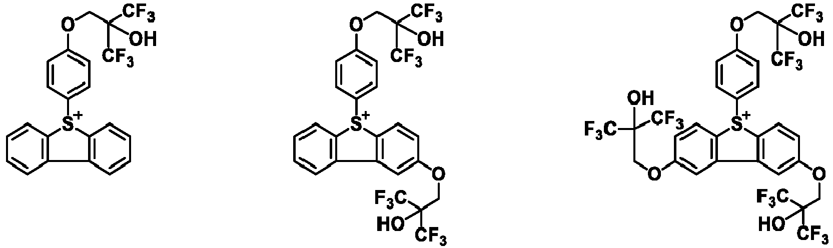

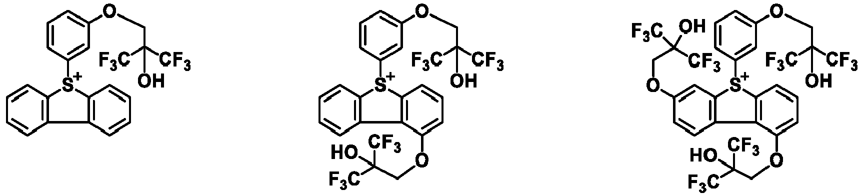

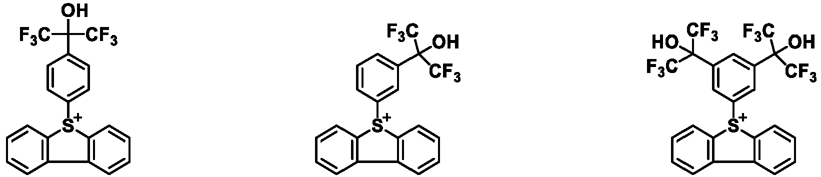

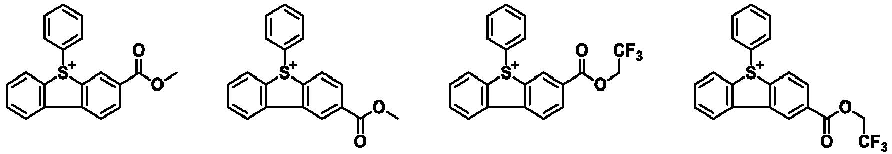

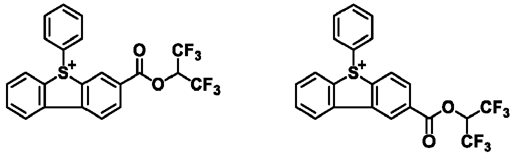

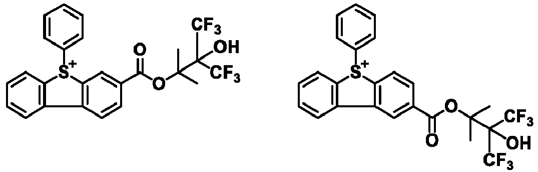

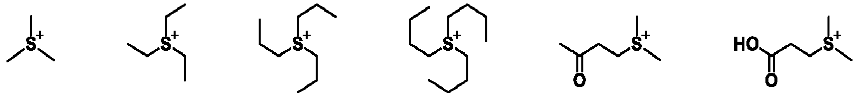

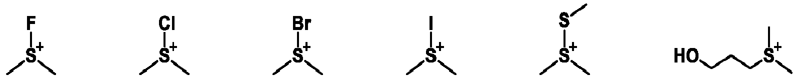

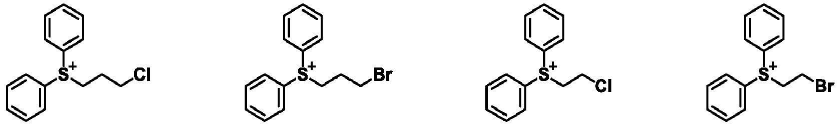

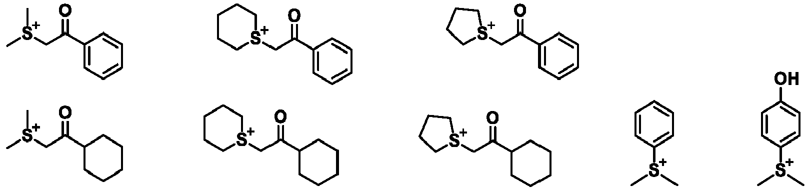

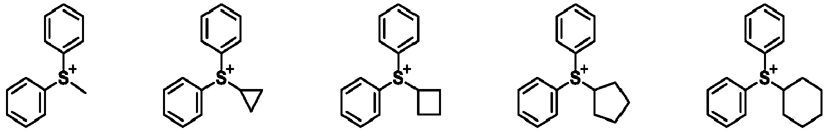

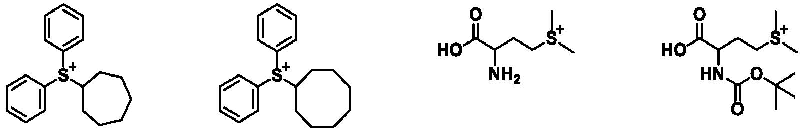

Examples of the iodonium cation having formula (cation-2) are shown below, but not limited thereto.

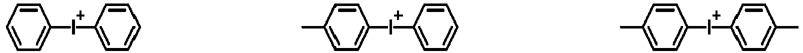

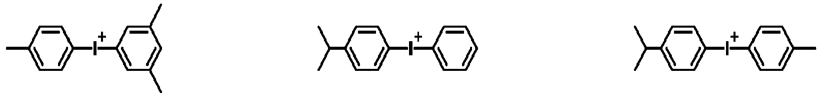

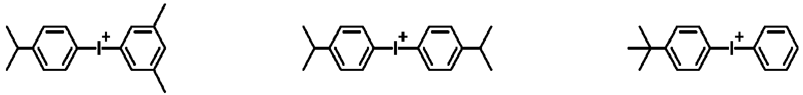

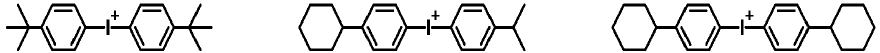

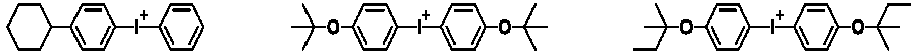

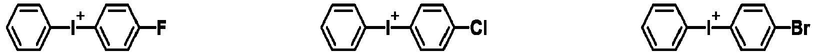

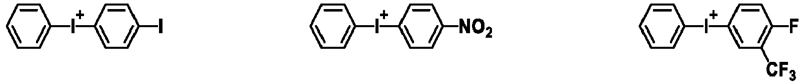

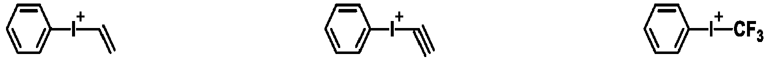

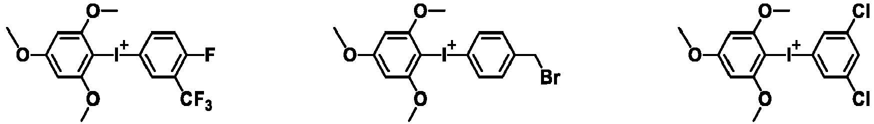

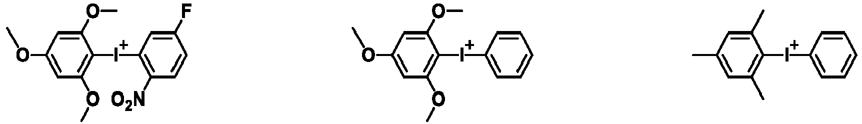

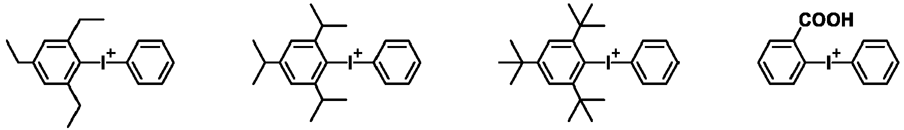

Examples of the ammonium cation having formula (cation-3) are shown below, but not limited thereto.

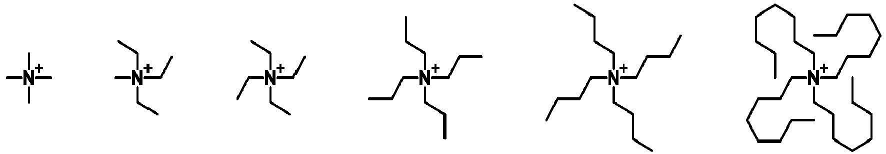

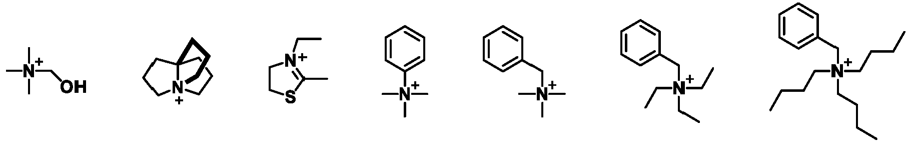

Specific structures of the inventive onium salt include arbitrary combinations of the anion with the cation, both as exemplified above.

The onium salt having formula (A) may be synthesized by any well-known method, for example, according to the following scheme. Reference is now made to the synthesis of an onium salt having the formula (Q-1-ex).

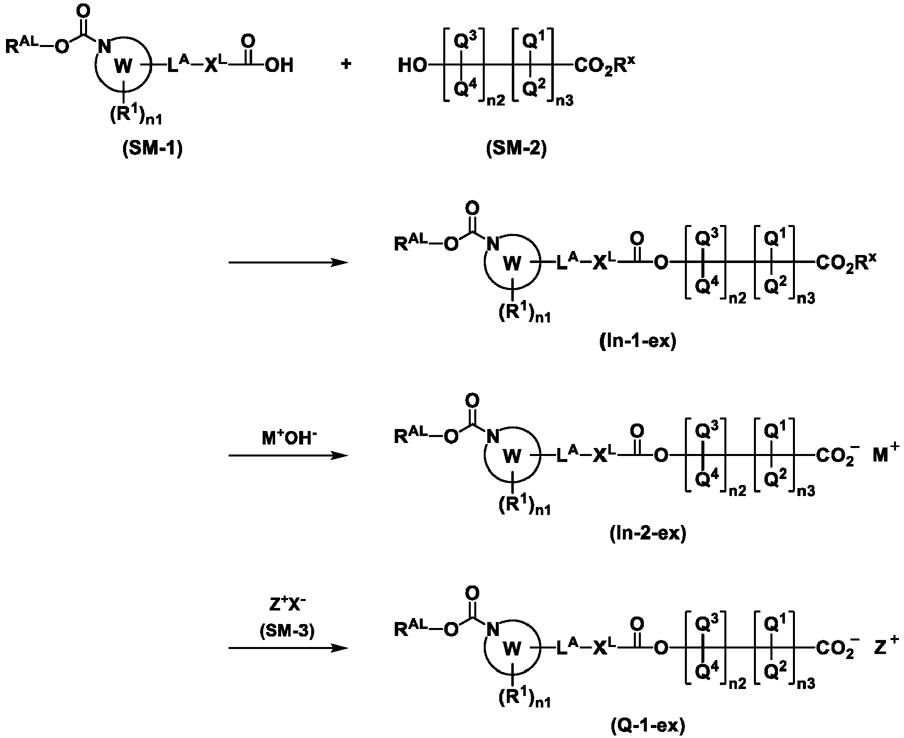

Herein, n1 to n3, W, L^{A}, X^{L}, R¹, Q¹ to Q⁴, R^{AL} and Z⁺ are as defined above. R^{X} is a group which forms a primary or secondary ester with the adjacent -CO₂-. M⁺ is a counter cation. X⁻ is a counter anion.

The first step is to react reactant SM-1 with reactant SM-2, which are commercially available or can be synthesized by the standard method, to form an intermediate In-1-ex. Any condensing agents may be used when an ester bond is formed directly from the carboxy group on reactant SM-1 and the hydroxy group on reactant SM-2. Examples of the condensing agent include N,N'-dicyclohexylcarbodiimide, N,N'-diisopropylcarbodiimide, 1-[3-(dimethylamino)propyl]-3-ethylcarbodiimide, and 1-ethyl-3-(3-dimethylaminopropyl)carbodiimide hydrochloride. From the standpoint of ease of removal of urea compounds formed as by-products after reaction, it is desirable to use 1-ethyl-3-(3-dimethylaminopropyl)carbodiimide hydrochloride. The reaction is carried out by dissolving reactants SM-1 and SM-2 in a halogenated solvent such as methylene chloride and adding a condensing agent. The reaction rate can be increased by adding 4-dimethylaminopyridine as a catalyst. While it is desirable in view of yield to monitor the reaction by silica gel thin layer chromatography (TLC) until the reaction is complete, the reaction time is typically about 12 to 24 hours. After the reaction is terminated, urea compounds formed by side reactions are removed by filtration or water-washing if necessary. The reaction solution is subjected to standard aqueous work-up, obtaining Intermediate In-1-ex. If necessary, the intermediate is purified by a standard technique such as distillation, chromatography or recrystallization.

The second step is alkaline hydrolysis of Intermediate In-1-ex to Intermediate In-2-ex. Specifically, the carboxylic ester in Intermediate In-1-ex is subjected to alkaline hydrolysis using an alkali metal hydroxide salt or a hydroxide salt of organic cation, obtaining Intermediate In-2-ex or carboxylic acid salt. Examples of the alkali metal hydroxide salt used herein include lithium hydroxide, sodium hydroxide, and potassium hydroxide. Examples of the hydroxide salt of organic cation include tetramethylammonium hydroxide and benzyltrimethylammonium hydroxide. The reaction is carried out by dissolving Intermediate In-1-ex in an ether solvent such as tetrahydrofuran or 1,4-dioxane and adding an aqueous solution of the hydroxide salt. While it is desirable in view of yield to monitor the reaction by TLC until the reaction is complete, the reaction time is typically about 12 to 24 hours. The reaction mixture is subjected to standard aqueous work-up, obtaining Intermediate In-2-ex. If necessary, the intermediate is purified by a standard technique such as chromatography or recrystallization.

The third step is a salt exchange between Intermediate In-2-ex and an onium salt: Z⁺X⁻ to synthesize an onium salt Q-1-ex. X⁻ is preferably a chloride ion, bromide ion, iodide ion or methylsulfate anion because the exchange reaction readily takes place in a quantitative way. It is desirable in view of yield to monitor the reaction process by TLC. The reaction mixture is subjected to standard aqueous work-up, obtaining an onium salt Q-1-ex. If necessary, the onium salt is purified by a standard technique such as chromatography or recrystallization.

In the above-illustrated scheme, the third step of ion exchange may be readily carried out by any well-known procedure, for example, with reference to JP-A 2007-145797.

It is noted that the preparation method according to the above scheme is merely exemplary and the method of preparing the inventive onium salt is not limited thereto.

The onium salt having a nitrogen-containing aliphatic heterocycle and fluorocarboxylic acid structure in the anion, represented by formula (A), functions as a quencher. That is, the fluorocarboxylic acid anion site is effective for trapping the strong acid generated from the acid generator in exposed areas. The acid labile group with which the nitrogen-containing aliphatic heterocycle site is protected undergoes deprotection reaction under the action of the strong acid, whereupon a nitrogen-containing aliphatic heterocyclic compound which is highly basic is formed. The highly basic nitrogen-containing aliphatic heterocycle site restrains excessive diffusion of acid to unexposed areas while the carboxylic acid anion site continuously repeats proton exchange with the strong acid. Due to the synergy of these effects, the dissolution contrast between exposed and unexposed areas is enhanced, and the diffusion of strong acid is adequately controlled. Thus satisfactory lithographic performance is achievable in the formation of small-size patterns. The fluorocarboxylic acid structure and the acid labile group with which the nitrogen-containing aliphatic heterocycle site is protected have an adequate number of carbon atoms, which leads to an improvement in organic solvent solubility. This effectively restrains the penetration of an alkaline developer into a resist film in exposed areas and hence, the chipping or top-loss of resist patterns. The onium salt quite effectively functions as a quencher when applied to chemically amplified negative resist compositions.

In the resist composition, the quencher (A) is preferably used in an amount of 0.1 to 100 parts by weight, more preferably 1 to 50 parts by weight, even more preferably 1 to 20 parts by weight, most preferably 1 to 15 parts by weight per 80 parts by weight of the base polymer (B) described below. An amount of the quencher in the range ensures a satisfactory quenching function, eliminating the risk of lowering sensitivity or leaving foreign particles due to shortage of solubility. The quencher may be used alone or in admixture of two or more.

### (B) Base polymer

The chemically amplified negative resist composition also comprises (B) a base polymer. The base polymer contains a polymer comprising repeat units having the formula (B 1). Notably, the polymer and unit having formula (B 1) are also referred to as polymer B and unit B1, hereinafter. The repeat units B1 provide for etching resistance, adhesion to the substrate, and solubility in alkaline developer.

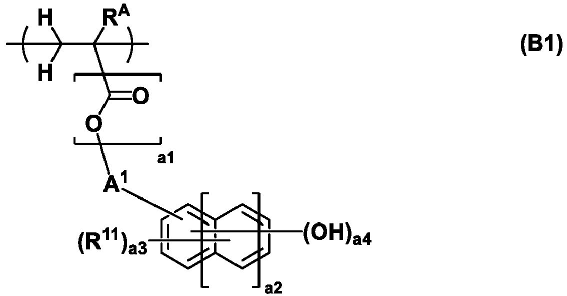

In formula (B1), a1 is 0 or 1. The subscript a2 is an integer of 0 to 2. The structure represents a benzene skeleton when a2=0, a naphthalene skeleton when a2=1, and an anthracene skeleton when a2=2. The subscript a3 is an integer satisfying 0 ≤ a3 ≤ 5+2(a2)-a4, and a4 is an integer of 1 to 3. In case of a2=0, preferably a3 is an integer of 0 to 3, and a4 is an integer of 1 to 3. In case of a2=1 or 2, preferably a3 is an integer of 0 to 4, and a4 is an integer of 1 to 3.

In formula (B1), R^{A} is hydrogen, fluorine, methyl or trifluoromethyl.

In formula (B1), R¹¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group. The saturated hydrocarbyl group and saturated hydrocarbyl moiety in the saturated hydrocarbyloxy group and saturated hydrocarbylcarbonyloxy group may be straight, branched or cyclic, and examples thereof include alkyl groups such as methyl, ethyl, n-propyl, isopropyl, butyl, pentyl, hexyl, and structural isomers thereof, cycloalkyl groups such as cyclopropyl, cyclobutyl, cyclopentyl and cyclohexyl, and combinations thereof. A carbon count within the upper limit ensures good solubility in alkaline developer. A plurality of R¹¹ may be identical or different when a3 is 2 or more.

In formula (B1), A¹ is a single bond or C₁-C₁₀ saturated hydrocarbylene group in which some constituent -CH₂- may be replaced by -O-. The saturated hydrocarbylene group may be straight, branched or cyclic and examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case of a 1 = 1 in formula (B1), the ether bond may be incorporated at any position excluding the position between the α-carbon and β-carbon relative to the ester oxygen. In case of a1=0, the atom that bonds with the main chain becomes an ethereal oxygen, and a second ether bond may be incorporated at any position excluding the position between the α-carbon and β-carbon relative to that ethereal oxygen. Saturated hydrocarbylene groups having no more than 10 carbon atoms are desirable because of a sufficient solubility in alkaline developer.

Preferred examples of the repeat units B1 wherein a1=0 and A¹ is a single bond (meaning that the aromatic ring is directly bonded to the main chain of the polymer), that is, repeat units free of a linker: -C(=O)-O-A¹- include units derived from 3-hydroxystyrene, 4-hydroxystyrene, 5-hydroxy-2-vinylnaphthalene, and 6-hydroxy-2-vinylnaphthalene. Repeat units having the formula (B 1-1) are especially preferred. 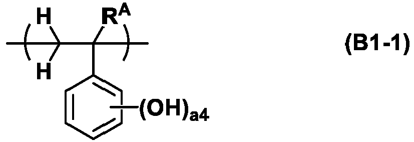 Herein R^{A} and a4 are as defined above.

Preferred examples of the repeat units B1 wherein a1=1, that is, having a linker: -C(=O)-O-A¹- are shown below, but not limited thereto. Herein R^{A} is as defined above.

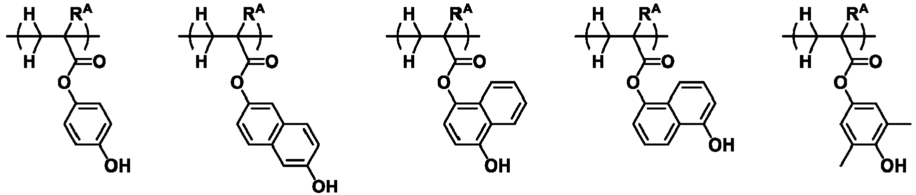

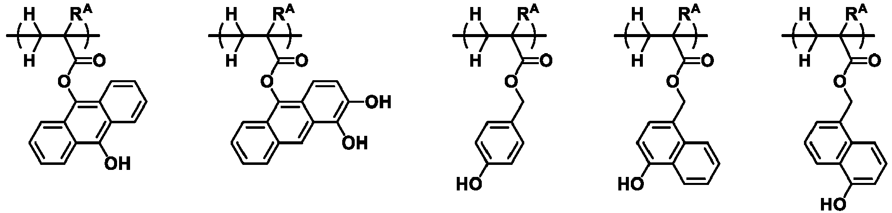

The repeat units B 1 may be used alone or in admixture of two or more.

In a preferred embodiment, the polymer B further contains repeat units having the formula (B2), referred to as repeat units B2. The polymer B further containing repeat units B2 is referred to as polymer B', hereinafter.

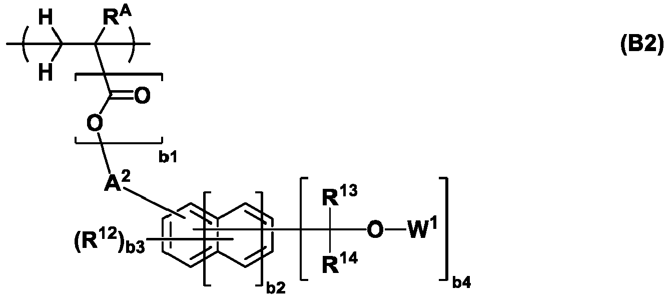

Upon exposure to high-energy radiation, repeat units B2 are such that -O-W¹ undergoes elimination reaction under the action of an acid generated from an acid generator, turning the polymer insoluble in alkaline developer and inducing crosslinking reaction between polymer chains. The repeat units B2 are effective for efficiently driving forward negative-turning reaction and improving resolution performance.

In formula (B2), b 1 is 0 or 1, b2 is an integer of 0 to 2, b3 is an integer meeting 0 ≤ b3 ≤ 5+2(b2)-b4, and b4 is an integer of 1 to 3.

In formula (B2), R^{A} is hydrogen, fluorine, methyl or trifluoromethyl.

In formula (B2), R¹² is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group. The saturated hydrocarbyl group and saturated hydrocarbyl moiety in the saturated hydrocarbyloxy group and saturated hydrocarbylcarbonyloxy group may be straight, branched or cyclic, and examples thereof include alkyl groups such as methyl, ethyl, propyl, isopropyl, butyl, pentyl, hexyl, and structural isomers thereof, cycloalkyl groups such as cyclopropyl, cyclobutyl, cyclopentyl and cyclohexyl, and combinations thereof. A plurality of R¹² may be identical or different when b3 is 2 or more.

In formula (B2), R¹³ and R¹⁴ are each independently hydrogen, a C₁-C₁₅ saturated hydrocarbyl group which may be substituted with a hydroxy or saturated hydrocarbyloxy moiety, or an optionally substituted aryl group. Notably, R¹³ and R¹⁴ are not hydrogen at the same time. R¹³ and R¹⁴ may bond together to form a ring with the carbon atom to which they are attached. Preferred examples of R¹³ and R¹⁴ include alkyl groups such as methyl, ethyl, propyl, butyl and structural isomers thereof, and substituted forms of the foregoing in which some hydrogen is substituted by hydroxy or saturated hydrocarbyloxy moiety.

In formula (B2), A² is a single bond or a C₁-C₁₀ saturated hydrocarbylene group in which some constituent -CH₂- may be replaced by -O-. The saturated hydrocarbylene group may be straight, branched or cyclic and examples thereof include alkanediyl groups such as methylene, ethane-1,2-diyl, propane-1,3-diyl, butane-1,4-diyl, pentane-1,5-diyl, hexane-1,6-diyl, and structural isomers thereof; cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case of b 1=1 in formula (B2), the ether bond may be incorporated at any position excluding the position between the α-carbon and β-carbon relative to the ester oxygen. In case of b 1=0, the atom that bonds with the main chain becomes an ethereal oxygen, and a second ether bond may be incorporated at any position excluding the position between the α-carbon and β-carbon relative to that ethereal oxygen.

In formula (B2), W¹ is hydrogen, a C₁-C₁₀ aliphatic hydrocarbyl group or an optionally substituted aryl group. The aliphatic hydrocarbyl group may be straight, branched or cyclic and examples thereof include alkyl groups such as methyl, ethyl, propyl, and isopropyl, and cyclic aliphatic hydrocarbyl groups such as cyclopentyl, cyclohexyl and adamantyl. Typical of the aryl group is phenyl. In the aliphatic hydrocarbyl group, some constituent -CH₂- may be replaced by -O-, -C(=O)-, -O-C(=O)- or -C(=O)-O-. It is noted that -CH₂- in the hydrocarbyl group may bond to the oxygen atom in formula (B2). Typical of the substituted hydrocarbyl group is methylcarbonyl.

The preferred repeat units B2 include units having the formulae (B2-1) and (B2-2). 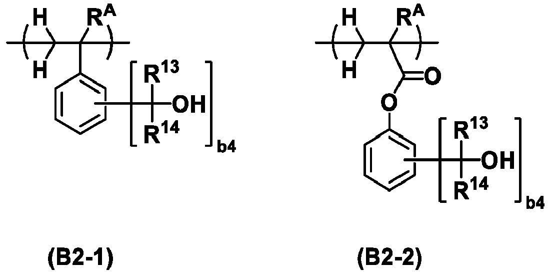 Herein, b4, R^{A}, R¹³ and R¹⁴ are as defined above.

Preferred examples of repeat unit B2 are shown below, but not limited thereto. R^{A} is as defined above.

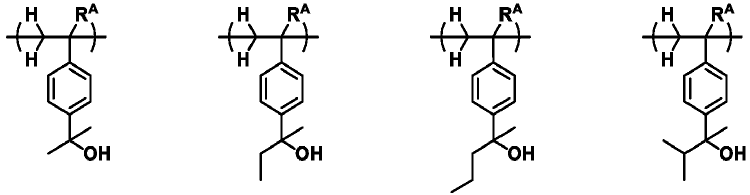

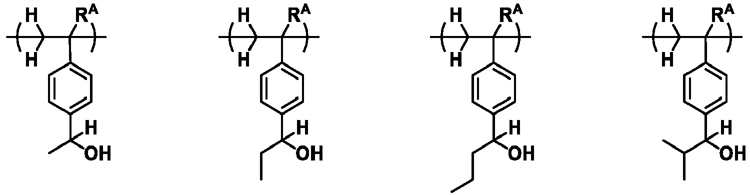

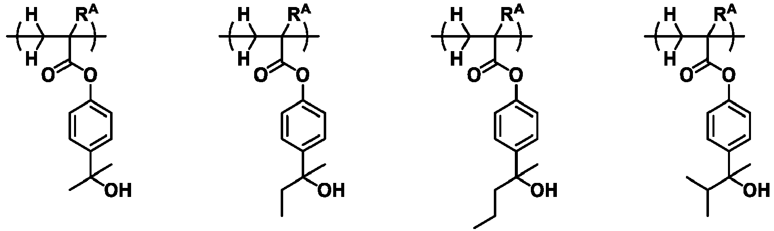

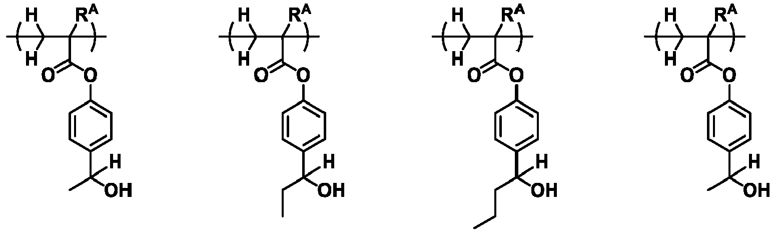

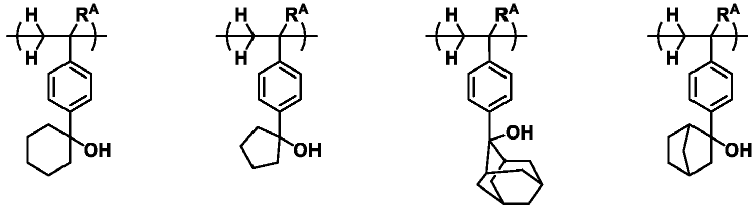

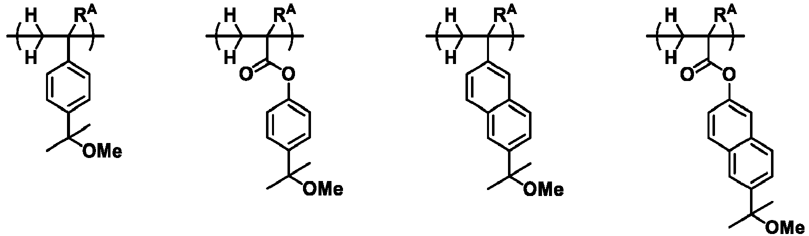

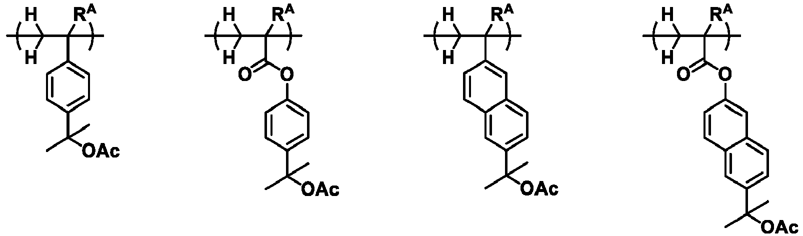

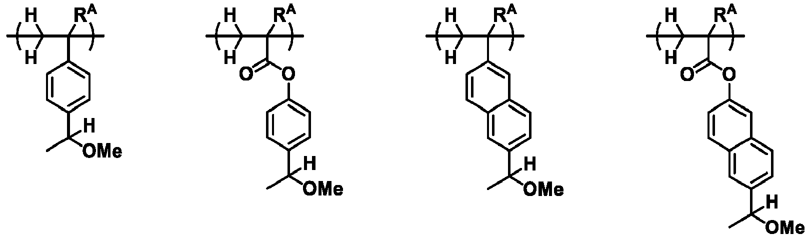

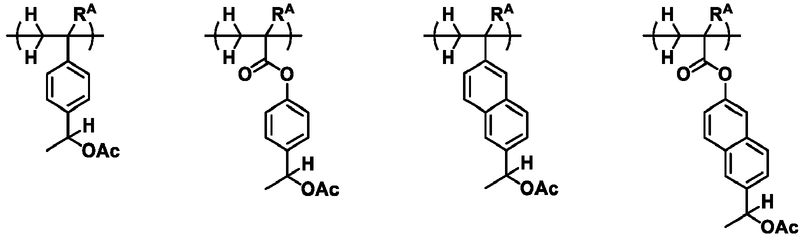

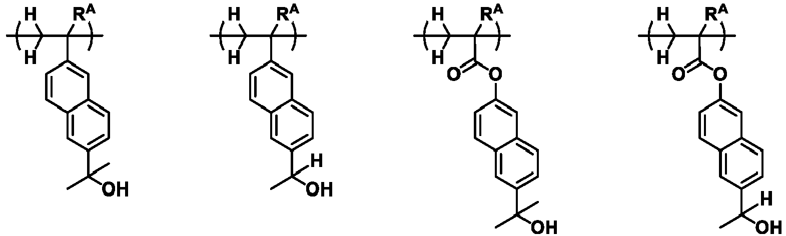

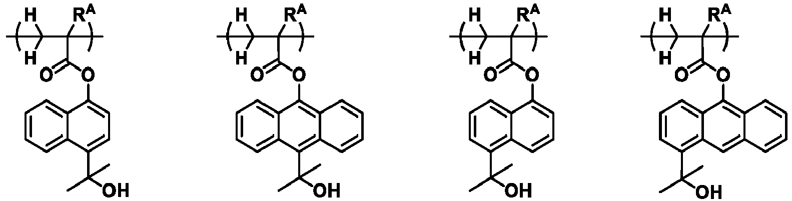

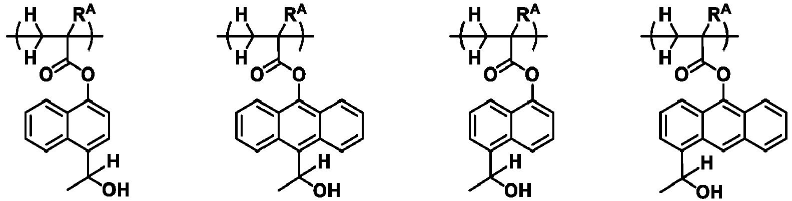

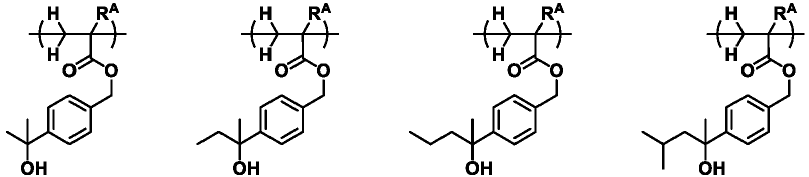

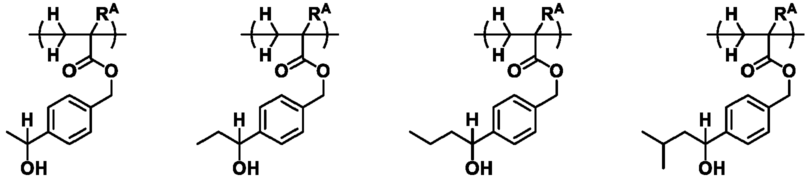

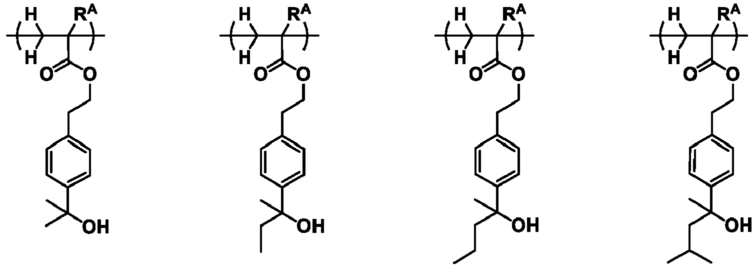

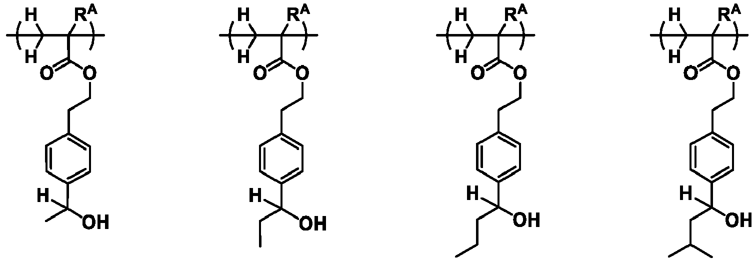

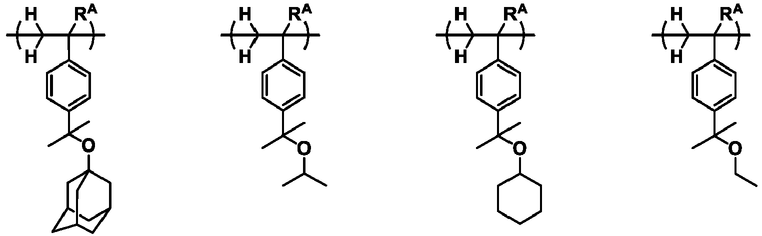

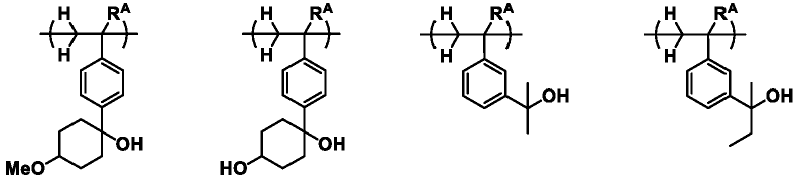

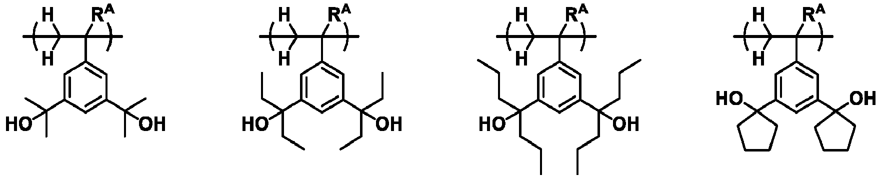

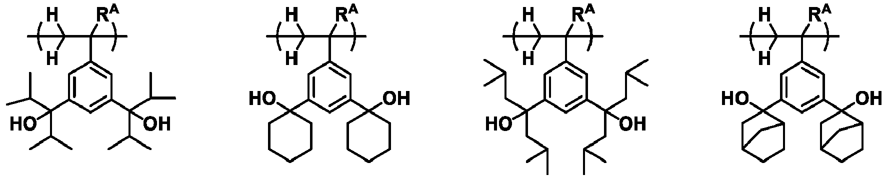

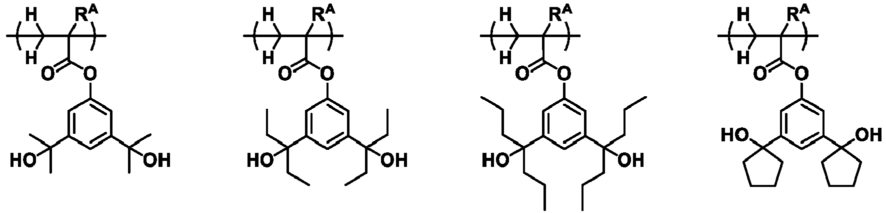

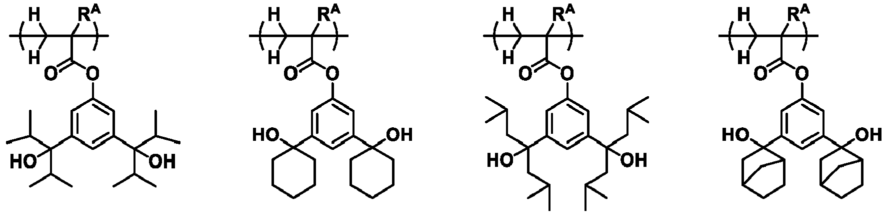

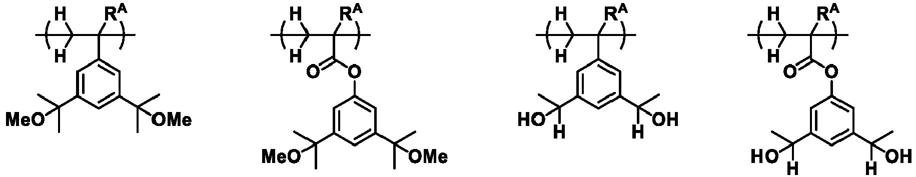

The repeat units B2 may be used alone or in admixture of two or more.

In a preferred embodiment, the polymer B or B' further comprises repeat units of at least one type selected from units having the formulae (B3), (B4) and (B5) for the purpose of enhancing etch resistance. These repeat units are simply referred to as repeat units B3, B4 and B5, respectively.

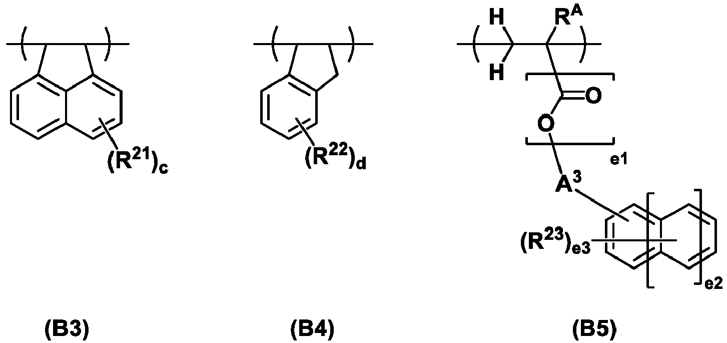

In formulae (B3) and (B4), c and d are each independently an integer of 0 to 4.

In formulae (B3) and (B4), R²¹ and R²² are each independently hydroxy, halogen, an optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group. The saturated hydrocarbyl group, saturated hydrocarbyloxy group and saturated hydrocarbylcarbonyloxy group may be straight, branched or cyclic. When c is 2 or more, a plurality of groups R²¹ may be identical or different. When d is 2 or more, a plurality of groups R²² may be identical or different.

In formula (B5), e1 is 0 or 1. The subscript e2 is an integer of 0 to 2, and the corresponding structure represents a benzene skeleton when e2=0, a naphthalene skeleton when e2=1, and an anthracene skeleton when e2=2. The subscript e3 is an integer of 0 to 5. In case of e2=0, preferably e3 is an integer of 0 to 3. In case of e2=1 or 2, preferably e3 is an integer of 0 to 4.

In formula (B5), R^{A} is hydrogen, fluorine, methyl or trifluoromethyl.

In formula (B5), R²³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen atom, nitro group, cyano group, C₁-C₂₀ saturated hydrocarbylsulfinyl group, or C₁-C₂₀ saturated hydrocarbylsulfonyl group. The saturated hydrocarbyl group, saturated hydrocarbyloxy group, saturated hydrocarbylcarbonyloxy group, saturated hydrocarbyloxyhydrocarbyl group, saturated hydrocarbylthiohydrocarbyl group, saturated hydrocarbylsulfinyl group and saturated hydrocarbylsulfonyl group may be straight, branched or cyclic. When e3 is 2 or more, a plurality of groups R²³ may be identical or different.

R²³ is preferably selected from halogen atoms such as fluorine, chlorine, bromine and iodine; saturated hydrocarbyl groups such as methyl, ethyl, propyl, butyl, pentyl, hexyl, cyclopentyl, cyclohexyl, and structural isomers thereof; and saturated hydrocarbyloxy groups such as methoxy, ethoxy, propoxy, butoxy, pentyloxy, hexyloxy, cyclopentyloxy, cyclohexyloxy, and structural isomers of their hydrocarbon moiety. Inter alia, methyl, ethyl, methoxy and ethoxy are useful.

The saturated hydrocarbylcarbonyloxy group may be readily introduced into a polymer even after polymerization, by a chemical modification method and is advantageously utilized for fine adjustment of the solubility of the polymer in alkaline developer. Examples of the saturated hydrocarbylcarbonyloxy group include methylcarbonyloxy, ethylcarbonyloxy, propylcarbonyloxy, butylcarbonyloxy, pentylcarbonyloxy, hexylcarbonyloxy, cyclopentylcarbonyloxy, cyclohexylcarbonyloxy, benzoyloxy, and structural isomers of their hydrocarbon moiety. As long as the carbon count is equal to or less than 20, an appropriate effect of controlling or adjusting (typically reducing) the solubility of the polymer in alkaline developer is obtainable, and the generation of scum or development defects may be suppressed.

Of the foregoing preferred substituent groups, such substituent groups as chlorine, bromine, iodine, methyl, ethyl and methoxy are useful because the corresponding monomers may be readily prepared.

In formula (B5), A³ is a single bond or C₁-C₁₀ saturated hydrocarbylene group in which some constituent -CH₂- may be replaced by -O-. The saturated hydrocarbylene group may be straight, branched or cyclic. Examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case of e1=1 in formula (B5), the ether bond may be incorporated at any position excluding the position between the α- and β-carbons relative to the ester oxygen. In case of e1=0, the atom bonding to the backbone becomes an ether oxygen atom, and a second ether bond may be incorporated at any position excluding the position between the α- and β-carbons relative to the ether oxygen. Saturated hydrocarbylene groups having no more than 10 carbon atoms are desirable because of a sufficient solubility in alkaline developer.

Preferred examples of the repeat units B5 wherein e1 is 0 and A³ is a single bond (meaning that the aromatic ring is directly bonded to the main chain of the polymer), that is, repeat units free of the linker: -C(=O)-O-A³- include units derived from styrene, 4-chlorostyrene, 4-bromostyrene, 4-methylstyrene, 4-methoxystyrene, 4-acetoxystyrene, 2-hydroxypropylstyrene, 2-vinylnaphthalene, and 3-vinylnaphthalene.

Preferred examples of the repeat units B5 wherein e1 is 1, that is, having the linker: -C(=O)-O-A³- are shown below, but not limited thereto. R^{A} is as defined above.

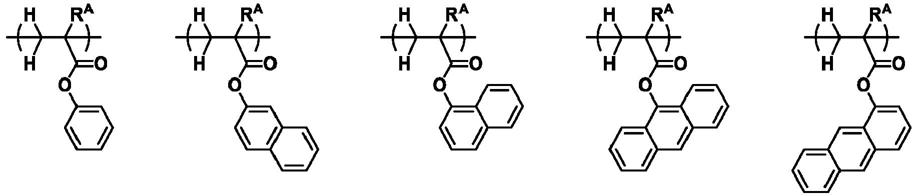

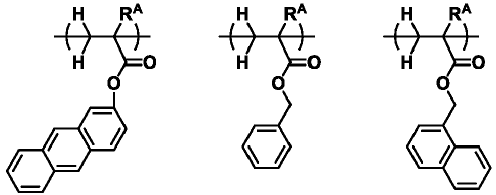

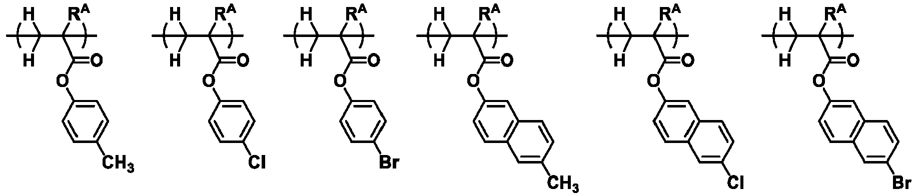

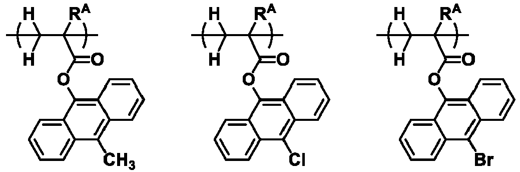

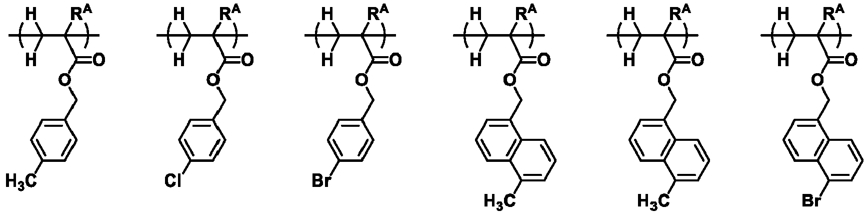

When repeat units of at least one type selected from repeat units B3 to B5 are incorporated, better performance is obtained because not only the aromatic ring possesses etch resistance, but the cyclic structure incorporated into the main chain also exerts the effect of improving etch resistance and resistance to EB irradiation during pattern inspection step.

The repeat units B3 to B5 may be used alone or in admixture of two or more.

In a preferred embodiment, the polymer B' further comprises repeat units of at least one type selected from repeat units having the formula (B6), repeat units having the formula (B7), repeat units having the formula (B8), repeat units having the formula (B9), repeat units having the formula (B10), repeat units having the formula (B11), repeat units having the formula (B12), and repeat units having the formula (B 13), shown below. Notably these repeat units are also referred to as repeat units B6 to B 13. The repeat units B6 to B13 are effective for suppressing acid diffusion and forming patterns with improved resolution and reduced LER.

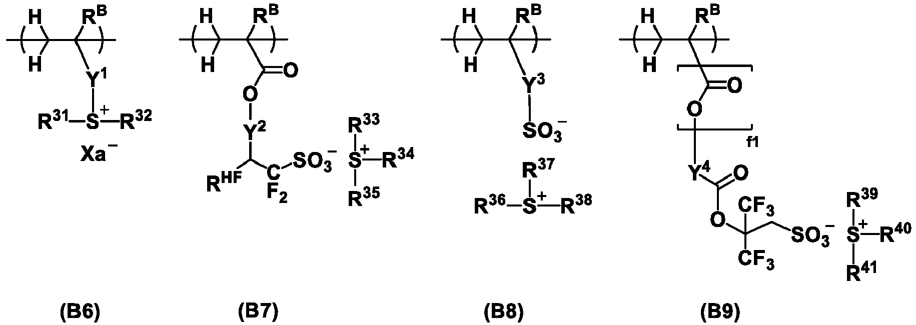

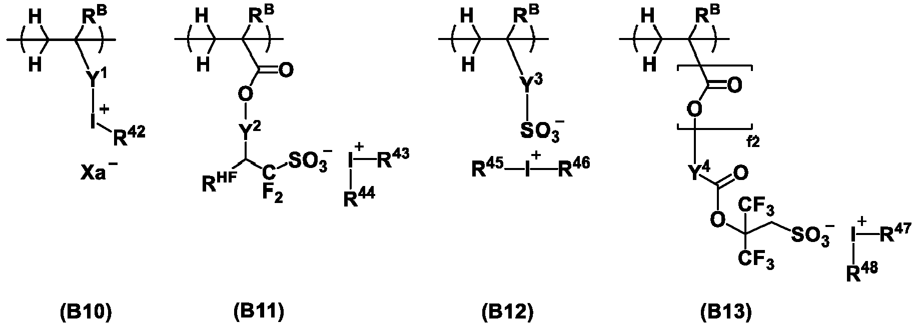

In formulae (B6) to (B13), R^{B} is each independently hydrogen or methyl. Y¹ is a single bond, a C₁-C₆ aliphatic hydrocarbylene group, phenylene group, naphthylene group, or C₇-C₁₈ group obtained by combining the foregoing, *-O-Y¹¹-, *-C(=O)-O-Y¹¹-, or *-C(=O)-NH-Y¹¹-, wherein Y¹¹ is a C₁-C₆ aliphatic hydrocarbylene group, phenylene group, naphthylene group, or C₇-C₁₈ group obtained by combining the foregoing, which may contain a carbonyl moiety, ester bond, ether bond or hydroxy moiety. Y² is a single bond or **-Y²¹-C(=O)-O-, wherein Y²¹ is a C₁-C₂₀ hydrocarbylene group which may contain a heteroatom. Y³ is a single bond, methylene, ethylene, phenylene, fluorinated phenylene, trifluoromethyl-substituted phenylene group, *-O-Y³¹-, *-C(=O)-O-Y³¹-, or *-C(=O)-NH-Y³¹-, wherein Y³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety. The asterisk (*) is a point of attachment to the carbon atom in the backbone and the double asterisk (**) is a point of attachment to the oxygen atom in the formula. Y⁴ is a single bond or a C₁-C₃₀ hydrocarbylene group which may contain a heteroatom. The subscripts f1 and f2 are each independently 0 or 1. When Y⁴ is a single bond, f1 and f2 are 0.

In formulae (B6) and (B10), Xa⁻ is a non-nucleophilic counter ion, examples of which include those described in JP-A 2010-113209 and JP-A 2007-145797.

In formulae (B7) and (B11) wherein Y² is -Y²¹-C(=O)-O-, Y²¹ is a C₁-C₂₀ hydrocarbylene group which may contain a heteroatom, examples of which are shown below, but not limited thereto.

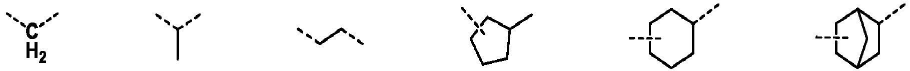

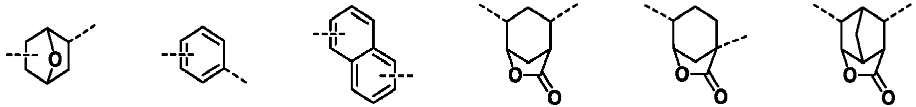

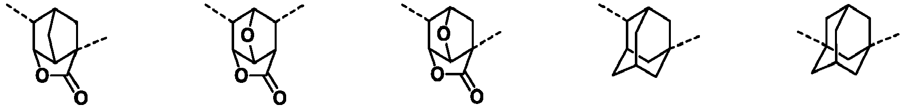

In formulae (B7) and (B11), R^{HF} is hydrogen or trifluoromethyl. Examples of the repeat units B7 and B11 wherein R^{HF} is hydrogen include those described in JP-A 2010-116550. Examples of the repeat units B7 and B11 wherein R^{HF} is trifluoromethyl include those described in JP-A 2010-077404. Examples of the repeat units B8 and B12 include those described in JP-A 2012-246265 and JP-A 2012-246426.

Preferred examples of the anion in the monomers from which repeat units B9 and B13 are derived are shown below, but not limited thereto.

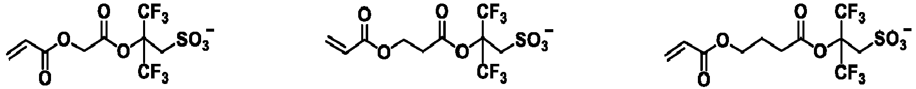

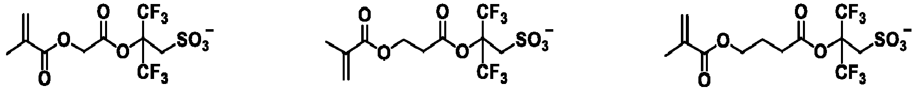

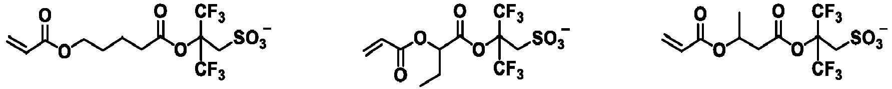

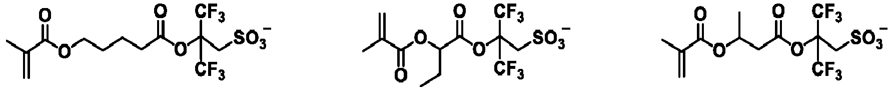

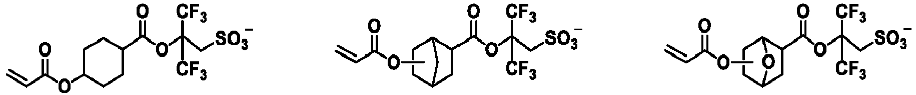

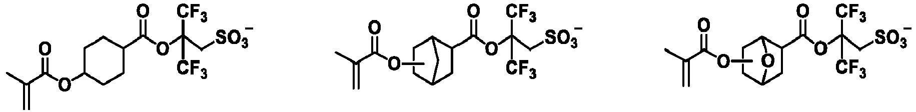

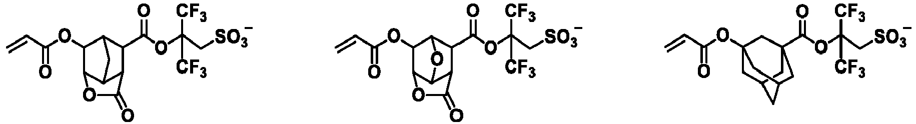

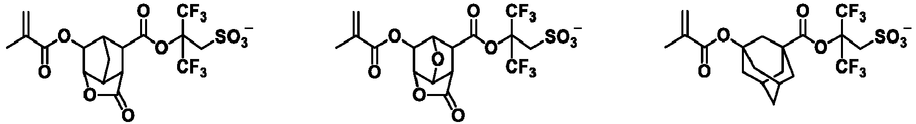

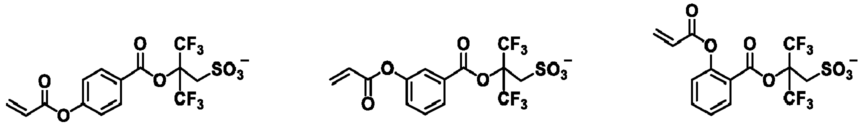

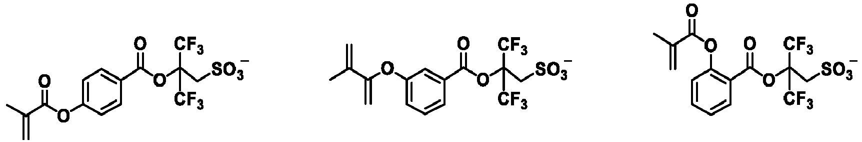

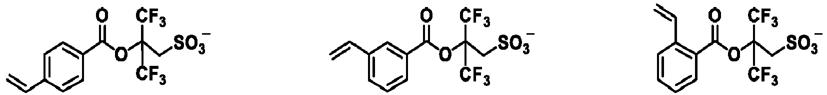

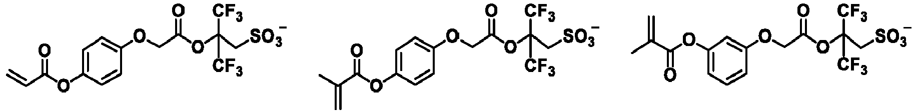

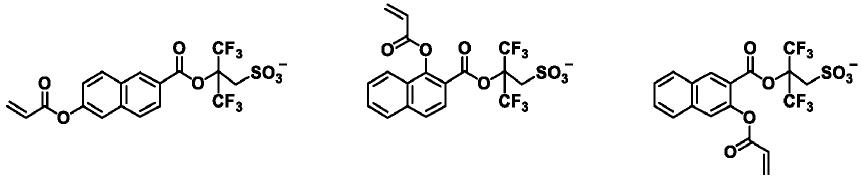

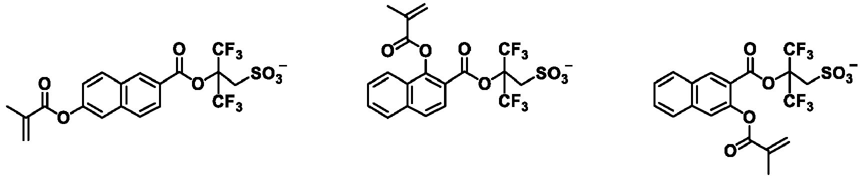

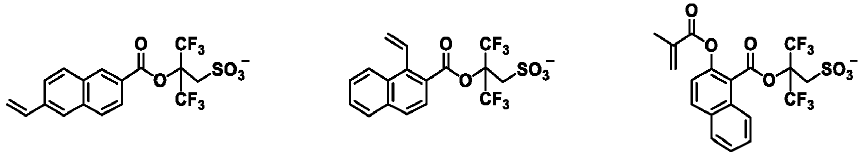

In formulae (B6) to (B13), R³¹ to R⁴⁸ are each independently halogen or a C₁-C₂₀ hydrocarbyl group which may contain a heteroatom. The hydrocarbyl group may be saturated or unsaturated and straight, branched or cyclic. Examples of the halogen and hydrocarbyl group are as exemplified above for the halogen and hydrocarbyl groups represented by R^{c1} to R^{c5} in formulae (cation-1) to (cation-3). In the hydrocarbyl group, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy moiety, fluorine, chlorine, bromine, iodine, cyano moiety, nitro moiety, carbonyl moiety, ether bond, ester bond, sulfonate ester bond, carbonate bond, lactone ring, sultone ring, carboxylic anhydride (-C(=O)-O-C(=O)-) or haloalkyl moiety.

A pair of R³¹ and R³² may bond together to form a ring with the sulfur atom to which they are attached. Also, R³³ and R³⁴, R³⁶ and R³⁷, or R³⁹ and R⁴⁰ may bond together to form a ring with the sulfur atom to which they are attached. Examples of the ring are as exemplified for the ring that R^{c1} and R^{c2} in formula (cation-1), taken together, form with the sulfur atom to which they are attached.

Examples of the sulfonium cation in repeat units B7 to B9 are as exemplified for the sulfonium cation having formula (cation-1). Examples of the iodonium cation in repeat units B11 to B 13 are as exemplified for the iodonium cation having formula (cation-2).

The repeat units B6 to B 13 are capable of generating an acid upon receipt of high-energy radiation. The binding of these units into a polymer enables appropriate control of acid diffusion and formation of a pattern with reduced LER. Since the acid-generating unit is bound to a polymer, the phenomenon that acid volatilizes from the exposed region and re-deposits on the unexposed region during bake in vacuum is suppressed. This is effective for reducing LER and for suppressing unwanted negative-turning reaction in the unexposed region for thereby reducing pattern defects.

Each of repeat units B6 to B13 may be of one type or a combination of plural types.

The polymer B or B' may further comprise (meth)acrylate or other repeat units having an adhesive group such as lactone structure or hydroxy group other than phenolic hydroxy.

Examples of the (meth)acrylate unit having an adhesive group include repeat units having the following formulae (B14) to (B16), which are also referred to as repeat units B14 to B 16. While these units do not exhibit acidity, they may be used as auxiliary units for providing adhesion to substrates or adjusting solubility.

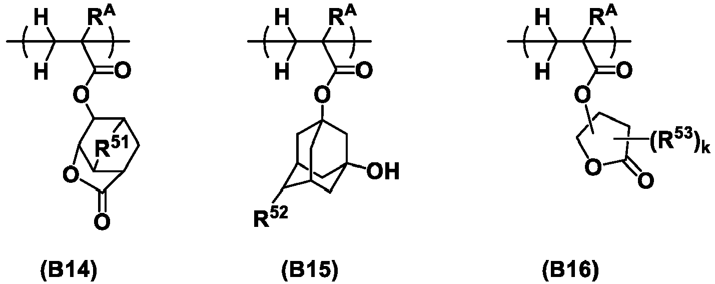

In formulae (B14) to (B16), R^{A} is each independently hydrogen, fluorine, methyl or trifluoromethyl. R⁵¹ is -O- or methylene. R⁵² is hydrogen or hydroxy. R⁵³ is a C₁-C₄ saturated hydrocarbyl group, and k is an integer of 0 to 3. Each of repeat units B14 to B16 may be of one type or a combination of plural types.

The content of repeat units B1 is preferably 30 to 95 mol%, more preferably 50 to 85 mol% of the overall repeat units of polymer B for providing a high contrast between a negative-turning region which is exposed to high-energy radiation and a non-negative-turning region which is not exposed to high-energy radiation, for achieving a high resolution. The content of repeat units B2 is preferably 5 to 70 mol%, more preferably 10 to 60 mol% based on the overall repeat units of polymer B for achieving the effect of accelerating negative-turning reaction. The content of repeat units B3 to B5 is preferably 0 to 30 mol%, more preferably 3 to 20 mol% based on the overall repeat units of polymer B for achieving the effect of enhancing etch resistance. The polymer B may contain 0 to 30 mol%, preferably 0 to 20 mol% of other repeat units.

In the embodiment wherein polymer B' does not contain repeat units B6 to B13, the content of repeat units B1 is preferably 25 to 95 mol%, more preferably 40 to 85 mol%, the content of repeat units B3 to B5 is preferably 0 to 30 mol%, more preferably 3 to 20 mol%, and the content of repeat units B5 is preferably 5 to 70 mol%, more preferably 10 to 60 mol%, based on the overall repeat units of polymer B'. Other repeat units may be incorporated in a content of 0 to 30 mol%, preferably 0 to 20 mol%.

In the other embodiment wherein polymer B' contains repeat units B6 to B13, the content of repeat units B1 is preferably 25 to 94.5 mol%, more preferably 36 to 85 mol%, the content of repeat units B3 to B5 is preferably 0 to 30 mol%, more preferably 3 to 20 mol%, the content of repeat units B5 is preferably 5 to 70 mol%, more preferably 10 to 60 mol%, the total content of repeat units B 1 to B5 is preferably 60 to 99.5 mol%, and the content of repeat units B6 to B 13 is preferably 0.5 to 20 mol%, more preferably 1 to 10 mol%, based on the overall repeat units of polymer B'. Other repeat units may be incorporated in a content of 0 to 30 mol%, preferably 0 to 20 mol%.

The repeat units B 1 to B5 preferably account for at least 60 mol%, more preferably at least 70 mol%, even more preferably at least 80 mol% based on the overall repeat units of the polymer. This ensures that the chemically amplified negative resist composition has satisfactory properties.

Preferably, polymer B' comprises repeat units having the formula (B 1-1), repeat units having the formula (B2-1) or (B2-2), and repeat units having the formula (B7).

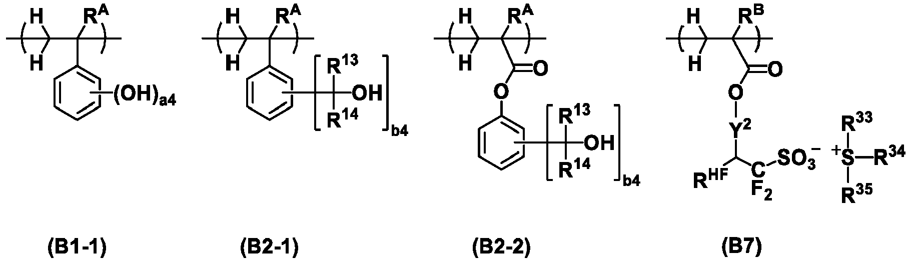

Herein, a4, b4, R^{A}, R^{B}, Y², R¹³, R¹⁴, R³¹, R³⁴, R³⁵, and R^{HF} are as defined above.

In the embodiment wherein polymer B' is used as base polymer (B), it may be a mixture of a polymer containing repeat units B6 to B13 and a polymer free of repeat units B6 to B 13. In the chemically amplified negative resist composition, the amount of the polymer free of repeat units B6 to B13 is preferably 2 to 5,000 parts by weight, more preferably 10 to 1,000 parts by weight per 100 parts by weight of the polymer containing repeat units B6 to B 13.

It is now considered that the chemically amplified negative resist composition is used in the fabrication of masks. The lithography of advanced generation implies a coating thickness of up to 150 nm, preferably up to 100 nm. The base polymer on which the chemically amplified negative resist composition is based should preferably have a dissolution rate in alkaline developer (typically 2.38 wt% aqueous solution of tetramethylammonium hydroxide (TMAH)) of up to 80 nm/sec, more preferably up to 50 nm/sec for forming small-size patterns because a strong development process is often employed in order to minimize defects resulting from resist residues. In an example where LSI chips are manufactured from a wafer using the chemically amplified negative resist composition in combination with the EUV lithography, the coating thickness is often up to 100 nm as viewed from the need to form a pattern of narrow lines with a width of up to 50 nm. Since a thin film has a risk that the pattern can be degraded by development, the polymer should preferably have a dissolution rate of up to 80 nm/sec, more preferably up to 50 nm/sec.

The polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to WO 2006/121096, JP-A 2008-102383, JP-A 2008-304590, and JP-A 2004-115630, for example.

The polymer should preferably have a Mw of 1,000 to 50,000, and more preferably 2,000 to 20,000. A Mw of at least 1,000 eliminates the risk that pattern features are rounded at their top to invite degradations of resolution and LER. A Mw of up to 50,000 eliminates the risk that LER increases when a pattern with a line width of up to 100 nm is formed. As used herein, Mw is measured by GPC versus polystyrene standards using tetrahydrofuran (THF) or dimethylformamide (DMF) solvent.

The polymer preferably has a narrow molecular weight distribution or dispersity (Mw/Mn) of 1.0 to 2.0, more preferably 1.0 to 1.8. A polymer with such a narrow dispersity eliminates the risk that foreign particles are left on the pattern after development and the pattern profile is aggravated.

### (C) Crosslinker

When the base polymer (B) does not contain polymer B', the negative resist composition preferably comprises a crosslinker as component (C). When the base polymer (B) contains polymer B', a crosslinker need not be added.

Suitable crosslinkers which can be used herein include epoxy compounds, melamine compounds, guanamine compounds, glycoluril compounds and urea compounds having substituted thereon at least one group selected from among methylol, alkoxymethyl and acyloxymethyl groups, isocyanate compounds, azide compounds, and compounds having a double bond such as an alkenyloxy group. These compounds may be used as an additive or introduced into a polymer side chain as a pendant. Hydroxy-containing compounds may also be used as the crosslinker.

Of the foregoing crosslinkers, examples of suitable epoxy compounds include tris(2,3-epoxypropyl) isocyanurate, trimethylolmethane triglycidyl ether, trimethylolpropane triglycidyl ether, and triethylolethane triglycidyl ether.

Examples of the melamine compound include hexamethylol melamine, hexamethoxymethyl melamine, hexamethylol melamine compounds having 1 to 6 methylol groups methoxymethylated and mixtures thereof, hexamethoxyethyl melamine, hexaacyloxymethyl melamine, hexamethylol melamine compounds having 1 to 6 methylol groups acyloxymethylated and mixtures thereof.

Examples of the guanamine compound include tetramethylol guanamine, tetramethoxymethyl guanamine, tetramethylol guanamine compounds having 1 to 4 methylol groups methoxymethylated and mixtures thereof, tetramethoxyethyl guanamine, tetraacyloxyguanamine, tetramethylol guanamine compounds having 1 to 4 methylol groups acyloxymethylated and mixtures thereof.

Examples of the glycoluril compound include tetramethylol glycoluril, tetramethoxyglycoluril, tetramethoxymethyl glycoluril, tetramethylol glycoluril compounds having 1 to 4 methylol groups methoxymethylated and mixtures thereof, tetramethylol glycoluril compounds having 1 to 4 methylol groups acyloxymethylated and mixtures thereof.

Examples of the urea compound include tetramethylol urea, tetramethoxymethyl urea, tetramethylol urea compounds having 1 to 4 methylol groups methoxymethylated and mixtures thereof, and tetramethoxyethyl urea.

Suitable isocyanate compounds include tolylene diisocyanate, diphenylmethane diisocyanate, hexamethylene diisocyanate and cyclohexane diisocyanate.

Suitable azide compounds include 1,1'-biphenyl-4,4'-bisazide, 4,4'-methylidenebisazide, and 4,4'-oxybisazide.

Examples of the alkenyloxy-containing compound include ethylene glycol divinyl ether, triethylene glycol divinyl ether, 1,2-propanediol divinyl ether, 1,4-butanediol divinyl ether, tetramethylene glycol divinyl ether, neopentyl glycol divinyl ether, trimethylol propane trivinyl ether, hexanediol divinyl ether, 1,4-cyclohexanediol divinyl ether, pentaerythritol trivinyl ether, pentaerythritol tetravinyl ether, sorbitol tetravinyl ether, sorbitol pentavinyl ether, and trimethylol propane trivinyl ether.

An appropriate amount of the crosslinker (C) used is 0.1 to 50 parts, and more preferably 1 to 10 parts by weight per 80 parts by weight of the base polymer (B). As long as the amount of the crosslinker is in the range, the risk of resolution being reduced by forming bridges between pattern features is mitigated. The crosslinkers may be used alone or in admixture.

### (D) Fluorinated polymer

The negative resist composition may further comprise a fluorinated polymer for the purposes of enhancing contrast, preventing chemical flare of acid upon exposure to high-energy radiation, preventing mixing of acid from an anti-charging film in the step of coating an anti-charging film-forming material on a resist film, and suppressing unexpected unnecessary pattern degradation. The fluorinated polymer contains repeat units of at least one type selected from repeat units having the formula (D1), repeat units having the formula (D2), repeat units having the formula (D3), and repeat units having the formula (D4), and may contain repeat units of at least one type selected from repeat units having the formula (D5) and repeat units having the formula (D6). It is noted that repeat units having formulae (D1), (D2), (D3), (D4), (D5), and (D6) are also referred to as repeat units D1, D2, D3, D4, D5, and D6, respectively, hereinafter. Since the fluorinated polymer also has a surface active function, it can prevent insoluble residues from re-depositing onto the substrate during the development step and is thus effective for preventing development defects.

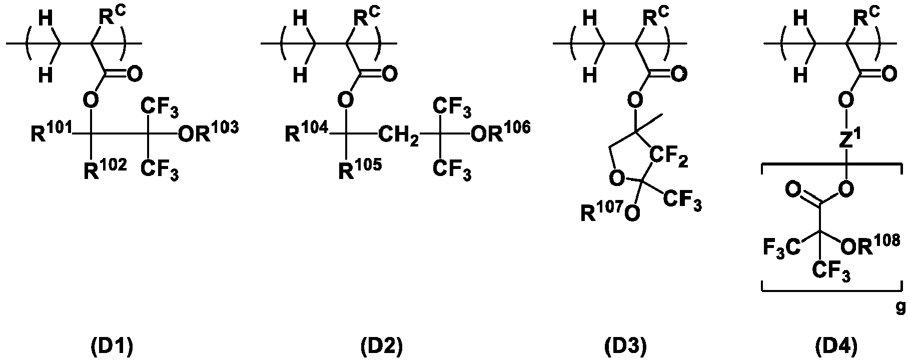

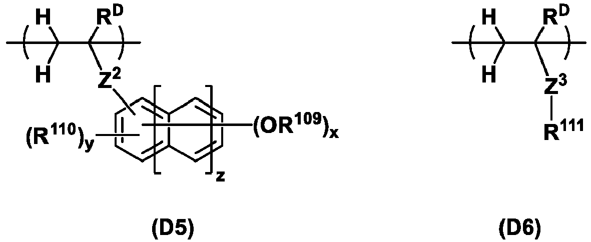

In formulae (D1) to (D6), x is an integer of 1 to 3, y is an integer satisfying: 0 ≤ y ≤ 5+2z-x, z is 0 or 1, and g is an integer of 1 to 3. R^{C} is each independently hydrogen, fluorine, methyl or trifluoromethyl. R^{D} is each independently hydrogen or methyl. R¹⁰¹, R¹⁰², R¹⁰⁴ and R¹⁰⁵ are each independently hydrogen or a C₁-C₁₀ saturated hydrocarbyl group. R¹⁰³, R¹⁰⁶, R¹⁰⁷ and R¹⁰⁸ are each independently hydrogen, a C₁-C₁₅ hydrocarbyl group or fluorinated hydrocarbyl group, or an acid labile group, with the proviso that an ether bond or carbonyl moiety may intervene in a carbon-carbon bond in the hydrocarbyl groups or fluorinated hydrocarbyl groups represented by R¹⁰³, R¹⁰⁶, R¹⁰⁷ and R¹⁰⁸. R¹⁰⁹ is hydrogen or a C₁-C₅ straight or branched hydrocarbyl group in which a heteroatom-containing moiety may intervene in a carbon-carbon bond. R¹¹⁰ is a C₁-C₅ straight or branched hydrocarbyl group in which a heteroatom-containing moiety may intervene in a carbon-carbon bond. R¹¹¹ is a C₁-C₂₀ saturated hydrocarbyl group in which at least one hydrogen is substituted by fluorine and some constituent -CH₂- may be replaced by an ester bond or ether bond. Z¹ is a C₁-C₂₀ (g+1)-valent hydrocarbon group or C₁-C₂₀ (g+1)-valent fluorinated hydrocarbon group. Z² is a single bond, *-C(=O)-O- or *-C(=O)-NH- wherein * designates a point of attachment to the carbon atom in the backbone. Z³ is a single bond, -O-, *-C(=O)-O-Z³¹-Z³²- or *-C(=O)-NH-Z³¹-Z³²-, wherein Z³¹ is a single bond or a C₁-C₁₀ saturated hydrocarbylene group, Z³² is a single bond, ester bond, ether bond or sulfonamide bond, and * designates a point of attachment to the carbon atom in the backbone.

In formulae (D1) and (D2), the C₁-C₁₀ saturated hydrocarbyl group represented by R¹⁰¹, R¹⁰², R¹⁰⁴ and R¹⁰⁵ may be straight, branched or cyclic and examples thereof include C₁-C₁₀ alkyl groups such as methyl, ethyl, n-propyl, isopropyl, n-butyl, isobutyl, sec-butyl, tert-butyl, n-pentyl, n-hexyl, n-heptyl, n-octyl, n-nonyl, and n-decyl, and C₃-C₁₀ cyclic saturated hydrocarbyl groups such as cyclopropyl, cyclobutyl, cyclopentyl, cyclohexyl, adamantyl, and norbornyl. Inter alia, C₁-C₆ saturated hydrocarbyl groups are preferred.

In formulae (D1) to (D4), the C₁-C₁₅ hydrocarbyl group represented by R¹⁰³, R¹⁰⁶, R¹⁰⁷ and R¹⁰⁸ may be straight, branched or cyclic and examples thereof include C₁-C₁₅ alkyl, C₂-C₁₅ alkenyl and C₂-C₁₅ alkynyl groups, with the alkyl groups being preferred. Suitable alkyl groups include methyl, ethyl, n-propyl, isopropyl, n-butyl, isobutyl, sec-butyl, n-pentyl, n-hexyl, n-heptyl, n-octyl, n-nonyl, n-decyl, n-undecyl, n-dodecyl, n-tridecyl, n-tetradecyl and n-pentadecyl. The fluorinated hydrocarbyl groups correspond to the foregoing hydrocarbyl groups in which some or all carbon-bonded hydrogen atoms are substituted by fluorine atoms.

In formula (D4), examples of the C₁-C₂₀ (g+1)-valent hydrocarbon group Z¹ include the foregoing C₁-C₂₀ alkyl groups and C₃-C₂₀ cyclic saturated hydrocarbyl groups, with g number of hydrogen atoms being eliminated. Examples of the C₁-C₂₀ (g+1)-valent fluorinated hydrocarbon group Z¹ include the foregoing (g+1)-valent hydrocarbon groups in which at least one hydrogen atom is substituted by fluorine.

Examples of the repeat units D1 to D4 are given below, but not limited thereto. Herein R^{C} is as defined above.

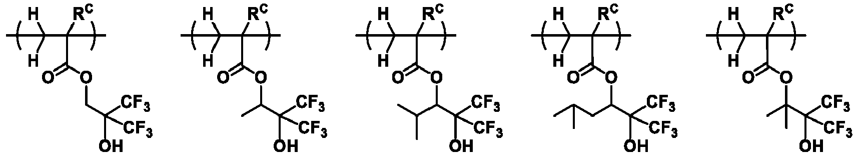

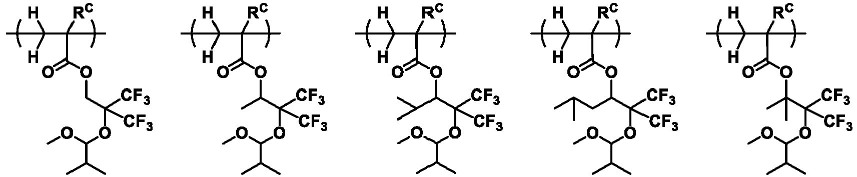

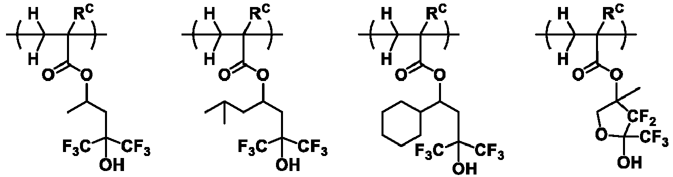

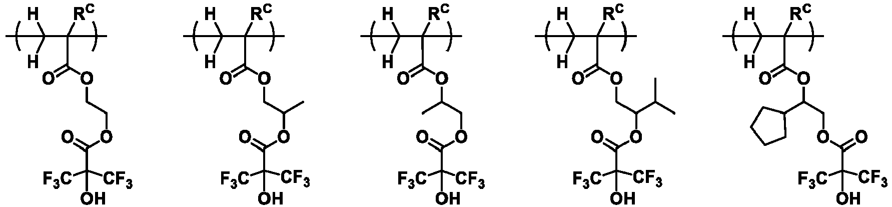

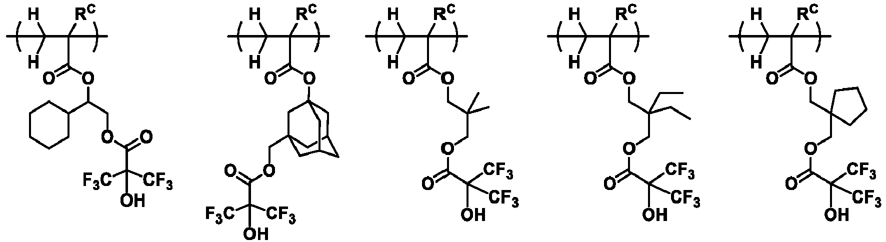

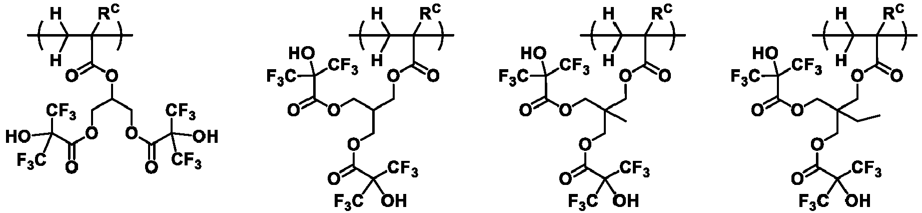

In formula (D5), examples of the C₁-C₅ hydrocarbyl groups R¹⁰⁹ and R¹¹⁰ include alkyl, alkenyl and alkynyl groups, with the alkyl groups being preferred. Suitable alkyl groups include methyl, ethyl, n-propyl, isopropyl, n-butyl, isobutyl, sec-butyl, and n-pentyl. In these groups, a moiety containing a heteroatom such as oxygen, sulfur or nitrogen may intervene in a carbon-carbon bond.

In formula (D5), -OR¹⁰⁹ is preferably a hydrophilic group. In this case, R¹⁰⁹ is preferably hydrogen or a C₁-C₅ alkyl group in which oxygen intervenes in a carbon-carbon bond.

In formula (D5), Z² is preferably *-C(=O)-O- or *-C(=O)-NH-. Also preferably R^{D} is methyl. The inclusion of carbonyl in Z² enhances the ability to trap the acid originating from the anti-charging film. A polymer wherein R^{D} is methyl is a robust polymer having a high glass transition temperature (Tg) which is effective for suppressing acid diffusion. As a result, the resist film is improved in stability with time, and neither resolution nor pattern profile is degraded.

Examples of the repeat unit D5 are given below, but not limited thereto. Herein R^{D} is as defined above.

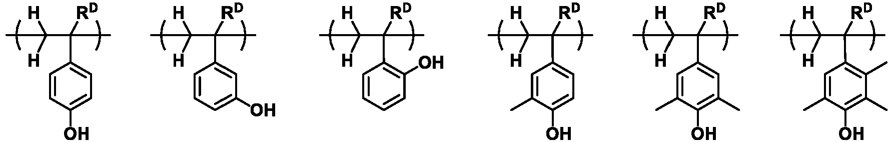

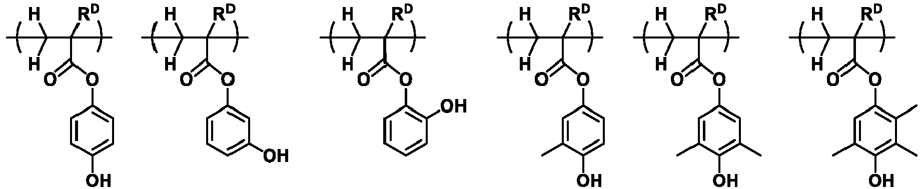

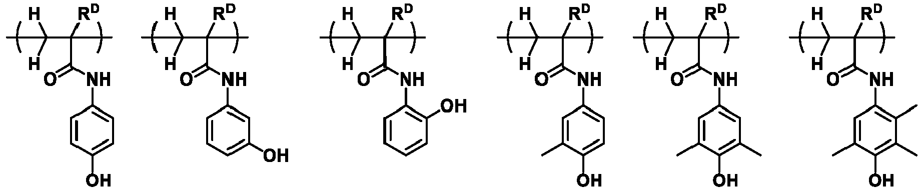

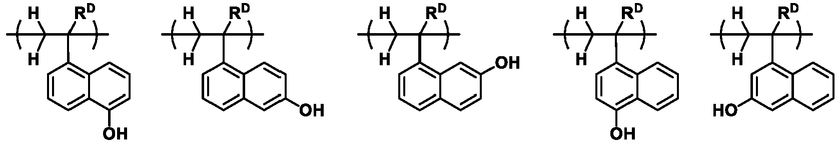

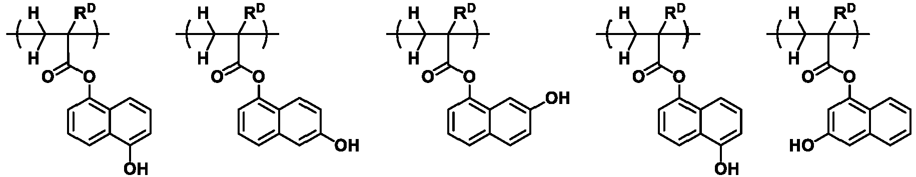

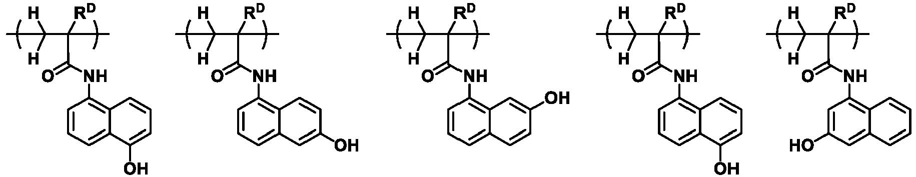

In formula (D6), the C₁-C₁₀ saturated hydrocarbylene group Z³ may be straight, branched or cyclic and examples thereof include methanediyl, ethane-1,1-diyl, ethane-1,2-diyl, propane-1,1-diyl, propane-1,2-diyl, propane-1,3-diyl, propane-2,2-diyl, butane-1,1-diyl, butane-1,2-diyl, butane-1,3-diyl, butane-2,3-diyl, butane-1,4-diyl, and 1,1-dimethylethane-1,2-diyl.

The C₁-C₂₀ saturated hydrocarbyl group having at least one hydrogen substituted by fluorine, represented by R¹¹¹, may be straight, branched or cyclic and examples thereof include C₁-C₂₀ alkyl groups and C₃-C₂₀ cyclic saturated hydrocarbyl groups in which at least one hydrogen is substituted by fluorine.

Examples of the repeat unit D6 are given below, but not limited thereto. Herein R^{D} is as defined above.

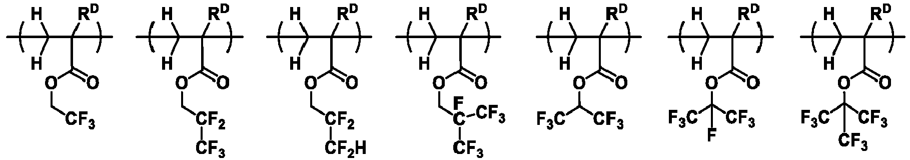

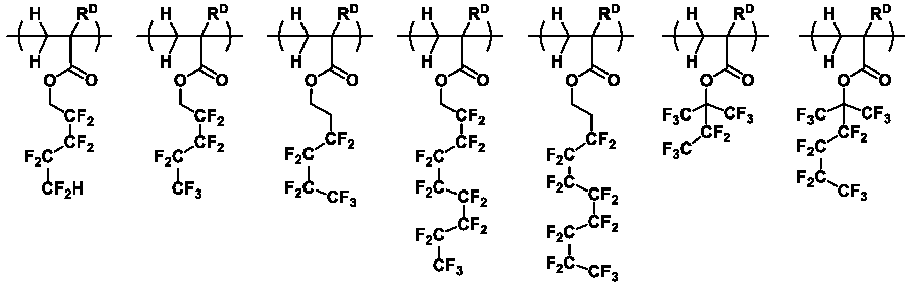

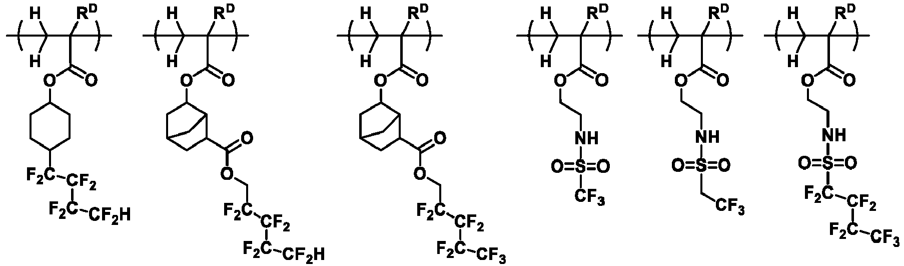

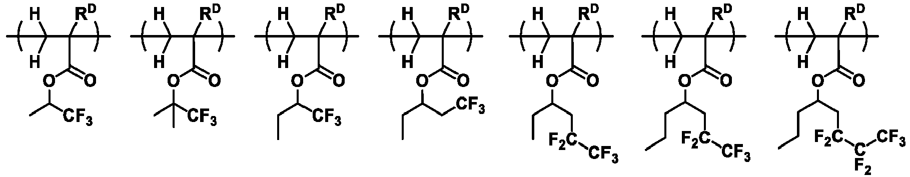

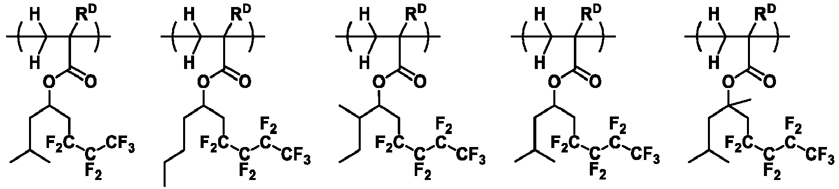

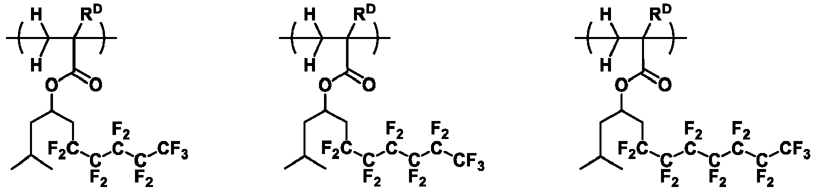

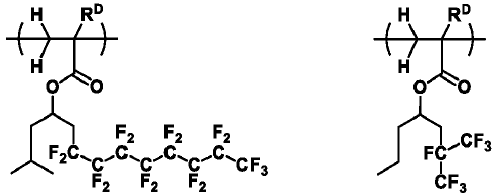

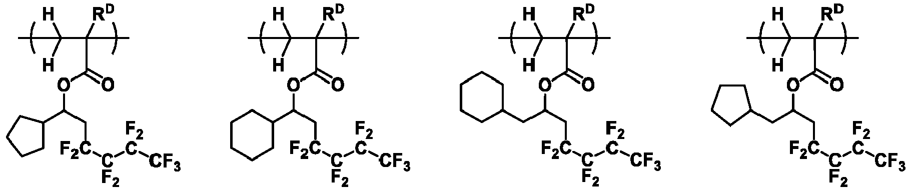

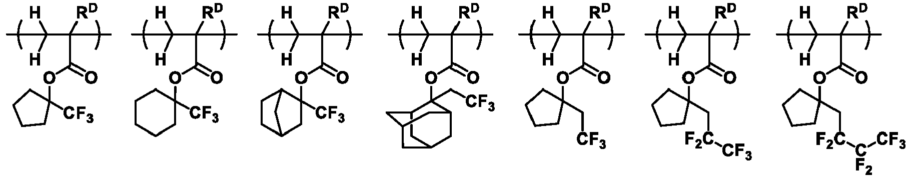

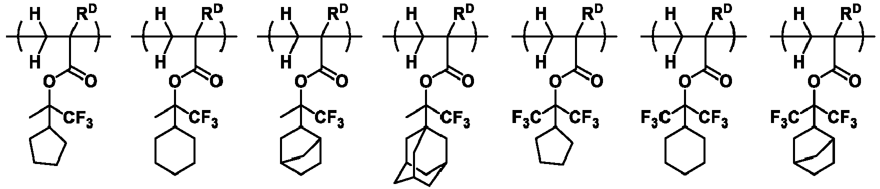

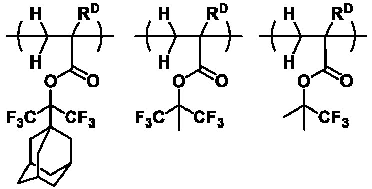

The repeat units D1 to D4 are preferably incorporated in an amount of 15 to 95 mol%, more preferably 20 to 85 mol% based on the overall repeat units of the fluorinated polymer. The repeat unit D5 and/or D6 is preferably incorporated in an amount of 5 to 85 mol%, more preferably 15 to 80 mol% based on the overall repeat units of the fluorinated polymer. Each of repeat units D1 to D6 may be used alone or in admixture.

The fluorinated polymer may comprise additional repeat units as well as the repeat units D1 to D6. Suitable additional repeat units include those described in USP 9,091,918 (JP-A 2014-177407, paragraphs [0046]-[0078]). When the fluorinated polymer comprises additional repeat units, their content is preferably up to 50 mol% based on the overall repeat units.

The fluorinated polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630.

The fluorinated polymer should preferably have a Mw of 2,000 to 50,000, and more preferably 3,000 to 20,000. A fluorinated polymer with a Mw of less than 2,000 helps acid diffusion, degrading resolution and detracting from age stability. A polymer with too high Mw has a reduced solubility in solvent, with a risk of leaving coating defects. The fluorinated polymer preferably has a dispersity (Mw/Mn) of 1.0 to 2.2, more preferably 1.0 to 1.7.

In the negative resist composition, the fluorinated polymer (D) is preferably used in an amount of 0.01 to 30 parts, more preferably 0.1 to 20 parts, even more preferably 0.5 to 10 parts by weight per 80 parts by weight of the base polymer (B). The fluorinated polymer may be used alone or in admixture.

### (E) Acid generator

The negative resist composition may further comprise an acid generator as component (E). The acid generator used herein may be any compound (PAG) capable of generating an acid in response to actinic ray or radiation. The PAG used herein is not particularly limited as long as it can generate an acid upon exposure to high-energy radiation. Suitable PAGs include sulfonium salts, iodonium salts, sulfonyldiazomethane, N-sulfonyloxyimide, and oxime-O-sulfonate acid generators.

Suitable PAGs include nonafluorobutane sulfonate, partially fluorinated sulfonates described in JP-A 2012-189977, paragraphs [0247]-[0251], partially fluorinated sulfonates described in JP-A 2013-101271, paragraphs [0261]-[0265], and those described in JP-A 2008-111103, paragraphs [0122]-[0142] and JP-A 2010-215608, paragraphs [0080]-[0081]. Among others, arylsulfonate and alkanesulfonate type PAGs are preferred because they generate acids having an appropriate strength to promote the reaction of crosslinker (C) with base polymer (B).

In order that the effect of improving LER is exerted by combining the acid generator with the quencher (A), the acid generator preferably generates an acid having a pKa value of -3.0 or larger, more preferably in the range of -3.0 to 2.0, even more preferably in the range of -2.0 to 1.5.

A salt compound having an anion of the structure shown below is preferred as the acid generator.

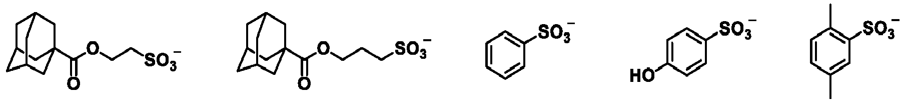

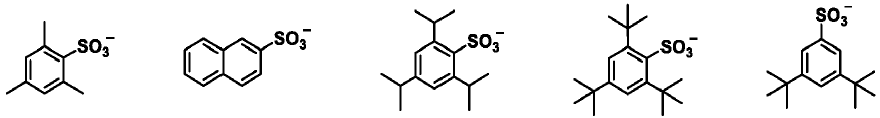

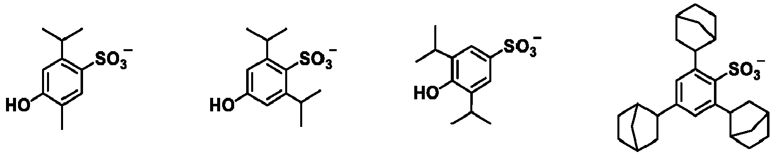

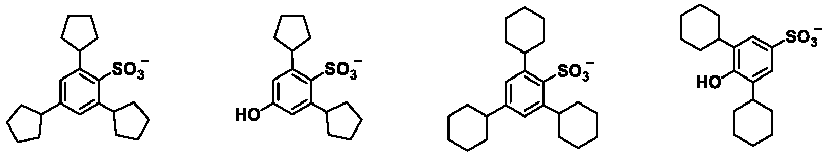

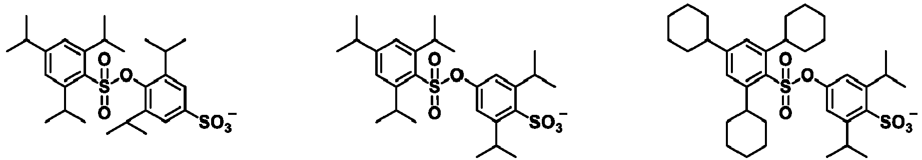

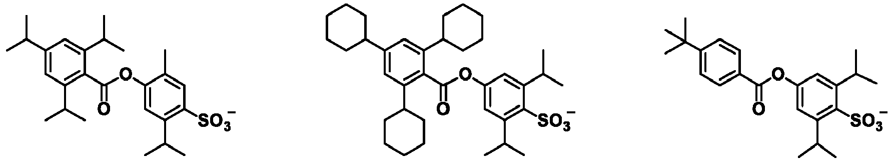

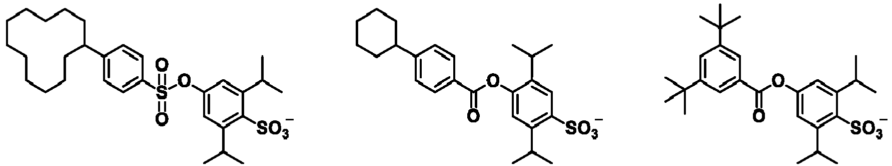

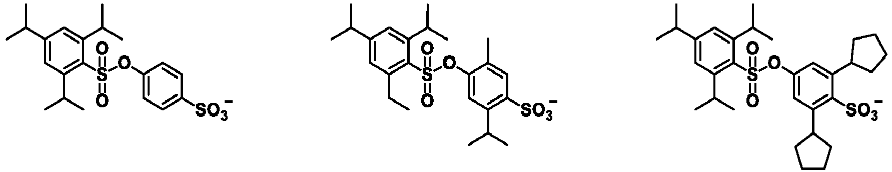

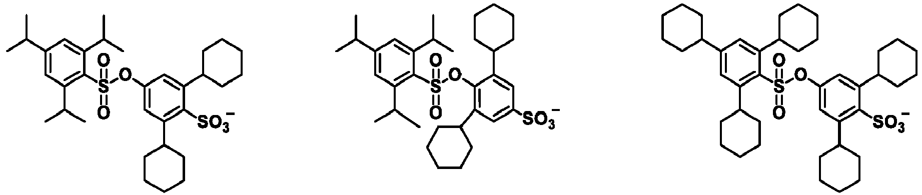

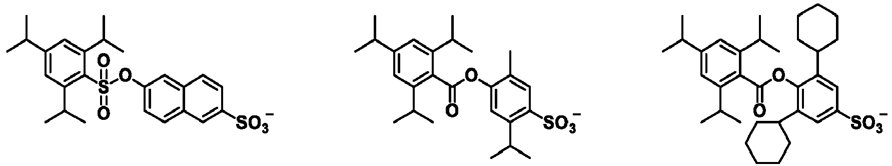

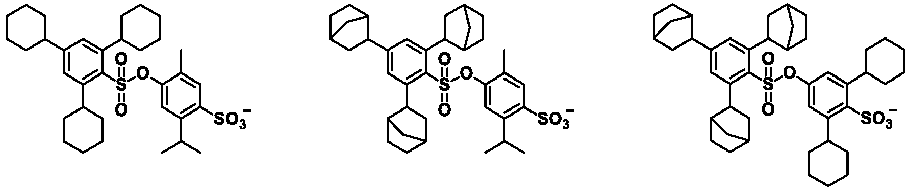

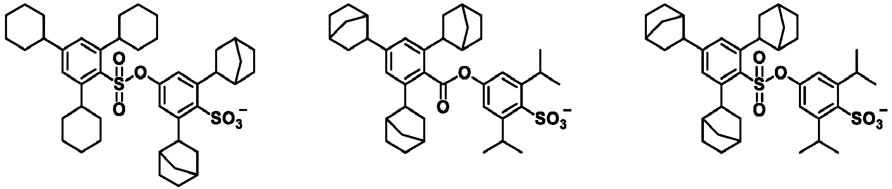

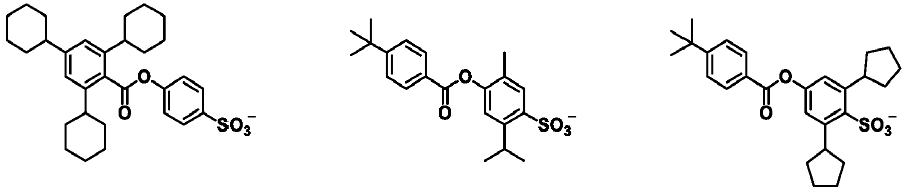

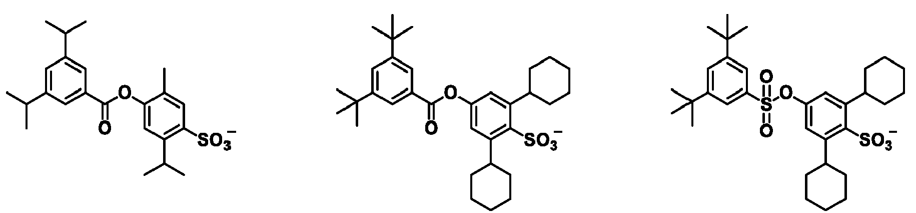

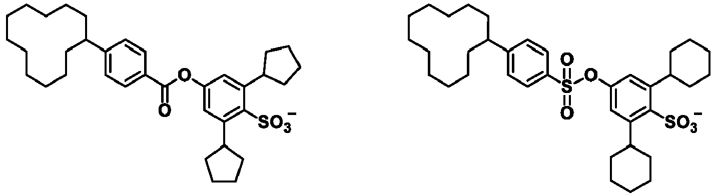

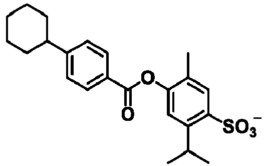

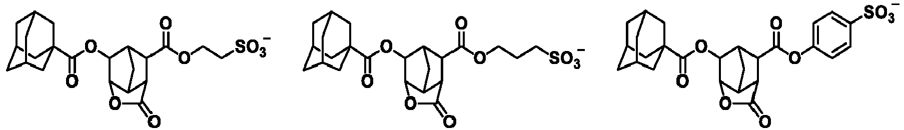

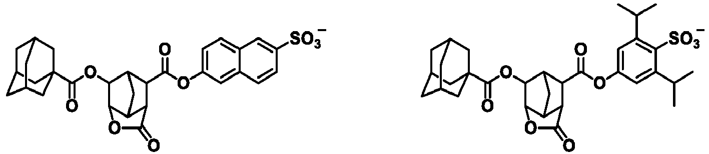

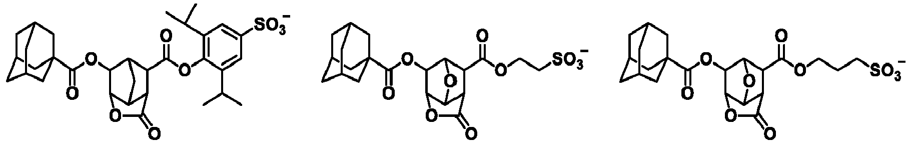

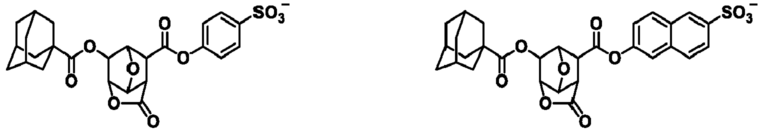

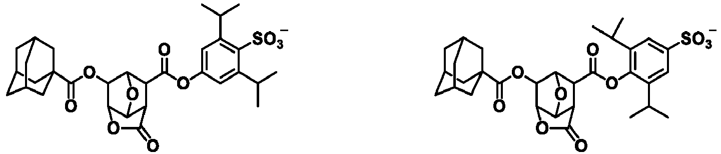

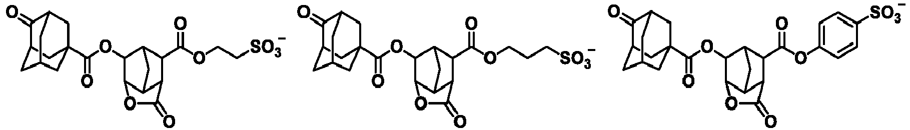

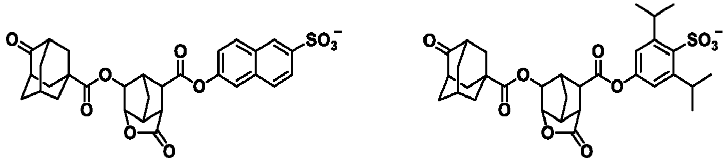

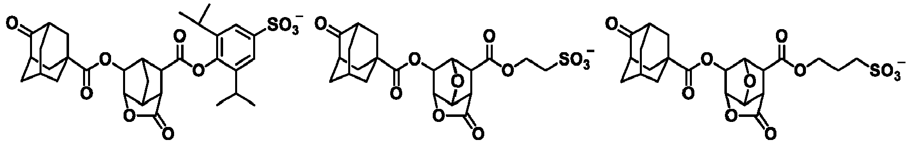

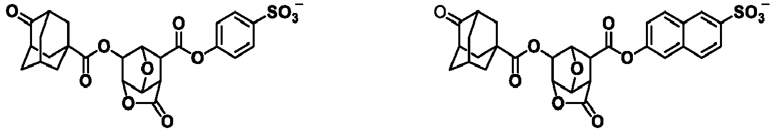

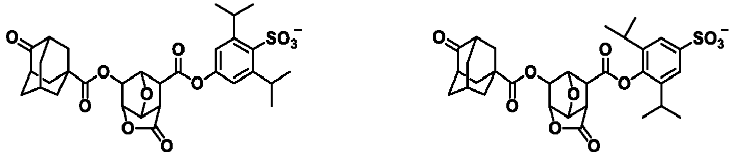

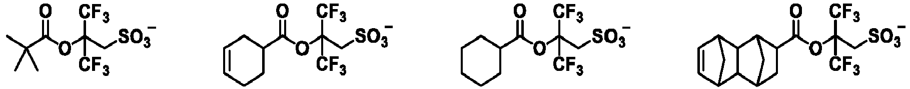

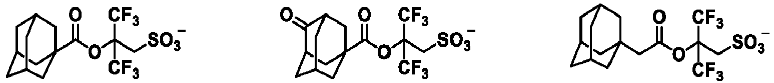

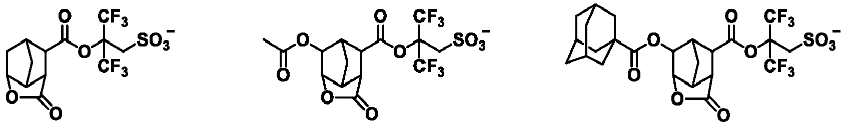

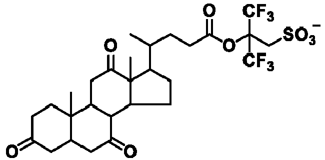

Examples of the pairing cation include the above-illustrated examples of the sulfonium cation having formula (cation-1) and the above-illustrated examples of the iodonium cation having formulae (cation-2).

When the negative resist composition contains the acid generator (E), an appropriate amount of the acid generator used is 1 to 30 parts, more preferably 2 to 20 parts by weight per 80 parts by weight of the base polymer (B). In the embodiment wherein the base polymer contains repeat units B6 to B13, that is, in the case of polymer-bound acid generator, the addition of acid generator (E) may be omitted. The acid generator may be used alone or in admixture.

In the embodiment wherein the chemically amplified negative resist composition contains the quencher (A) and the acid generator (E), the acid generator (E) and the quencher (A) are preferably present in a weight ratio (E/A) of less than 6/1, more preferably less than 5/1, even more preferably less than 4/1. As long as the ratio of acid generator (E) to quencher (A) is in the range, it is possible to fully suppress acid diffusion, leading to improved resolution and dimensional uniformity.

### (F) Organic solvent

The chemically amplified negative resist composition may further comprise an organic solvent as component (F). The organic solvent used herein is not particularly limited as long as the components are soluble therein. Examples of the organic solvent are described in JP-A 2008-111103, paragraphs [0144] to [0145] (USP 7,537,880). Specifically, exemplary solvents include ketones such as cyclohexanone, cyclopentanone, methyl-2-n-pentyl ketone and 2-heptanone; alcohols such as 3-methoxybutanol, 3-methyl-3-methoxybutanol, 1-methoxy-2-propanol, 1-ethoxy-2-propanol, and diacetone alcohol (DAA); ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate (PGMEA), propylene glycol monoethyl ether acetate, ethyl lactate (EL), ethyl pyruvate, butyl acetate, methyl 3-methoxypropionate, ethyl 3-ethoxypropionate, t-butyl acetate, t-butyl propionate, and propylene glycol mono-t-butyl ether acetate; and lactones such as γ-butyrolactone (GBL), and mixtures thereof.

Of the above organic solvents, it is recommended to use 1-ethoxy-2-propanol, PGMEA, PGME, cyclohexanone, EL, GBL, DAA, and mixtures thereof.

In the negative resist composition, the organic solvent (F) is preferably used in an amount of 200 to 10,000 parts, more preferably 400 to 6,000 parts by weight per 80 parts by weight of the base polymer (B). The organic solvent may be used alone or in admixture.

### (G) Basic compound

In the negative resist composition, (G) a basic compound may be added as the quencher other than component (A) for the purpose of correcting a pattern profile or the like. The basic compound is effective for controlling acid diffusion. Even when the resist film is applied to a substrate having an outermost surface layer made of a chromium-containing material, the basic compound is effective for minimizing the influence of the acid generated in the resist film on the chromium-containing material.

Numerous basic compounds are known useful including primary, secondary, and tertiary aliphatic amines, mixed amines, aromatic amines, heterocyclic amines, nitrogen-containing compounds with carboxy group, nitrogen-containing compounds with sulfonyl group, nitrogen-containing compounds with hydroxy group, nitrogen-containing compounds with hydroxyphenyl group, alcoholic nitrogen-containing compounds, amide derivatives, imide derivatives, carbamate derivatives, and ammonium salts. Examples are described in Patent Document 9, for example, and any such compounds are useful. Of the foregoing basic compounds, preferred are tris[2-(methoxymethoxy)ethyl]amine, tris[2-(methoxymethoxy)ethyl]amine-N-oxide, dibutylaminobenzoic acid, morpholine derivatives and imidazole derivatives.

In the negative resist composition, the basic compound (G) is preferably added in an amount of 0 to 20 parts, and more preferably 0 to 10 parts by weight per 80 parts by weight of the base polymer (B). The basic compounds may be used alone or in admixture.

### (H) Surfactant

The negative resist composition may contain any conventional surfactants for facilitating to coat the composition to the substrate. Exemplary surfactants include PF-636 (Omnova Solutions Inc.) and FC-4430 (3M) as well as a number of known surfactants as described in JP-A 2004-115630. Any suitable one may be chosen therefrom. The amount of the surfactant (H) added is preferably 0 to 5 parts by weight per 80 parts by weight of the base polymer (B). The surfactant may be used alone or in admixture.

### Process

Another embodiment of the invention is a resist pattern forming process comprising the steps of applying the chemically amplified negative resist composition defined above onto a substrate to form a resist film thereon, exposing the resist film patternwise to high-energy radiation, and developing the resist film in an alkaline developer to form a resist pattern.

Pattern formation using the negative resist composition of the invention may be performed by well-known lithography processes. In general, the resist composition is first applied onto a substrate for IC fabrication (e.g., Si, SiO, SiO₂, SiN, SiON, TiN, WSi, BPSG, SOG, organic antireflective coating, etc.) or a substrate for mask circuit fabrication (e.g., Cr, CrO, CrON, MoSi₂, Si, SiO, SiO₂, SiON, SiONC, CoTa, NiTa, TaBN, SnO₂, etc.) by a suitable coating technique such as spin coating. The coating is prebaked on a hotplate preferably at a temperature of 60 to 150°C for 1 to 20 minutes, more preferably at 80 to 140°C for 1 to 10 minutes to form a resist film of 0.03 to 2 µm thick.

Then the resist film is exposed patternwise to high-energy radiation such as UV, deep-UV, excimer laser (KrF, ArF), EUV, x-ray, γ-ray or synchrotron radiation or EB. The resist composition of the invention is especially effective in the KrF excimer laser, EUV or EB lithography.

On use of UV, deep-UV, EUV, excimer laser, x-ray, γ-ray or synchrotron radiation as the high-energy radiation, the resist film is exposed through a mask having a desired pattern, preferably in a dose of 1 to 500 mJ/cm², more preferably 10 to 400 mJ/cm². On use of EB, a pattern may be written directly in a dose of preferably 1 to 500 µC/cm², more preferably 10 to 400 µC/cm², even more preferably 100 to 400 µC/cm².

The exposure may be performed by conventional lithography whereas the immersion lithography of holding a liquid, typically water between the mask and the resist film may be employed if desired. In the case of immersion lithography, a protective film which is insoluble in water may be used.

The resist film is then baked (PEB) on a hotplate preferably at 60 to 150°C for 1 to 20 minutes, more preferably at 80 to 140°C for 1 to 10 minutes.

Thereafter, the resist film is developed with a developer in the form of an aqueous base solution, for example, 0.1 to 5 wt%, preferably 2 to 3 wt% aqueous solution of tetramethylammonium hydroxide (TMAH) preferably for 0.1 to 3 minutes, more preferably 0.5 to 2 minutes by conventional techniques such as dip, puddle and spray techniques. In this way, a desired resist pattern is formed on the substrate.

From the chemically amplified negative resist composition, a pattern with a high resolution and minimal LER can be formed. The resist composition is effectively applicable to a substrate, specifically a substrate having a surface layer of material to which a resist film is less adherent and which is likely to invite pattern stripping or pattern collapse, and particularly a substrate having sputter deposited on its outermost surface metallic chromium or a chromium compound containing at least one light element selected from oxygen, nitrogen and carbon or a substrate having an outermost surface layer of SiO, SiOₓ, or a tantalum, molybdenum, cobalt, nickel, tungsten or tin compound. The substrate to which the negative resist composition is applied is most typically a photomask blank which may be either of transmission or reflection type.

The mask blank of transmission type is typically a photomask blank having a light-shielding film of chromium-based material. It may be either a photomask blank for binary masks or a photomask blank for phase shift masks. In the case of the binary mask-forming photomask blank, the light-shielding film may include an antireflection layer of chromium-based material and a light-shielding layer. In one example, the antireflection layer on the surface layer side is entirely composed of a chromium-based material. In an alternative example, only a surface side portion of the antireflection layer on the surface layer side is composed of a chromium-based material and the remaining portion is composed of a silicon compound-based material which may contain a transition metal. In the case of the phase shift mask-forming photomask blank, it may include a phase shift film and a chromium-based light-shielding film thereon.

Photomask blanks having an outermost layer of chromium base material are well known as described in JP-A 2008-026500 and JP-A 2007-302873 and the references cited therein. Although the detail description is omitted herein, the following layer construction may be employed when a light-shielding film including an antireflective layer and a light-shielding layer is composed of chromium base materials.

In the example where a light-shielding film including an antireflective layer and a light-shielding layer is composed of chromium base materials, layers may be stacked in the order of an antireflective layer and a light-shielding layer from the outer surface side, or layers may be stacked in the order of an antireflective layer, a light-shielding layer, and an antireflective layer from the outer surface side. Each of the antireflective layer and the light-shielding layer may be composed of multiple sub-layers. When the sub-layers have different compositions, the composition may be graded discontinuously or continuously from sub-layer to sub-layer. The chromium base material used herein may be metallic chromium or a material consisting of metallic chromium and a light element such as oxygen, nitrogen or carbon. Examples used herein include metallic chromium, chromium oxide, chromium nitride, chromium carbide, chromium oxynitride, chromium oxycarbide, chromium nitride carbide, and chromium oxide nitride carbide.

The mask blank of reflection type includes a substrate, a multilayer reflective film formed on one major surface (front surface) of the substrate, for example, a multilayer reflective film of reflecting exposure radiation such as EUV radiation, and an absorber film formed on the multilayer reflective film, for example, an absorber film of absorbing exposure radiation such as EUV radiation to reduce reflectivity. From the reflection type mask blank (reflection type mask blank for EUV lithography), a reflection type mask (reflection type mask for EUV lithography) having an absorber pattern (patterned absorber film) formed by patterning the absorber film is produced. The EUV radiation used in the EUV lithography has a wavelength of 13 to 14 nm, typically about 13.5 nm.

The multilayer reflective film is preferably formed contiguous to one major surface of a substrate. An underlay film may be disposed between the substrate and the multilayer reflective film as long as the benefits of the invention are not lost. The absorber film may be formed contiguous to the multilayer reflective film while a protective film (protective film for the multilayer reflective film) may be disposed between the multilayer reflective film and the absorber film, preferably contiguous to the multilayer reflective film, more preferably contiguous to the multilayer reflective film and the absorber film. The protective film is used for protecting the multilayer reflective film in a cleaning, tailoring or otherwise processing step. Also preferably, the protective film has an additional function of protecting the multilayer reflective film or preventing the multilayer reflective film from oxidation during the step of patterning the absorber film by etching. Besides, an electroconductive film, which is used for electrostatic chucking of the reflection type mask to an exposure tool, may be disposed below the other major surface (back side surface) which is opposed to the one major surface of the substrate, preferably contiguous to the other major surface. It is provided herein that a substrate has one major surface which is a front or upper side surface and another major surface which is a back or lower side surface. The terms "front and back" sides or "upper and lower" sides are used for the sake of convenience. One or another major surface may be either of the two major surfaces (film-bearing surfaces) of a substrate, and in this sense, front and back or upper and lower are exchangeable. Specifically, the multilayer reflective film may be formed by any of the methods of JP-A 2021-139970 and the references cited therein.

The resist pattern forming process is successful in forming patterns of rectangular profile having a high resolution, reduced LER, improved fidelity, and improved dose margin even on a substrate (typically mask blank of transmission or reflection type) whose outermost surface is made of a material tending to affect resist pattern profile such as a chromium or silicon-containing material. This is because the negative resist composition is effective for controlling acid diffusion at the substrate interface.

### EXAMPLES

Examples of the invention are given below by way of illustration and not by way of limitation. The abbreviation "pbw" is parts by weight. For copolymers, the compositional ratio is a molar ratio and Mw is determined by GPC versus polystyrene standards using THF or DMF solvent.

### [1] Preparation of chemically amplified negative resist compositions

### Examples 1-1 to 1-50 and Comparative Examples 1-1 to 1-4

Chemically amplified negative resist compositions (R-1 to R-50, CR-1 to CR-4) were prepared by dissolving selected components in an organic solvent in accordance with the formulation shown in Tables 1 to 3, and filtering the solution through a UPE filter and/or nylon filter with a pore size of 10 nm, 5 nm, 3 nm or 1 nm. The organic solvent was a mixture of 790 pbw of PGMEA, 1,580 pbw of EL, and 1,580 pbw of PGME. In Tables 1 to 3, crosslinker TMGU is tetramethoxymethylglycoluril, and surfactant PF-636 is PolyFox PF-636 by Omnova Solutions Inc.

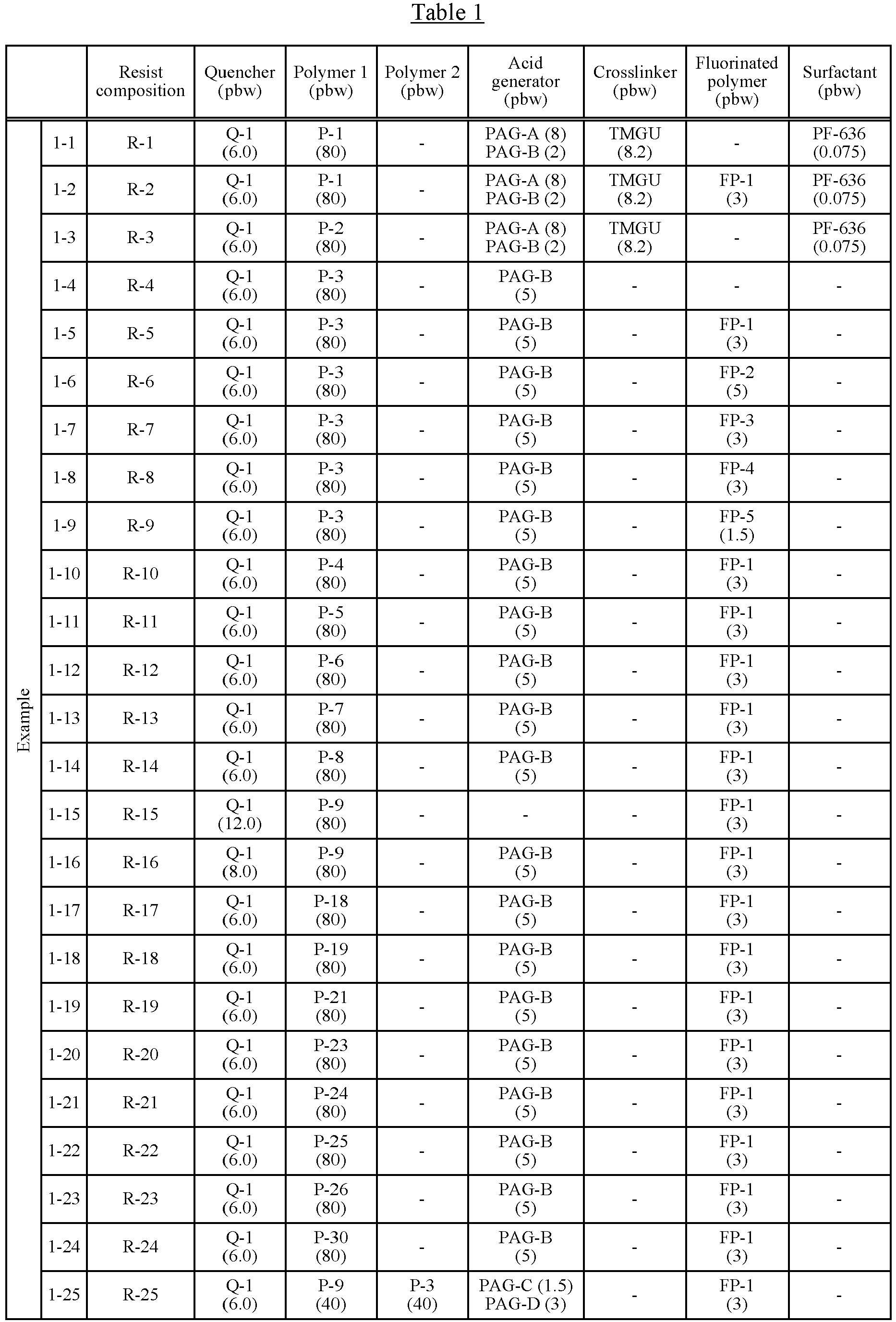

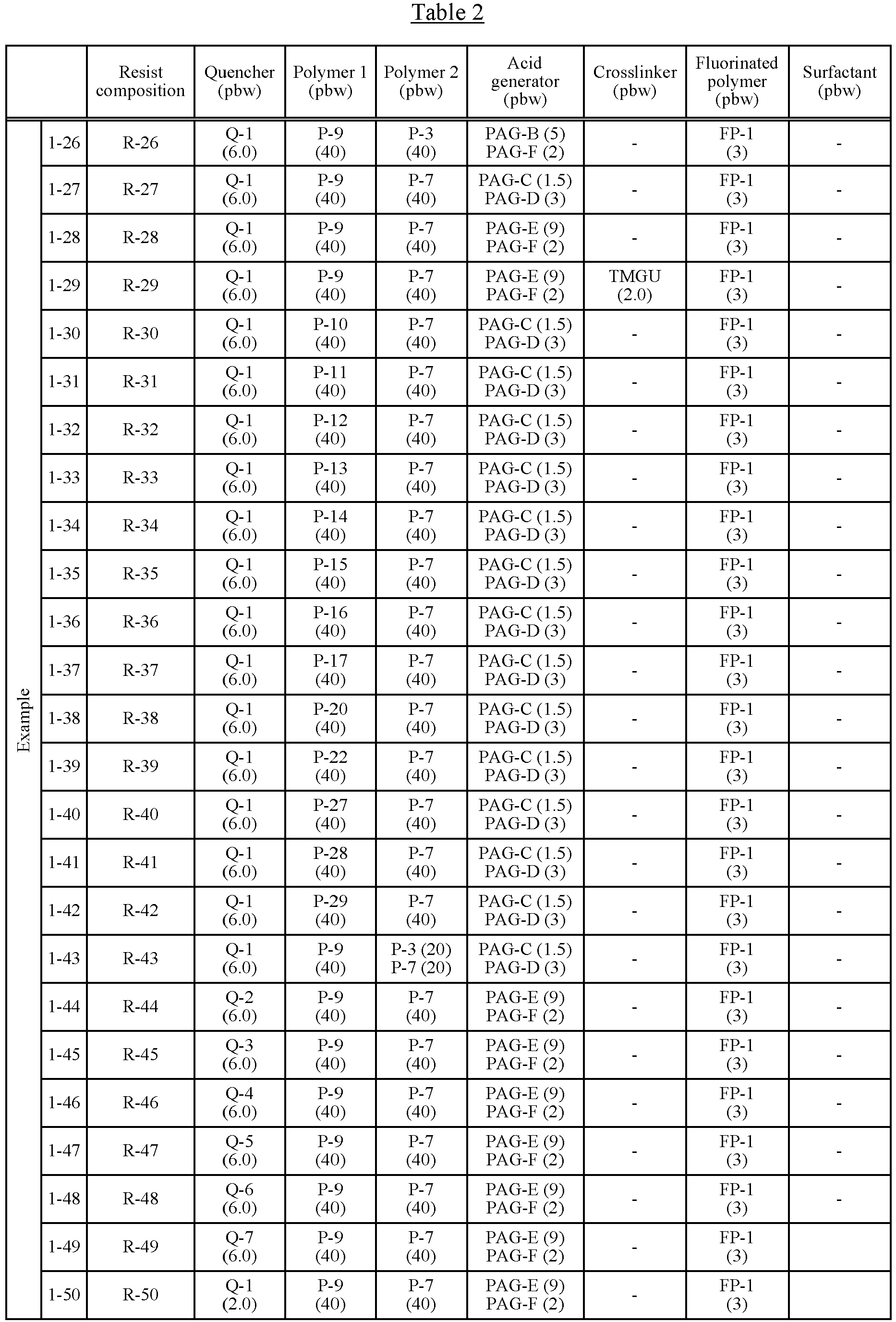

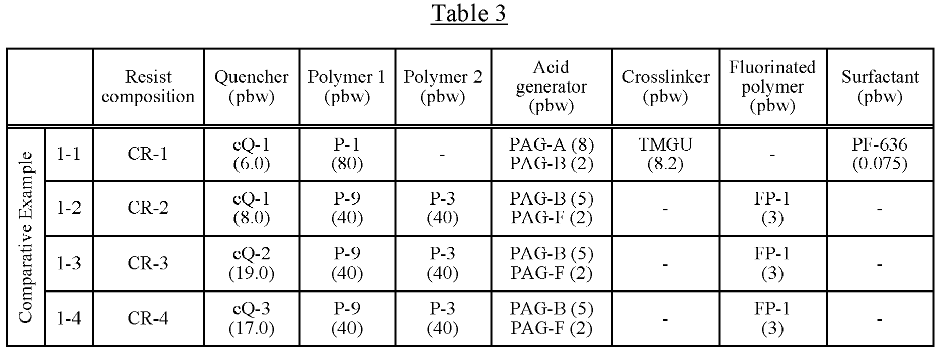

Polymers P-1 to P-30 in Tables 1 to 3 have the structure shown in Tables 4 and 5.

**Table 4**

| | Unit 1 | Incorporation ratio (mol%) | Unit 2 | Incorporation ratio (mol%) | Unit 3 | Incorporation ratio (mol%) | Unit 4 | Incorporation ratio (mol%) | Unit 5 | Incorporation ratio (mol%) | Mw | Mw/Mn |
|---|---|---|---|---|---|---|---|---|---|---|---|---|
| P-1 | A-1 | 80.0 | B-1 | 10.0 | B-5 | 10.0 | - | - | - | - | 4,500 | 1.65 |
| P-2 | A-1 | 80.0 | B-2 | 8.0 | B-4 | 12.0 | - | - | - | - | 4,400 | 1.64 |
| P-3 | A-1 | 60.0 | B-2 | 10.0 | C-1 | 30.0 | - | - | - | - | 3,700 | 1.62 |
| P-4 | A-1 | 70.0 | B-2 | 7.0 | C-2 | 23.0 | - | - | - | - | 3,600 | 1.63 |
| P-5 | A-1 | 70.0 | B-2 | 10.0 | C-3 | 20.0 | - | - | - | - | 3,900 | 1.65 |
| P-6 | A-1 | 65.0 | B-2 | 10.0 | C-4 | 25.0 | - | - | - | - | 3,800 | 1.64 |
| P-7 | A-1 | 45.0 | B-2 | 10.0 | C-5 | 45.0 | - | - | - | - | 4,100 | 1.63 |
| P-8 | A-1 | 55.0 | B-4 | 10.0 | C-1 | 35.0 | - | - | - | - | 4,000 | 1.63 |
| P-9 | A-1 | 66.0 | B-2 | 9.0 | C-1 | 21.5 | E-1 | 3.5 | - | - | 13,000 | 1.62 |
| P-10 | A-1 | 60.0 | B-2 | 4.0 | C-1 | 24.0 | E-1 | 12.0 | - | - | 15,000 | 1.65 |
| P-11 | A-1 | 67.0 | B-2 | 10.0 | C-1 | 18.5 | E-2 | 4.5 | - | - | 14,000 | 1.63 |
| P-12 | A-1 | 67.0 | B-2 | 9.3 | C-1 | 20.0 | E-3 | 3.7 | - | - | 13,500 | 1.63 |
| P-13 | A-1 | 67.3 | B-2 | 10.0 | C-1 | 17.5 | E-4 | 5.2 | - | - | 13,200 | 1.64 |
| P-14 | A-1 | 64.1 | B-2 | 9.5 | C-1 | 22.0 | E-5 | 4.4 | - | - | 12,800 | 1.62 |
| P-15 | A-1 | 64.0 | B-2 | 10.0 | C-1 | 22.8 | E-6 | 3.2 | - | - | 13,500 | 1.63 |

**Table 5**

| | Unit 1 | Incorporation ratio (mol%) | Unit 2 | Incorporation ratio (mol%) | Unit 3 | Incorporation ratio (mol%) | Unit 4 | Incorporation ratio (mol%) | Unit 5 | Incorporation ratio (mol%) | Mw | Mw/Mn |
|---|---|---|---|---|---|---|---|---|---|---|---|---|
| P-16 | A-1 | 62.0 | B-3 | 10.0 | C-1 | 24.3 | E-1 | 3.7 | - | - | 12,400 | 1.66 |
| P-17 | A-2 | 60.5 | B-4 | 10.0 | C-1 | 24.4 | E-2 | 5.1 | - | - | 12,300 | 1.65 |
| P-18 | A-1 | 70.0 | C-1 | 30.0 | - | - | - | - | - | - | 4,200 | 1.69 |
| P-19 | A-1 | 80.0 | B-2 | 5.0 | C-1 | 15.0 | - | - | - | - | 4,300 | 1.67 |
| P-20 | A-1 | 80.0 | B-2 | 2.5 | C-1 | 15.0 | E-1 | 2.5 | - | - | 12,100 | 1.69 |
| P-21 | A-2 | 50.0 | C-1 | 30.0 | D-1 | 20.0 | - | - | - | - | 4,600 | 1.67 |
| P-22 | A-2 | 50.0 | B-2 | 2.5 | C-1 | 30.0 | D-1 | 15.0 | E-1 | 2.5 | 12,700 | 1.73 |
| P-23 | A-2 | 50.0 | C-1 | 30.0 | D-2 | 20.0 | - | - | - | - | 5,400 | 1.72 |
| P-24 | A-2 | 50.0 | C-1 | 30.0 | D-3 | 20.0 | - | - | - | - | 6,100 | 1.73 |
| P-25 | A-2 | 50.0 | C-1 | 30.0 | D-4 | 20.0 | - | - | - | - | 7,000 | 1.76 |
| P-26 | A-1 | 67.5 | B-2 | 2.5 | C-1 | 30.0 | - | - | - | - | 4,100 | 1.65 |
| P-27 | A-1 | 57.5 | B-2 | 2.5 | C-1 | 30.0 | E-5 | 10.0 | - | - | 11,000 | 1.65 |
| P-28 | A-1 | 65.0 | C-1 | 25.0 | E -7 | 10.0 | - | - | - | - | 13,000 | 1.80 |
| P-29 | A-1 | 65.0 | C-1 | 25.0 | E -8 | 10.0 | - | - | - | - | 12,500 | 1.80 |
| P-30 | A-3 | 75.0 | C-1 | 25.0 | - | - | - | - | - | - | 4,500 | 1.68 |

The structure of each unit in Tables 4 and 5 is shown below.

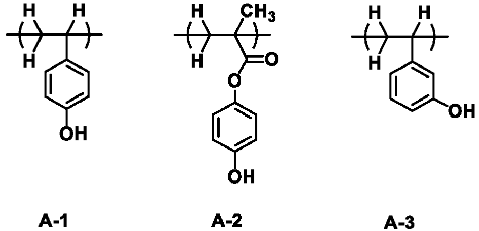

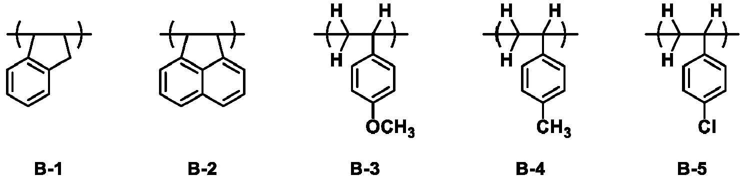

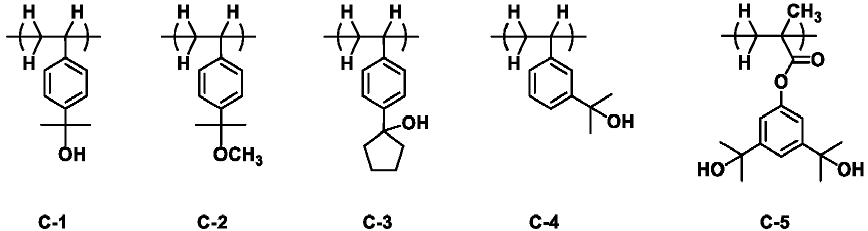

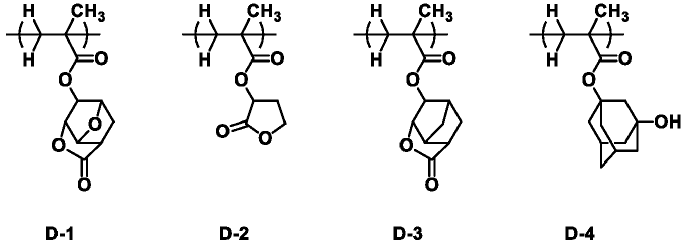

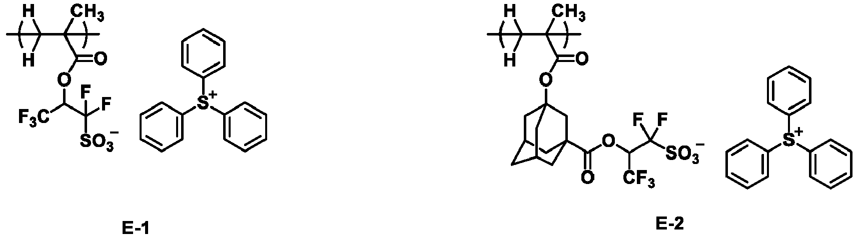

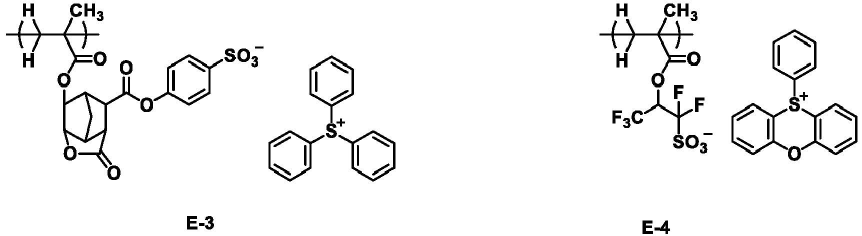

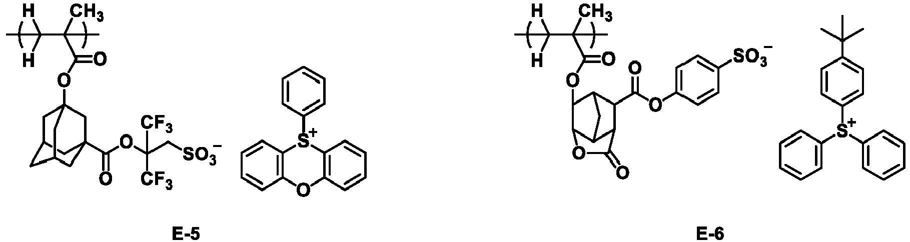

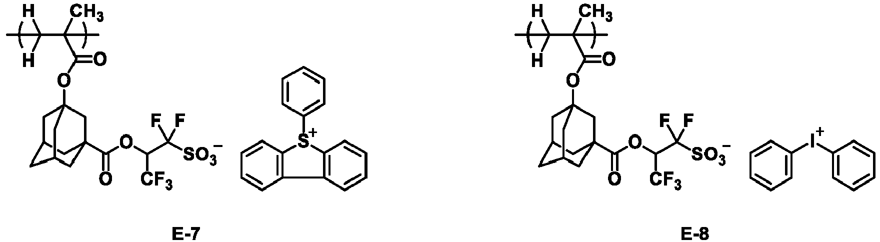

In Tables 1 to 3, quenchers Q-1 to Q-7, comparative quenchers cQ-1 to cQ-3, photoacid generators PAG-A to PAG-F, and fluorinated polymers FP-1 to FP-5 are identified below.

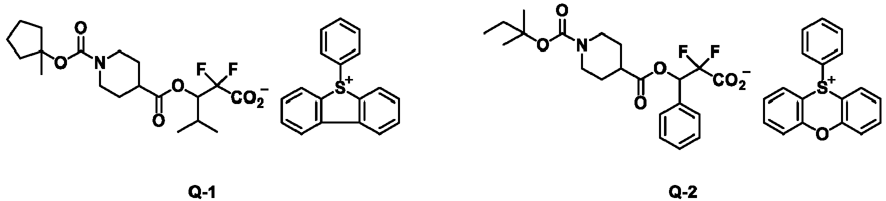

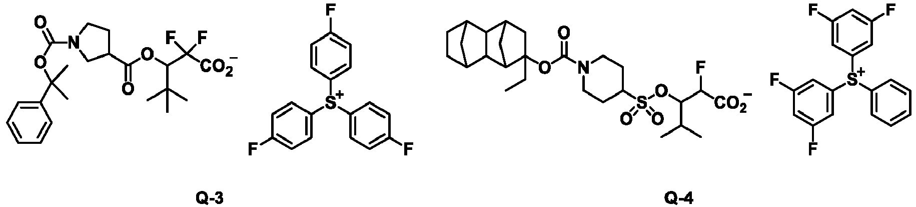

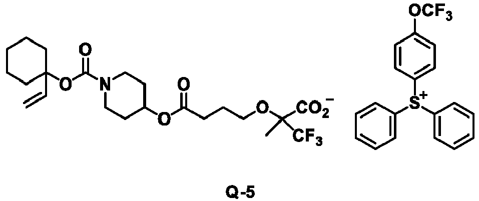

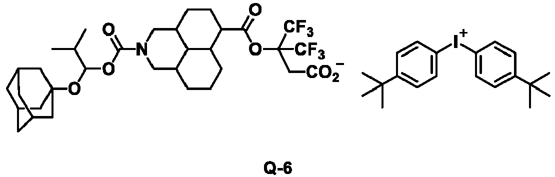

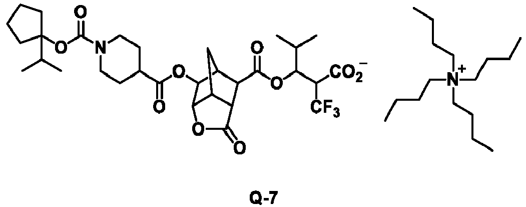

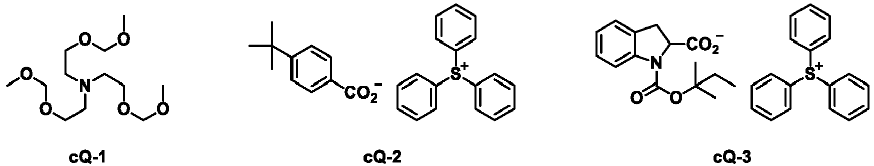

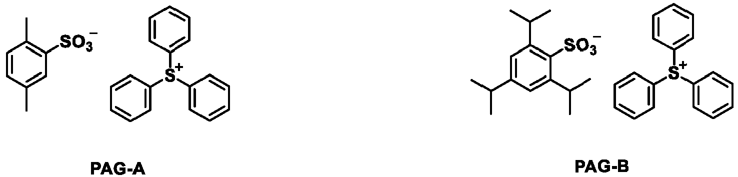

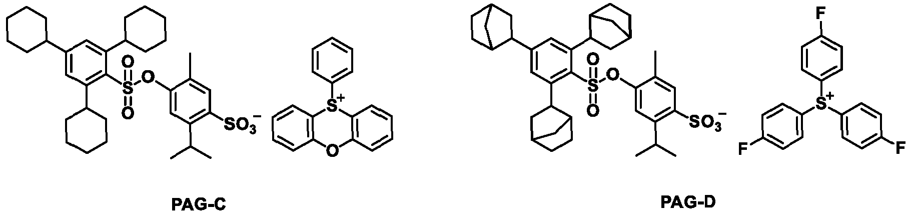

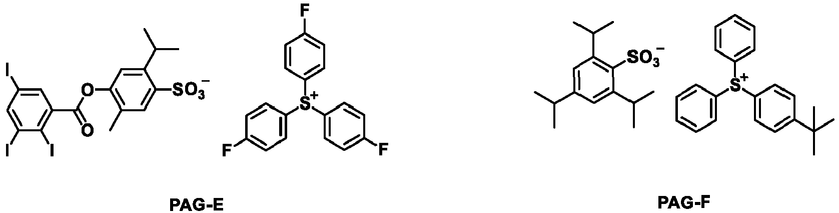

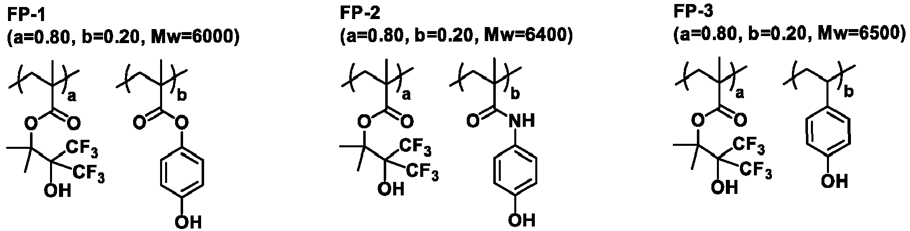

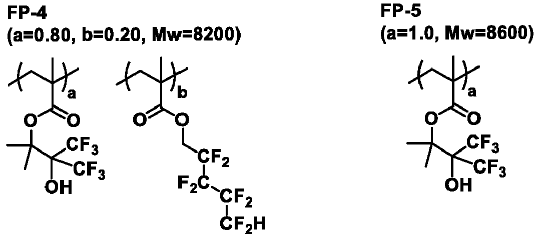

### [2] EB lithography test

### Examples 2-1 to 2-50 and Comparative Examples 2-1 to 2-4

A photomask blank of reflection type for an EUV lithography mask was furnished by starting with a low-coefficient-of-thermal-expansion glass substrate and depositing thereon a multilayer reflective film of 40 Mo/Si layers with a thickness of 284 nm, a Ru film of 3.5 nm thick as protective film, a TaN film of 70 nm thick as absorbing layer, and a CrN film of 6 nm thick as hard mask. Using a coater/developer system ACT-M (Tokyo Electron Ltd.), each of the resist compositions (R-1 to R-50, CR-1 to CR-4) was spin coated onto the photomask blank, and prebaked on a hotplate at 110°C for 600 seconds to form a resist film of 80 nm thick. The thickness of the resist film was measured by an optical film thickness measurement system Nanospec (Nanometrics Inc.). Measurement was made at 81 points in the plane of the blank substrate excluding a peripheral band extending 10 mm inward from the blank periphery, and an average film thickness and a film thickness range were computed therefrom.

The resist film was exposed to EB using an EB writer system EBM-5000Plus (NuFlare Technology Inc., accelerating voltage 50 kV), then baked (PEB) at 110°C for 600 seconds, and developed in a 2.38 wt% TMAH aqueous solution, thereby yielding a negative pattern.

The resist pattern was evaluated as follows. The patterned mask blank was observed under a top-down scanning electron microscope (TDSEM). The optimum dose (Eop) was defined as the exposure dose (µC/cm²) which provided a 1:1 resolution at the top and bottom of a 200-nm 1:1 line-and-space (LS) pattern. The resolution (or maximum resolution) was defined as the minimum line width of a LS pattern that could be resolved at the optimum dose. The 200-nm LS pattern printed by exposure at the optimum dose (Eop) was observed under SEM. For each of the edges of 32 lines of the LS pattern, edge detection was carried out at 80 points, from which a 3-fold value (3σ) of the standard deviation (σ) or variation was determined and reported as LER (nm). A change of CD per µC relative to the exposure dose providing 1: 1 resolution was determined from the dose curve. The results are shown in Tables 6 to 8.

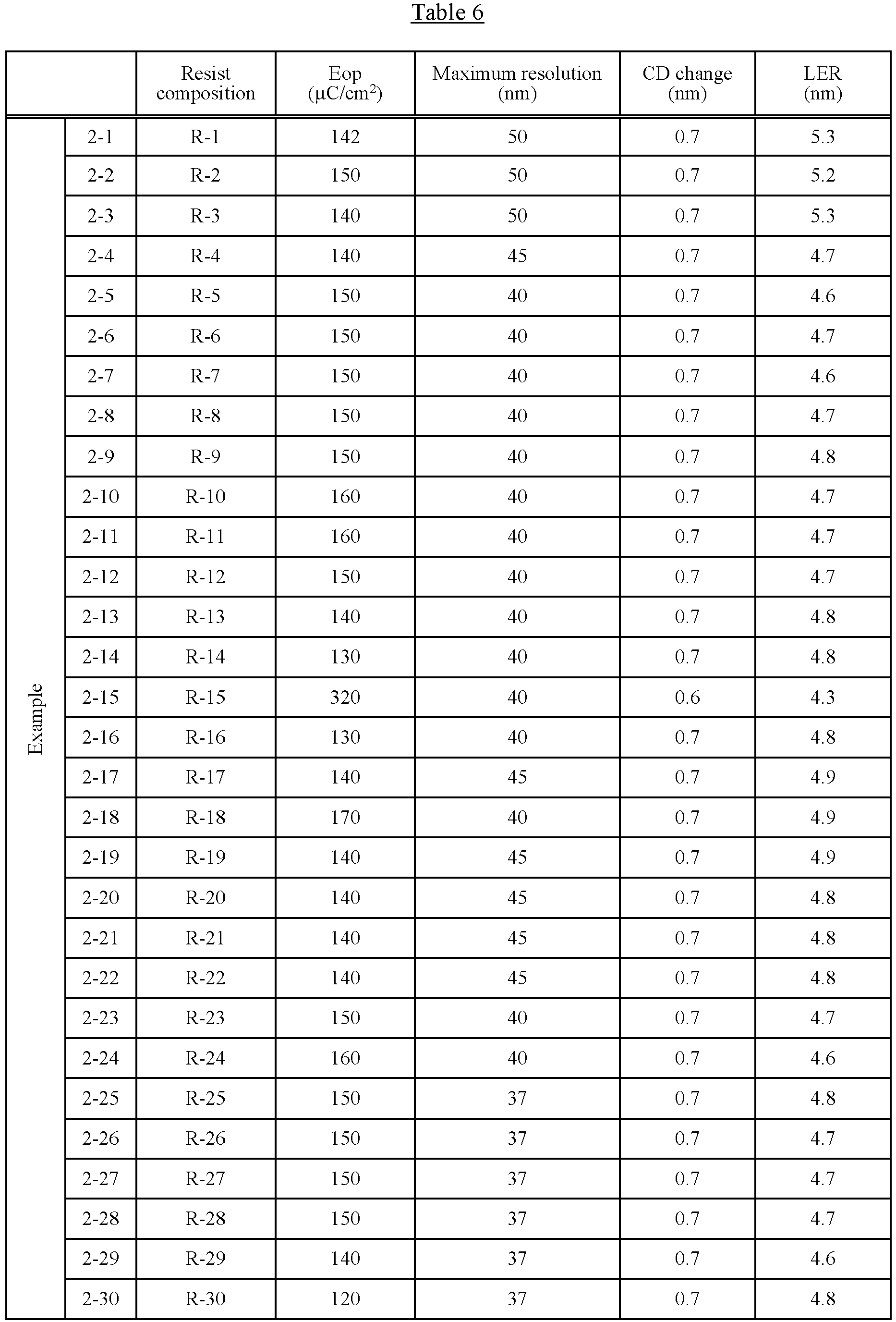

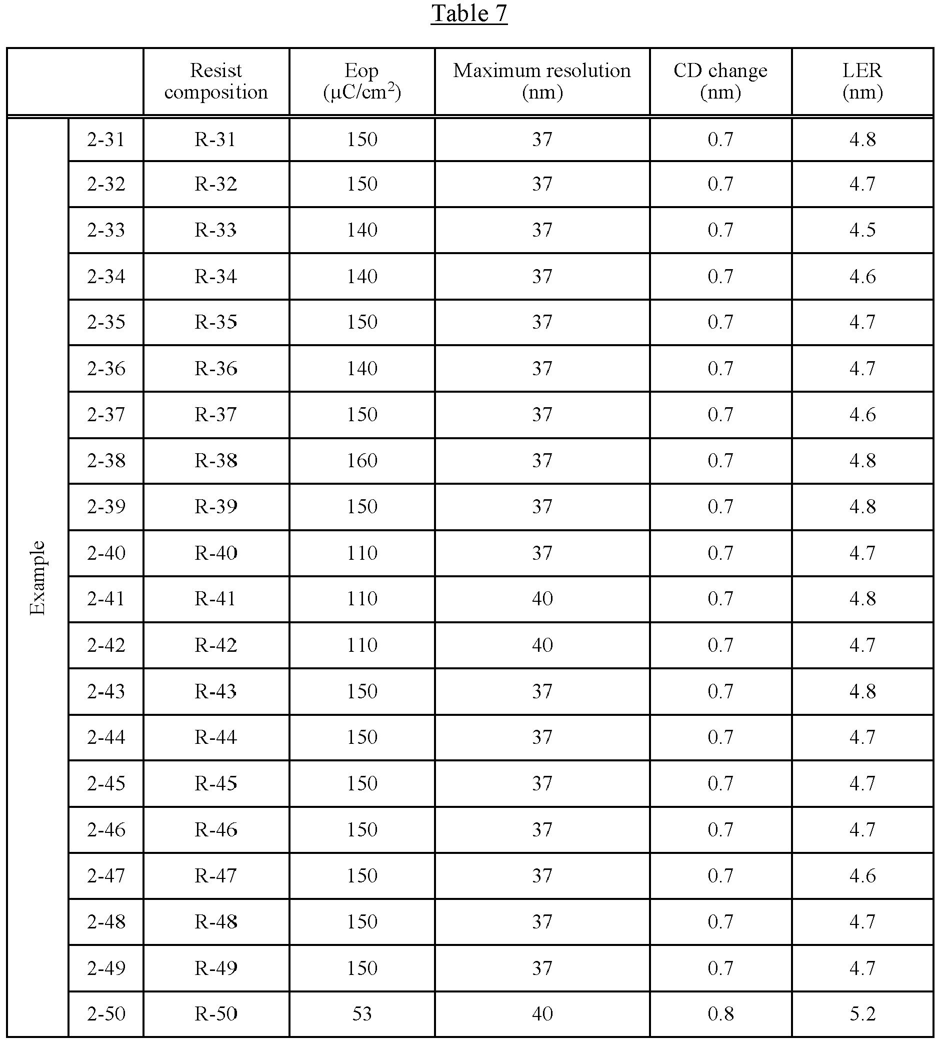

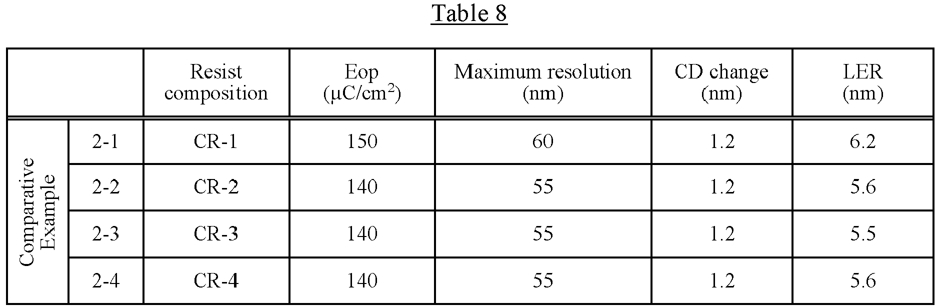

As compared with comparative resist compositions (CR-1 to CR-4), the chemically amplified negative resist compositions (R-1 to R-50) within the scope of the invention show satisfactory resolution and acceptable values of LER and dose margin because the onium salt having formula (A) exerts an acid diffusion-suppressing effect.

Because of a high quenching ability, the onium salt having formula (A) is effective for adjusting the resist sensitivity even when used in a small amount, highly compatible with the solvent, and uniformly dispersed in the resist film. These contribute to acceptable values of LER. An appropriate degree of lipophilicity leads to improved rigidity and suppressed swell. Consequently, patterns of rectangular profile with satisfactory resolution are obtainable in contrast to the rounded top profile of CR-1 to CR-4.

Using the chemically amplified negative resist composition within the scope of the invention, a resist pattern having a very high resolution, reduced LER and improved dose margin can be formed. The resist pattern forming process using the negative resist composition is useful in photolithography for the fabrication of semiconductor devices and the processing of photomask blanks of transmission or reflection type.

## Claims

1. A chemically amplified negative resist composition comprising
(A) a quencher containing an onium salt having the formula (A): 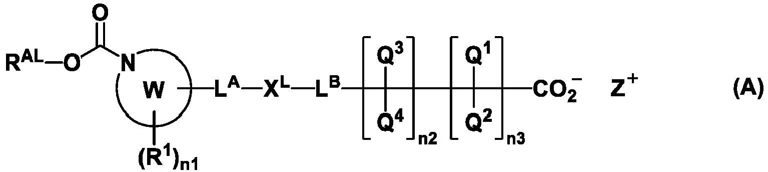 wherein n1 is an integer of 0 to 6, n2 is an integer of 0 to 3, n3 is an integer of 1 to 4,
W is a C₂-C₂₀ nitrogen-containing aliphatic heterocycle which may contain a heteroatom,
L^{A} and L^{B} are each independently a single bond, ether bond, ester bond, amide bond, sulfonate ester bond, carbonate bond or carbamate bond,
X^{L} is a single bond or a C₁-C₄₀ hydrocarbylene group which may contain a heteroatom,
R¹ is a C₁-C₂₀ hydrocarbyl group which may contain a heteroatom, and when n1 is 2 or more, a plurality of R¹ may bond together to form a ring with the carbon atoms on W to which they are attached,
Q¹ to Q⁴ are each independently hydrogen, fluorine, a C₁-C₆ hydrocarbyl group or C₁-C₆ fluorinated hydrocarbyl group, at least one of Q¹ to Q⁴ being fluorine or a C₁-C₆ fluorinated hydrocarbyl group, Q³ and Q⁴ may bond together to form a ring with the carbon atom to which they are attached,
R^{AL} is an acid labile group, and
Z⁺ is an onium cation, and
(B) a base polymer containing a polymer comprising repeat units having the formula (B1): 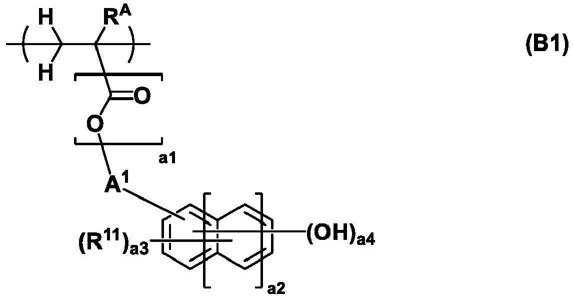 wherein a1 is 0 or 1, a2 is an integer of 0 to 2, a3 is an integer meeting 0 ≤ a3 ≤ 5+2(a2)-a4, a4 is an integer of 1 to 3,
R^{A} is hydrogen, fluorine, methyl or trifluoromethyl,
R¹¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group, and
A¹ is a single bond or a C₁-C₁₀ saturated hydrocarbylene group in which -CH₂- may be replaced by -O-.

2. The negative resist composition of claim 1 wherein R^{AL} is a group having the formula (AL-1) or (AL-2): 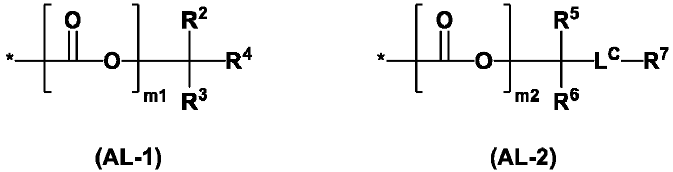 wherein L^{C} is -O- or -S-,
R², R³ and R⁴ are each independently a C₁-C₁₀ hydrocarbyl group, any two of R², R³ and R⁴ may bond together to form a ring with the carbon atom to which they are attached,
R⁵ and R⁶ are each independently hydrogen or a C₁-C₁₀ hydrocarbyl group, R⁷ is a C₁-C₂₀ hydrocarbyl group in which -CH₂- may be replaced by -O- or -S-, R⁶ and R⁷ may bond together to form a C₃-C₂₀ heterocyclic group with the carbon atom and L^{C} to which they are attached, -CH₂- in the heterocyclic group may be replaced by -O- or -S-,
m1 and m2 are each independently 0 or 1, and
* designates a point of attachment to the adjacent -O-.

3. The negative resist composition of claim 1 or 2 wherein Z⁺ is a sulfonium cation having the formula (cation-1), iodonium cation having the formula (cation-2), or ammonium cation having the formula (cation-3): 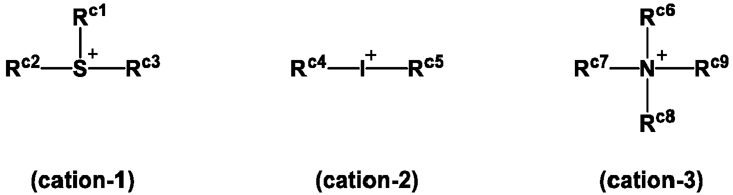 wherein R^{c1} to R^{c9} are each independently halogen or a C₁-C₃₀ hydrocarbyl group which may contain a heteroatom, R^{c1} and R^{c2} may bond together to form a ring with the sulfur atom to which they are attached.

4. The negative resist composition of any one of claims 1 to 3 wherein the polymer further comprises repeat units having the formula (B2): 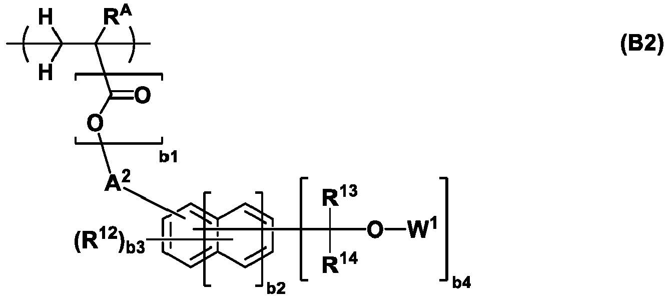 wherein b1 is 0 or 1, b2 is an integer of 0 to 2, b3 is an integer meeting 0 ≤ b3 ≤ 5+2(b2)-b4, b4 is an integer of 1 to 3,
R^{A} is hydrogen, fluorine, methyl or trifluoromethyl,
R¹² is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group,
R¹³ and R¹⁴ are each independently hydrogen, a C₁-C₁₅ saturated hydrocarbyl group which may be substituted with hydroxy or saturated hydrocarbyloxy moiety, or optionally substituted aryl group, excluding that both R¹³ and R¹⁴ are hydrogen at the same time, R¹³ and R¹⁴ may bond together to form a ring with the carbon atom to which they are attached,
A² is a single bond or a C₁-C₁₀ saturated hydrocarbylene group in which -CH₂- may be replaced by -O-, and
W¹ is hydrogen, a C₁-C₁₀ aliphatic hydrocarbyl group or optionally substituted aryl group.

5. The negative resist composition of any one of claims 1 to 4 wherein the polymer further comprises repeat units of at least one type selected from repeat units having the formula (B3), repeat units having the formula (B4), and repeat units having the formula (B5): 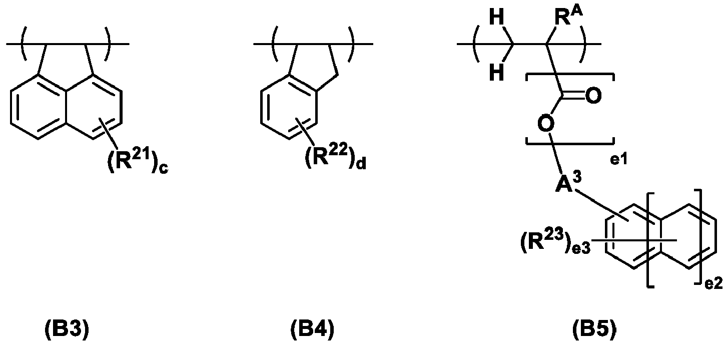 wherein c and d are each independently an integer of 0 to 4, e1 is 0 or 1, e2 is an integer of 0 to 2, e3 is an integer of 0 to 5,
R^{A} is hydrogen, fluorine, methyl or trifluoromethyl,
R²¹ and R²² are each independently hydroxy, halogen, optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group,
R²³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro, cyano, C₁-C₂₀ saturated hydrocarbyl sulfinyl group, or C₁-C₂₀ saturated hydrocarbyl sulfonyl group,
A³ is a single bond or C₁-C₁₀ saturated hydrocarbylene group in which -CH₂- may be replaced by -O-.

6. The negative resist composition of claim 4 wherein the polymer further comprises repeat units of at least one type selected from repeat units having the formulae (B6) to (B13): 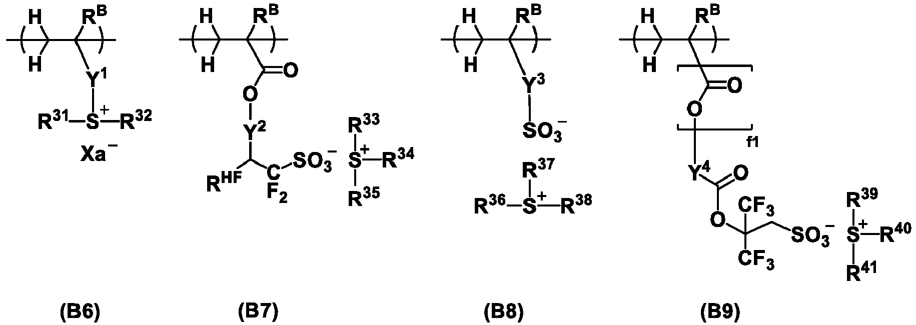 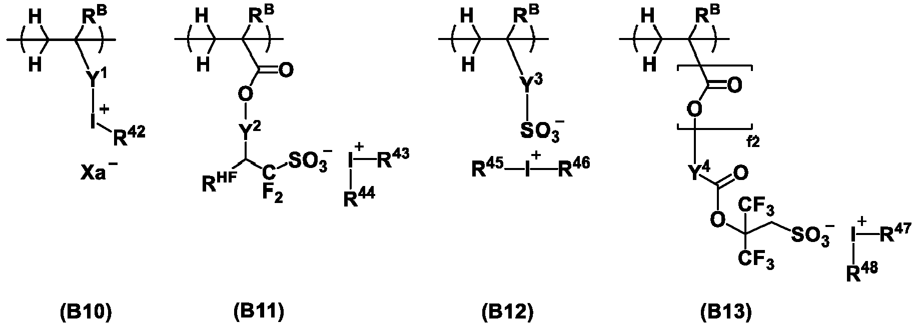 wherein R^{B} is each independently hydrogen or methyl,
Y¹ is a single bond, a C₁-C₆ aliphatic hydrocarbylene group, phenylene group, naphthylene group or C₇-C₁₈ group obtained by combining the foregoing, *-O-Y¹¹-, *-C(=O)-O-Y¹¹-, or *-C(=O)-NH-Y¹¹-, Y¹¹ is a C₁-C₆ aliphatic hydrocarbylene group, phenylene group, naphthylene group or C₇-C₁₈ group obtained by combining the foregoing, which may contain a carbonyl moiety, ester bond, ether bond or hydroxy moiety,
Y² is a single bond or **-Y²¹-C(=O)-O-, Y²¹ is a C₁-C₂₀ hydrocarbylene group which may contain a heteroatom,
Y³ is a single bond, methylene, ethylene, phenylene, fluorinated phenylene, trifluoromethyl-substituted phenylene, *-O-Y³¹-, *-C(=O)-O-Y³¹-, or *-C(=O)-NH-Y³¹-, Y³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety,
* designates a point of attachment to the carbon atom in the backbone, ** designates a point of attachment to the oxygen atom in the formula,
Y⁴ is a single bond or C₁-C₃₀ hydrocarbylene group which may contain a heteroatom,
f1 and f2 are each independently 0 or 1, f1 and f2 are 0 when Y⁴ is a single bond,
R³¹ to R⁴⁸ are each independently halogen or a C₁-C₂₀ hydrocarbyl group which may contain a heteroatom, R³¹ and R³² may bond together to form a ring with the sulfur atom to which they are attached, R³³ and R³⁴, R³⁶ and R³⁷, or R³⁹ and R⁴⁰ may bond together to form a ring with the sulfur atom to which they are attached,
R^{HF} is hydrogen or trifluoromethyl, and
Xa⁻ is a non-nucleophilic counter ion.

7. The negative resist composition of claim 6 wherein the base polymer (B) further contains a polymer comprising repeat units having formula (B 1) and repeat units having formula (B2), but not repeat units having formulae (B6) to (B 13).

8. The negative resist composition of any one of claims 1 to 7 wherein repeat units having an aromatic ring structure account for at least 60 mol% of the overall repeat units of the polymer in the base polymer.

9. The negative resist composition of any one of claims 1 to 8, further comprising (C) a crosslinker.

10. The negative resist composition of claim 4 which is free of a crosslinker.

11. The negative resist composition of any one of claims 1 to 10., further comprising (D) a fluorinated polymer comprising repeat units of at least one type selected from repeat units having the formula (D1), repeat units having the formula (D2), repeat units having the formula (D3) and repeat units having the formula (D4) and optionally repeat units of at least one type selected from repeat units having the formula (D5) and repeat units having the formula (D6): 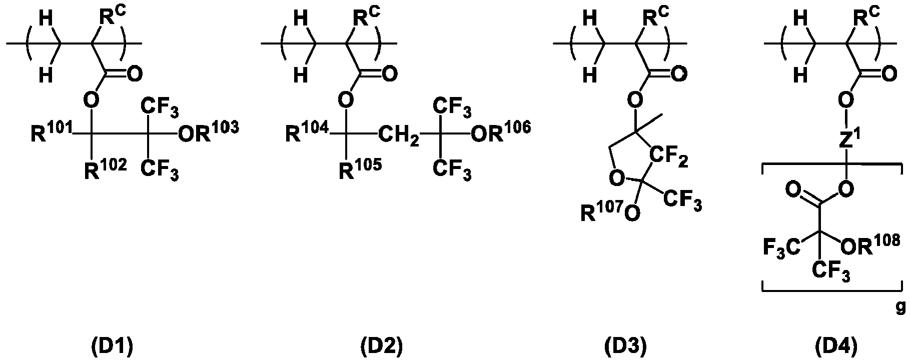 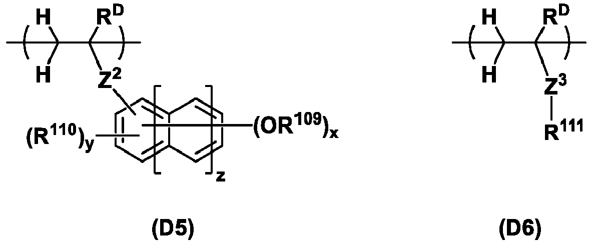 wherein x is an integer of 1 to 3, y is an integer satisfying 0 ≤ y ≤ 5+2z-x, z is 0 or 1, g is an integer of 1 to 3,
R^{C} is each independently hydrogen, fluorine, methyl or trifluoromethyl,
R^{D} is each independently hydrogen or methyl,
R¹⁰¹, R¹⁰², R¹⁰⁴ and R¹⁰⁵ are each independently hydrogen or a C₁-C₁₀ saturated hydrocarbyl group,
R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, and when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
R¹⁰⁹ is hydrogen or a C₁-C₅ straight or branched hydrocarbyl group in which a heteroatom-containing moiety may intervene in a carbon-carbon bond,
R¹¹⁰ is a C₁-C₅ straight or branched hydrocarbyl group in which a heteroatom-containing moiety may intervene in a carbon-carbon bond,
R¹¹¹ is a C₁-C₂₀ saturated hydrocarbyl group in which at least one hydrogen is substituted by fluorine, and in which some constituent -CH₂- may be replaced by an ester bond or ether bond,
Z¹ is a C₁-C₂₀ (g+1)-valent hydrocarbon group or C₁-C₂₀ (g+1)-valent fluorinated hydrocarbon group,
Z² is a single bond, *-C(=O)-O- or *-C(=O)-NH-, * designates a point of attachment to the carbon atom in the backbone,
Z³ is a single bond, -O-, *-C(=O)-O-Z³¹-Z³²_ or *-C(=O)-NH-Z³¹-Z³²-, Z³¹ is a single bond or C₁-C₁₀ saturated hydrocarbylene group, Z³² is a single bond, ester bond, ether bond, or sulfonamide bond, and * designates a point of attachment to the carbon atom in the backbone.

12. The negative resist composition of any one of claims 1 to 11, further comprising (E) an acid generator.

13. The negative resist composition of any one of claims 1 to 12, further comprising (F) an organic solvent.

14. A resist pattern forming process comprising the steps of:
applying the chemically amplified negative resist composition of any one of claims 1 to 13 onto a substrate to form a resist film thereon,
exposing the resist film patternwise to high-energy radiation, and
developing the exposed resist film in an alkaline developer.

15. A mask blank of transmission or reflection type which is coated with the chemically amplified negative resist composition of any one of claims 1 to 13.
